# EUROPEAN PATENT SPECIFICATION

(11) **EP 2 684 435 B1**
(45) Date of publication and mention of the grant of the patent: **02.10.2019**
(21) Application number: 12757650.2
(22) Date of filing: 09.03.2012
(51) Int. Cl.: H05K 9/00

(54) **FLEXIBLE ELECTRONIC CIRCUIT ENCLOSURE ASSEMBLY**
GEHÄUSEANORDNUNG FÜR EINE FLEXIBLE ELEKTRONISCHE SCHALTUNG
ENSEMBLE ENCEINTE DE CIRCUIT ÉLECTRONIQUE FLEXIBLE

(30) Priority: 11.03.2011 US 201161451795 P
(43) Date of publication of application: 15.01.2014
(73) Proprietor: Aptiv Technologies Limited, St. Michael (BB)
(72) Inventor: SNIDER, Chris R., Noblesville, IN 46062 (US)
(74) Representative: Manitz Finsterwald Patent- und Rechtsanwaltspartnerschaft mbB
(86) International application number: PCT/US2012/028416
(87) International publication number: WO 2012/125436

(56) References cited:
- EP-A1- 0 936 045
- US-A1- 2002 074 142
- US-A1- 2010 186 217
- US-A1- 2010 246 155
- US-A1- 2010 246 155

## Description

### RELATED APPLICATIONS

The present application claims priority to Provisional application U.S.S.N. 61/451,795 filed 11 March 2011 to Chris R. Snider, entitled Lightweight Audio System for Automotive Audio Systems and Method, and is related to Continuation in Part application of U.S.S.N. 12/787,452 filed 26 May 2010, which is a Continuation in Part application of 12/708,911 filed 19 February 2010, which is a Continuation in Part application of U.S.S.N. 11/893,357 filed 15 August 2007 claiming priority to Provisional applications U.S.S.N. 60/838,698 filed 18 August 2006 to Chris R. Snider et al., entitled Lightweight Automotive Radio/CD Player and U.S.S.N. 60/931,467 filed 23 May 2007 to Chris R. Snider et al., entitled Lightweight Automotive Telematic Device, both assigned to a common assignee.

### TECHNICAL FIELD

The present invention relates generally to apparatus for enclosing electrical subassemblies, and more specifically relates to apparatus for efficiently securing subassemblies to a chassis of an electrical assembly such as an automobile radio, compact disc playing mechanism, cassette tape playing mechanism, navigational aid, personal computer, personal and telematic communication devices or disk drive mechanism. For example, patent application US 2010/0246155 A1 discloses an enclosure assembly corresponding to the preamble of claim 1.

### BACKGROUND OF THE INVENTION

Devices such as automobile radios or personal computers contain subassemblies such as cassette playing mechanisms or disk drives that are attached to the chassis using threaded fasteners. The chassis provides structural support for the subassemblies and also provides electromagnetic shielding to limit electromagnetic interference (EMI) experienced by, and/or created by the device. The fasteners ensure that each subassembly within the chassis is properly located and securely retained within the chassis.

The use of such fasteners can have numerous drawbacks, particularly in a high volume production setting. The process for applying or installing fasteners can vary, but there is usually some degree of automation required, ranging from manually loading a screw into a bit on a pneumatic driver to using self-feeding automated machines. Typically, the torque applied by the device used to drive the fasteners must be monitored regularly and adjusted in order to assure proper seating of the fasteners. When fasteners are used, sheet metal tolerances, as well as tolerances of the fasteners themselves, have to be maintained at tight levels to allow for the minimization of stress in the assembly when aligning multiple fasteners with corresponding holes in the chassis and in the subassembly.

When threaded fasteners are used to assemble an electrical device, the assembly cycle time can be very long especially in high volume production. An operator assembling the device must typically first obtain the threaded fastener, orient and position it in alignment with the driver bit, then manipulate or actuate the machine to drive the threaded fastener. Furthermore, using threaded fasteners presents a risk of any one of the following upstream failures occurring: stripping of fastener threads; insufficient torque resulting in an unseated fastener; excessive torque resulting in distension/deformation of the fastener or adjacent electrical components; installation of the wrong fastener type or size; foreign object damage due to fasteners and/or metal shavings dropping onto the assembly and/or subassembly; and stripping of the head of the threaded fastener. Also, a fastener installation tool such as a driver and bit can slip off the fastener and impact an electrical component resulting in a damaged assembly.

If self-tapping fasteners are used, the process of driving the self-tapping fasteners into sheet metal often causes shavings of sheet metal to disperse into the assembly. Such shavings have been known to cause electrical failures, such as shorts or corruption of magnetic components that can permanently damage the product. If self-tapping fasteners are not used, an extra production step is required to pre-form threads in the sheet metal of the chassis and/or the subassembly to be installed within the chassis.

Fasteners further require an additional inventory burden on the production line in that the production line must be continuously stocked with part numbers (fasteners) other than the integral components that add value to the assembly. Also special tools specifically required for assembly, using fasteners, such as drivers and bits, must be continuously monitored and maintained for proper performance, wear and torque specifications. Typically, the top and/or bottom surface of the chassis must be secured in place after the subassembly is attached to the chassis.

Special fixtures are often required on the production line to secure a subassembly in a proper location and orientation while it is mounted within the chassis with fasteners. Such fixtures can be very complex, and the use of such fixtures usually requires extra handling of both the subassembly and of the resulting assembly thereby adding to the production cycle time and potentially compromising quality of the final product.

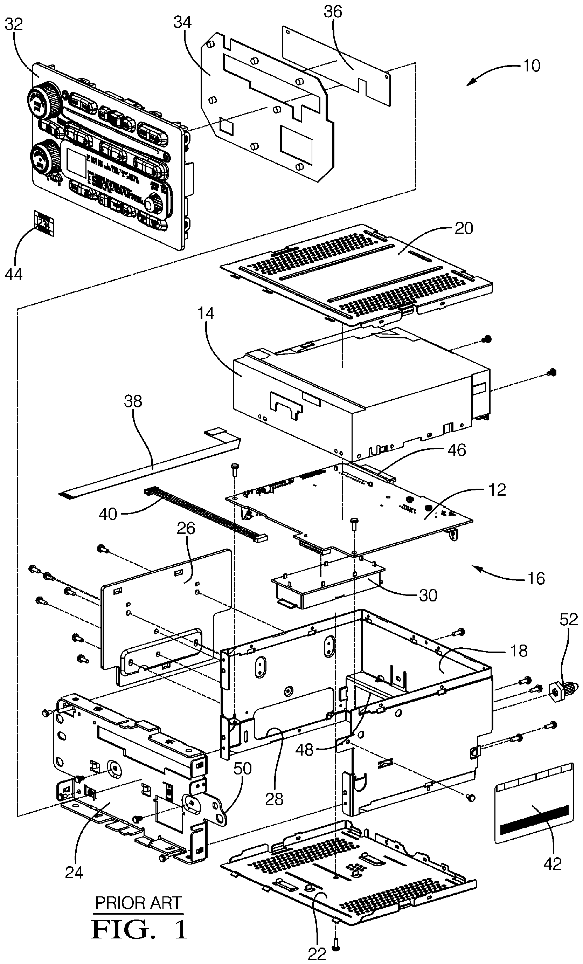

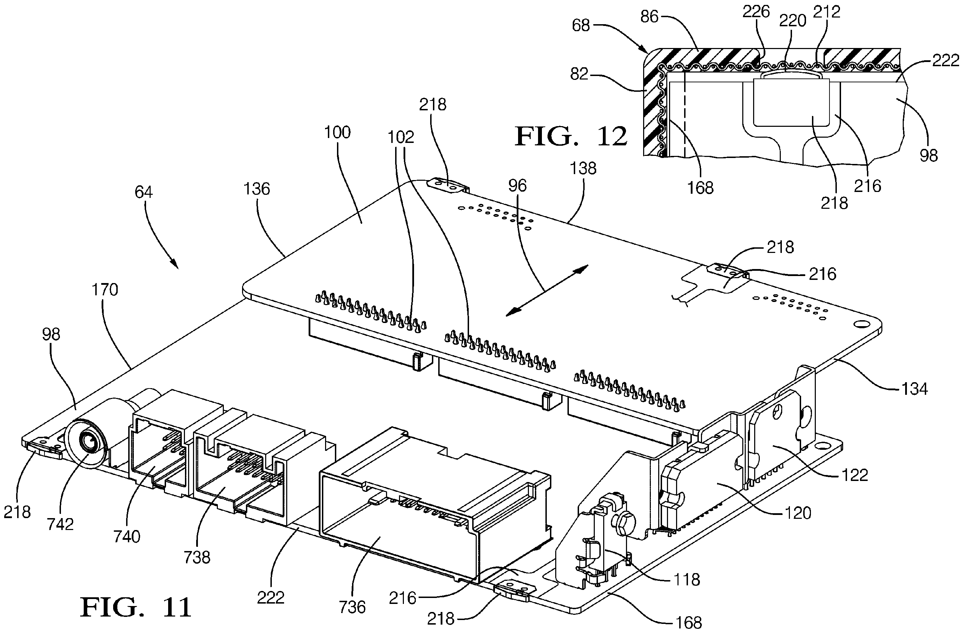

Figure 1 illustrates the construction of a typical prior art automotive radio/compact disc (CD) player 10. Radio/CD player 10 comprises a radio subassembly whose principle circuit components are carried on a circuit board 12 and a CD player subassembly 14. The circuit board 12 and the CD player 14 are encased within a common chassis 16 made up of sheet metal components. Chassis 16 includes a wraparound housing 18 defining a back and sidewalls, a top cover 20, a bottom cover 22 and a front plate 24 which are interconnected by numerous threaded fasteners to collectively enclose the subassemblies. The top and bottom covers 20 and 22, respectively, are provided with large arrays holes or openings for airflow and ventilation of heat generated within the radio/CD player 10. A convector or heat sink 26 is carried on an outer surface of one of the chassis sidewalls and is interconnected through a port/window 28 to a power device assembly 30. A trim plate assembly 32, along with a support pad 34 and CD dust cover 36 are affixed to the front plate 24, providing an operator control interface with the radio/CD player 10. Circuit board 12 is electrically in-circuit with the CD player subassembly 14 through an intermediate flex wire cable 38 and with the power device assembly 30 through a jumper cable 40. Information bearing labels 42 and 44 are provided for future reference by the operator and service technicians. The radio/CD player 10 is electrically interconnected with an antenna, power supply, speakers and other related systems of a host vehicle by rear-facing connectors 46 carried on the circuit board 12 which are registered with openings 48 in the rear wall of wraparound housing 18. The radio/CD player 10 is mounted within a host vehicle by threaded fasteners passing through openings in mounting features 50 extending from front plate 24 and a rearwardly directed mounting bushing 52 which is threadably affixed to a stud 54 carried on the outer surface of the rear wall 56 of wraparound housing 18. As best seen in Figures 11 and 12, the shank of the stud 54 extends outwardly through a hole 58 disposed concentrically with a localized recess 60 and the stud 54 is seated within the recess 60. Figure 90 illustrates another known stud design including a threaded shank secured to the rear wall 53 of a radio set 51 by a set nut 55 and receiving a molded rubber, plastic or vinyl stud 57 thereover. Note the large number of threaded fasteners 59.

The radio/CD player 10 of Figure 1 is of ordinary complexity and may require fifty or more threaded fasteners to complete the manufacturing process. Installation of that many fasteners may require that the in-process chassis be repositioned/re-fixtured ten to fifteen times as it passes along an assembly line of eight to ten skilled workers/work stations.

Vehicle entertainment systems usually include an audio component such as a radio to enable receiving signals from antennas, contain various forms of playback mechanisms, and have the capacity to accept data from user devices like MP3 players. Typically, the radio has a decorative assembly that provides man-machine interface as well as displaying pertinent data relative to the selected media and audio settings. Also, the back-end or chassis is constructed of metal to provide various functions to ensure the performance of the radio in the vehicular environment. The structure to contain the mass from playbacks, the heat conductive properties, and the electrical shielding and grounding are just a few of the advantages to using the metal construction. Unfortunately, with the density of the metal, the disadvantage of added weight is a side effect of the typical construction. In a vehicle, added weight impacts fuel economy, as well as other hidden costs during assembly that can effect the cost of the product, like sharp edges of metal can be a potential hazard for assemblers in the manufacturing plant as well as added weight can limit the packaging of multiple parts in containers for inter and outer plant distribution.

### Thermal Management System

Devices such as automobile stereos, audio amplifiers, home stereo systems, two-way radios, computers, signal conditioners/amplifiers, compact disc playing mechanisms, and cassette tape playing mechanisms are examples of products that typically require electrical components to amplify signals and regulate power. Accordingly, such devices typically contain numerous electrical components such as single in-line package (SIP) amplifiers and regulators that are typically soldered into printed circuit boards. Such electrical components generate heat in use. The heat must be dissipated away from the electrical components to avoid damage that can be caused by excessive temperatures in the electrical components. For example, excessive temperatures can cause delicate electrical leads to fail or insulating materials to melt, thereby causing a short circuit resulting in damage to, or even failure of, the entire electrical device.

A convector is often mounted to an outer surface of such a device to dissipate heat generated by components by transferring the heat away from the components and the device to the convector and then to the air through radiation. In order to accomplish this, it is preferable that the convector be physically in contact with the component. The components and the convector can be pressed together to allow even better heat conduction from the components to the convector. Sometimes an intermediary material such as a thermal pad or silicon grease is used between the component and the convector to assist in creating an adequate heat transfer junction.

Many convectors are made from aluminum due to the high heat conductivity of that material. Convectors often include a plurality of fins to increase the effective surface area of the convector and thereby increase the rate at which the convector can dissipate heat. Typically, aluminum, convectors are formed by an extruding process, during which the fins can also be formed integrally therewith.

Convectors are usually assembled to the component or components during final assembly of the overall device in which they are used. At final assembly, components such as SIP amplifiers are already soldered into a printed circuit board. The order of assembly can vary as to which component is assembled into the chassis first. The printed circuit board can be installed into the chassis before the convector is mounted to the printed circuit board and the chassis. Alternatively, the convector can be mounted to the chassis before the printed circuit board is mounted to the convector. Sometimes, the convector is assembled to the printed circuit board to form a subassembly before being assembled to the chassis.

Typically, components are attached to the convector using a clip and one or more threaded fasteners that extend through a hole in the clip and into a hole in the convector. The clip, component and convector must all be simultaneously held in a fixture and then be fastened together with a threaded fastener. If the component includes a hole to accept a threaded fastener, it can be mounted directly to the convector using a threaded fastener that extends through that hole, without using a clip.

The use of such fasteners can have numerous drawbacks, particularly in a high volume production setting. Often, each hole in the convector that receives a fastener must be separately drilled or punched. This is especially true for an extruded convector if the axis of the hole is not aligned with the direction in which the convector is extruded. The fastening process can vary, but there is usually some degree of automation required, ranging from manually loading a screw into a bit on a pneumatically or electrically powered driver to using self-feeding screw machines. Typically, the torque applied by the device must be monitored regularly and adjusted in order to assure proper seating of the fasteners.

The clamping force between the convector and the component should be at a proper level to ensure sufficient heat transfer to the convector. When fasteners are used to attach the convector to the component, clamping force is a function of the type of fastener and its condition and degree of assembly (e.g. the level of torque applied during installation of the fastener). Thus, a threaded fastener that is not seated all the way will give less clamping force than one that is seated all the way. Or, a stripped or improper type of fastener may provide an insufficient clamping force.

Special fixturing is often required to hold a component in the proper location while it is mounted to the convector using one or more fasteners. Such fixturing can be very complex and use of such fixturing usually requires extra handling of both the component and of the resulting assembly, thereby adding to the production cycle time and potentially compromising quality of the final product.

When threaded fasteners are used, the assembly cycle time can be very long, especially in high volume production. The operator must specifically obtain the threaded fastener, bring it in contact with the driver bit, then drive the threaded fastened. If self-tapping fasteners are used, the process of driving the self-tapping fasteners into metal often causes metal shavings to disperse into the assembly. Such shavings have been known to cause electrical failures that can permanently damage the product. If self-tapping fasteners are not used, an extra production step is necessary to form threads in the metal of the convector.

Accordingly, there is a need for electrical assemblies that do not require fasteners or tooling for securing a component to a convector.

Vehicular radio chassis assemblies may typically contain a circuit board assembly and a playback mechanism that may have ground points from the circuit board to the enclosure. They also tend to have heat sinks added for conducting unwanted heat away from the radio circuit board power components to transfer the heat outside of the chassis. When the enclosure has been constructed of a non-metallic material such as plastic, the grounding and shielding has been provided by a variety of methods, including, but not limited to using a metal wire mesh that is insert molded with the structure of the plastic enclosure. Another method may include using localized shields that are assembled and soldered to the circuit board. However, this approach only provides a shield, not a ground. While plastic enclosures are desirable for manufacturing assembly simplification through the elimination of fasteners as well as weight reductions from the metal enclosures, the capitalization to provide a wire mesh insert to a plastic part has been a drawback, especially in low volume applications. Also, the manufacturing process flow has typically coupled the wire mesh insert fabrication cell directly with the plastic molding press, which may not be desired is the molding process utilization is not at a high enough percentage of the available molding press time.

### Electrostatic Discharge Device

Static electricity (electrostatics) is created when two objects having unbalanced charges touch one another, causing the unbalanced charge to transfer between the two objects. This phenomenon commonly occurs in homes, vehicles and other environments when the air is dry (i.e. has a characteristic relatively low level of humidity). For instance, when a person slides onto a car seat, electrons may transfer between the two, causing the surface of the person's body to store a charge. When the person, then, touches a vehicle component, the charge may travel (discharge) from the body to the component, thus creating static electricity. If the object touched is an electronic device, such as a home stereo, home theatre system, computer, vehicle entertainment system or other electronic media system, this electrostatic discharge can be harmful to the sensitive electronic components of the device. For instance, when a person slides onto a vehicle seat and inserts a disc into the car stereo, a charge may travel from the body through the disc to the sensitive electronic components in the vehicle stereo. Similar problems may occur when using DVD and other magnetic media and disc players.

Accordingly, problems with the drainage of a static electric charge impacting sensitive electronic components continue to persist.

### SUMMARY OF THE INVENTION

The present invention provides numerous product and process advantages which collectively result in substantial cost and labor savings. By way of example, the preferred design optimizes the assembly process. It minimizes the required handling of major components and subassemblies during the assembly cycle. Final assembly is optimized, wherein only three major components and subassemblies are involved. This minimizes the number of work stations and fixtures, in-process transfers between work stations and total assembly cycle time. The inventive design permits selection of the optimal mechanical product configuration for a given receiver family. Furthermore, it permits idealized electrical and mechanical building block partitioning for common and unique elements.

The preferred embodiment of the invention contemplates screwless final assembly without the use of tools, fixtures and assembly machines. This greatly enhances in-process product flow in the factory, improves scheduling of final assembly, and allows labor intensive processes such as stick lead assembly to be largely moved off-line. This greatly reduces both direct and indirect labor requirements. Furthermore, inventory control is simplified inasmuch as position part proliferation is deferred to or near the end of process.

An embodiment of the invention described herein provides an electronic system housing assembly and method which includes a compression molded three-dimensional case configured to define a substantially closed cavity, either in its own right, or in combination with a front closure member. The case is formed of layered coalesced composite of one or more layers of relatively rigid polymer sheet material and a layer of electrically conductive sheet material operative to shield an electronic component within the cavity and to mount the housing assembly within a host vehicle.

A preferred embodiment of the present invention describes a flexible enclosure assembly for an electronic device for vehicular application is virtually "fastenerless" and includes a preform blank of conductive sheet material such as wire screen mesh or the like which defines upper, lower and a plurality of side wall portions flexibly interconnected by living hinges. A framework of resilient elastomeric material is insert molded to the preform blank to provide three-dimensional case details to accept one or more electronic devices such as circuit boards required for electrical control and display of vehicle based systems. The conductive sheet material is preferably a wire mesh which provides shielding from electrical anomalies and grounding of the circuit boards via exposed wire mesh pads and adjacent ground clips. Major components and subassemblies are self-fixturing during the final assembly process, eliminating the need for dedicated tools, fixtures and assembly equipment.

These and other features and advantages of this invention will become apparent upon reading the following specification, which, along with the drawings, describes preferred and alternative embodiments of the invention in detail.

### BRIEF DESCRIPTION OF THE DRAWINGS

The present invention will now be described, by way of example, with reference to the accompanying drawings, in which:
FIG. 1, is an exploded, perspective view of a prior art automotive radio/CD player combination in a common chassis constructed of sheet metal and a large number of threaded fasteners;
FIG. 2, is a front-left perspective view of an embodiment of an electronic circuit enclosure assembly embodied in an automotive radio/CD player, given as an example useful for the understanding of the invention ;
FIG. 3, is an exploded, perspective view of the radio/CD player of Figure 2, illustrating the major subcomponents and subassemblies thereof;
FIG. 4, is an exploded, perspective view of the radio/CD player of Figure 2, illustrating final assembly step I in the production thereof wherein the playback mechanism and circuit board assembly are slid and snapped to the faceplate;
FIG. 5, is an exploded, perspective view of the radio/CD player of Figure 2, illustrating final assembly step II in the production thereof wherein the case is slid and snapped to the faceplate;
FIG. 6, is an exploded, perspective view of the radio/CD player of Figure 2, illustrating final assembly step III in the production thereof wherein the power device retainer clip and heat sink are consecutively anchored, pivoted and snapped to the side of the case;
FIG. 7, is an exploded, perspective view of the radio/CD player of Figure 2, illustrating final assembly step IV in the production thereof wherein the trim plate assembly is snapped to the faceplate/back-end assembly;
FIG. 8, is a bottom plan view of the radio/CD player of Figure 2;
FIG. 9, is a left side plan view of the radio/CD player of Figure 2;
FIG. 10, is a rear plan view of the radio/CD player of Figure 2;
FIG. 11, is a perspective view of the circuit board assembly with ground clips installed thereon;
FIG. 12, is a fragmentary, cross-sectional view of a ground clip and an associated portion of the printed circuit board on an enlarged scale in assembly with an adjacent portion of the case to effect a grounding point with the integral wire mesh;
FIG. 13, is a fragmentary, perspective view of a keypad grounding clip integrally formed on the front side of the faceplate;
FIG. 14, is a cross-sectional view taken on lines 14 - 14 of Figure 13;
FIG. 15, is a cross-sectional view taken on lines 15 - 15 of Figure 13;
FIG. 16, is a cross-sectional view taken on lines 16 - 16 of Figure 13;
FIG 17, is a front perspective view of a prior art faceplate illustrating rivet/staked spring clips for ESD protection to associated contact pads on a trim plate assembly;
FIG. 18, is an exploded, perspective view of a second embodiment of a radio/CD player featuring an unfolded case which provides a single plane bottom up assembly configuration and given as an example useful for the understanding of the invention;
FIG. 19, is a representative cross-section of the case wall structure of the radio/CD player of Figure 18, on a greatly enlarged scale, illustrating a thin wall section forming a living hinge;
FIG. 20, is a fragmentary, cross-sectional detail of adjacent case panel edge portions of the radio/CD player of Figure 18, on an enlarged scale, in a post assembly orientation prior to engagement of cooperating integral latch features;
FIG. 21, is a fragmentary, cross-sectional detail of adjacent case panel edge portions of the radio/CD player of Figure 18, similar to that of Figure 20, in a post assembly orientation after engagement of cooperating integral latch features;
FIG. 22, is a representative cross-sectional detail of a variant of the case wall structure of the radio/CD player of Figure 18, on a greatly enlarged scale, illustrating a screen only section forming a living hinge;
FIG. 23, is a schematic representation of manufacturing process equipment for producing a continuous strip of composite/laminate (plastic-screen-plastic) material for subsequent formation of the case structure of the radio/CD player of Figure 18;
FIG. 24, is a representative view, on a greatly enlarged scale, of laminate case material produced by the process equipment of Figure 23, illustrating a localized deformation of the material to define a reduced thickness, undulating living hinge section;
FIG. 25, is a schematic representation of alternative manufacturing process equipment for producing a continuous strip of composite (plastic & screen) material for subsequent formation of a case structure suitable for the radio/CD player of Figure 18;
FIG. 26, is a front perspective view of an embodiment of electronic circuit enclosure assembly, given as an example useful for the understanding of the invention and substantially similar to that of Figure 2, but with I/O control device function graphical detail highlighted;
FIG. 27, is a front perspective view of the interior surface details of the case/back-end of Figure 10 illustrating the wire mesh screen which has been insert molded within the case adjacent the inner surface portions thereof;
FIG. 28, is a front-above perspective view of a partially assembled radio/CD player, substantially similar to that illustrated in Figure 7 (prior to installation of the trim plate assembly), illustrating, inter alia, (1) three outwardly directed spring contacts carried by resilient members integrally formed with the faceplate and (2) the juxtaposition of the wire mesh within the faceplate adjacent the outer surface thereof;
FIG. 29, is a front-left perspective view of the partially assembled radio/CD player of Figure 28, illustrating the same features from a different perspective;
FIG. 30, is a fragmentary, perspective view of a keyboard assembly printed circuit board carried on the inside surface of the trim plate assembly illustrating one of three contact pads which, after assembly, register with and establish electrical interconnection with spring contacts illustrated in Figures 28 and 29;
FIG. 31, is a perspective view of the back side of the trim plate assembly of the prior art radio/CD player illustrated in Figure 1, illustrating the surface details thereof;
FIG. 32, is a broken, bottom-rear perspective view of an audio system assembly embodying an embodiment of an electronic circuit enclosure assembly, given as an example useful for the understanding of the invention and illustrating internal PCB front and rear edge self-grounding with integral features of the audio system housing assembly;
FIG. 33 , is a broken, cross-sectional view, on an enlarged scale, of the rear edge of the PCB of Figure 32 self-engaging and self-grounding with exposed electrically conductive shield and guide tangs integrally formed with the audio system housing assembly;
FIG. 34, is a broken, cross-sectional view, on an enlarged scale, of the front edge of the PCB of Figure 32 self-engaging and self grounding with exposed electrically conductive shield and guide tangs integrally formed with the audio system housing assembly;
FIG. 35, is a broken, rear facing perspective view of the exposed electrically conductive shield and guide tangs of Figure 33, with the PCB removed;
FIG. 36, is a broken, forward facing perspective view of the exposed electrically conductive shield and guide tangs of Figure 34, with the PCB removed;
FIG. 37, is a broken, perspective, cross-sectional view of an alternative approach to self-grounding a PCB, wherein a rearwardly directed extension of the PCB containing grounding pads on the top or bottom (or both) surfaces thereof registers with an opening formed in the rear wall of the case exposing electrically conductive screen;
FIG. 38, is a broken, cross-sectional view of the alternative embodiment of Figure 37, with the PCB is in its installed design position wherein the extension has pierced the exposed screen and established electrical connection between the grounding pads and the screen;
FIG. 39, is a bottom-rear perspective view of a CD player subassembly affixed to opposed left and right mounting brackets via integral squirts;
FIG. 40, is a broken, cross-sectional view, on an enlarged scale, of one of the squirts taken on line 139 - 139 of Figure 39, as it is manually applied (as illustrated in phantom) within an adjacent opening in the CD player subassembly;
FIG. 41, is a broken, perspective view, on an enlarged scale, of one of the squirts of Figure 39;
FIG. 42, is a top plan view of an alternative embodiment of one of the squirts of Figure 39;

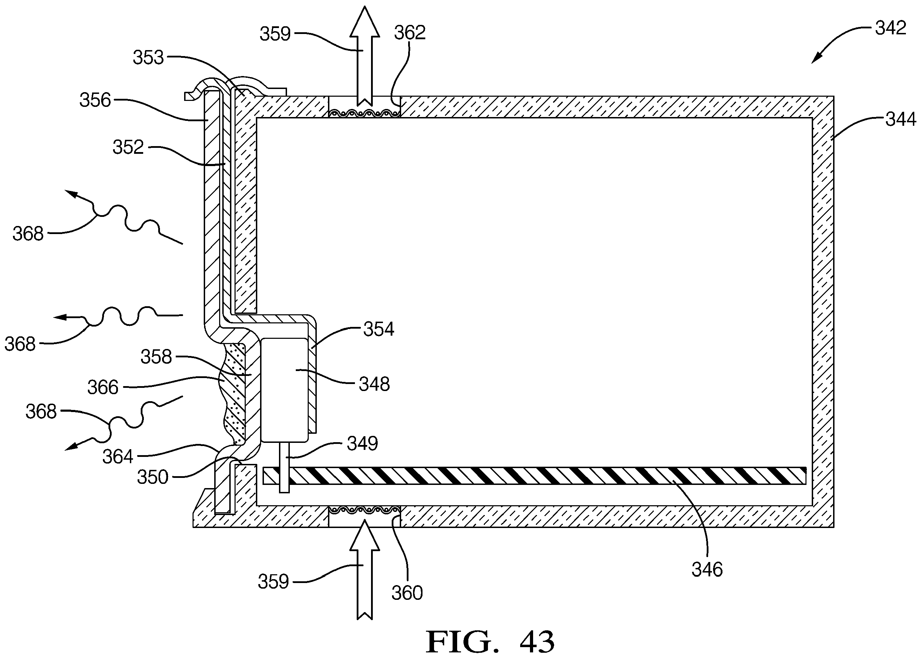

FIG. 43, is a cross-sectional schematic view of a simplified thermal control apparatus;
FIG. 44, is an exploded, perspective view of an embodiment of a radio/CD player, illustrating the major subcomponents and subassemblies thereof;
FIG. 45, is a perspective view of a generally planer preform blank as formed, given as an example useful for the understanding of the invention, such as be injection molding, prior to beginning the final assembly process;
FIG. 46, is a perspective view of the radio/CD player of Figure 44, illustrating final assembly step I in the production thereof wherein the trim plate assembly is snapped to the outer surface of one of the four wall portions, specifically the front wall portion, defined by the perform blank of Figure 45;
FIG. 47, is a perspective view of the radio/CD player of Figure 44, illustrating final assembly step II in the production thereof wherein the circuit board assembly is slid and snapped to the inner surface of the front wall portion defined by the perform blank of Figure 45;
FIG. 48, is a perspective view of the radio/CD player of Figure 44, illustrating final assembly step III in the production thereof wherein the playback mechanism is slid and snapped to the inner surface of the front wall portion defined by the perform blank of Figure 45;
FIG. 49, is a perspective view of the radio/CD player of Figure 44, illustrating final assembly step IV in the production thereof wherein the remaining three wall portions (top, back and bottom) defined by the perform blank of Figure 45 are folded by rotation about a first living hinge from a horizontal orientation illustrated in Figure 48 to a substantially vertical orientation;
FIG. 50, is a perspective view of the radio/CD player of Figure 44, illustrating final assembly step V in the production thereof wherein the remaining two wall portions (back and top) defined by the perform blank of Figure 45 are folded by rotation about a second living hinge from a vertical orientation illustrated in Figure 49 to a substantially horizontal orientation;
FIG. 51, is a perspective view of the radio/CD player of Figure 44, illustrating final assembly step VI in the production thereof wherein the remaining wall portion (top) defined by the perform blank of Figure 45 is folded by rotation about a third living hinge from a horizontal orientation illustrated in Figure 50 to a substantially horizontal orientation, thus forming the case into a three dimensional configuration;
FIGS. 52 and 53, are perspective views of the radio/CD player of Figure 44, illustrating final assembly step VII in the production thereof wherein the discrete right side wall closure member is installed via snap-fit engagement features and thermally coupled with power devices carried with the circuit board assembly;
FIG. 54, is a rear side perspective view of the completed radio/CD player;
FIG. 55, is broken segment of the front wall portion interconnected to a broken segment of the bottom wall portion by the first living hinge of Figure 45, in an enlarged scale;
FIG. 56, is a broken cross-sectional view taken along lines 56 - 56 of Figure 55;
FIG. 57, is a broken cross-sectional view taken along lines 57 - 57 of Figure 56;
FIGS. 58 and 59, are perspective views of living hinge reinforcement features in the preform blank respectively integrally formed with two adjacent wall portions which self-engage and interlock upon displacement of the adjacent wall portions from a parallel orientation to a normal orientation;
FIG. 60, is an exploded, perspective view of the cockpit area of an automobile, illustrating an instrument panel mounted electronic system embodying the present invention;
FIG. 61, is a perspective view of the inside details of a compression molded clamshell-shaped case of the electronic system of Figure 60, given as an example useful for the understanding of the invention and including upper and lower case halves joined by a living hinge in an as-molded configuration;
FIG. 62, is an exploded, perspective view of the clamshell case of Figure 61 aligned for assembly with an electronic circuit assembly;
FIG. 63, is a perspective view of the exploded assembly of Figure 62 with the upper and lower case halves folded about the living hinge to define a cavity enclosing the electronic circuit assembly;
FIG 64, is an exploded, perspective view of the folded case assembly of Figure 64 aligned for assembly with a vehicle operator accessible trim panel;
FIG. 65, is a top plan view of the electronic system of Figure 65;
FIG. 66, is a cross-sectional view of the electronic system taken along lines 66-66 of Figure 65;
FIG. 66A is a broken segment of a portion of the cross-sectional view of Figure 66 on an enlarged scale, illustrating details of the mounting of the electronic circuit assembly within the housing case between two opposed locating pedestals;
FIG. 67, is a schematic representation of manufacturing process equipment for producing a continuous strip of composite/laminate (plastic/screen/plastic) material for subsequent compression molding via hydorform technique for formation of a case structure of the electronic system of Figure 60;
FIG. 68, is a cross-sectional view of a hydroform die employed in the manufacturing process of Figure 67, including an upper portion including a draw ring and a fluid filled flexible bladder, a lower portion guiding a displaceable male punch die, and an intermediate work piece;
FIG. 69, is a cross-sectional view of the hydro form die of Figure 68, wherein the upper and lower portions have been closed to clampingly engage the work piece and the flexible bladder has been pressurized to press the work piece against the male punch die to partially deform the work piece against the male punch die;
FIG. 70, is a cross-sectional view of the hydroform die of Figure 68, wherein the upper and lower portions remain in the closed position and the male punch die is hydraulically displaced upwardly to fully deform the work piece to mimic the contours of the male punch die;
FIG. 71, is a cross-sectional view of the hydroform die wherein the fluid pressure in the bladder has been released, the male punch die is retracted to its released position, and the upper and lower portions are spaced to release the fully shaped work piece;
FIG. 72, is a broken segment of sheet wire mesh, on an enlarged scale, of the type continuously deployed from a center feed roller of figure 67;
FIG. 73, is a broken segment of feed material including the wire mesh of Figure 72 arranged with upper and lower layers of polymer sheet material prior to hydro forming;
FIG. 74, is a broken segment of post-hydroforming coalesced composite material wherein localized portions of the upper and lower polymer sheet material flows inwardly within wire mesh interstices to mechanically couple therewith, forming a knit line nominally coincident the center line of the adjacent wire mesh;
FIG. 75, is a perspective view of the outer surface of a composite insert molded silicone elastomeric material - wire mesh blank employed in a preferred embodiment of the present invention;
FIG. 76, is a perspective view of the inner surface of the composite insert molded silicone elastomeric material - wire mesh blank of Figure 75;
FIG. 77, is a perspective top view for the composite blank of Figures 75 and 76 folded to enclose an electronic device for shielding from electrical anomalies;
FIG. 78, is a perspective bottom view for the composite blank of Figure 77 illustrating the folded external flaps;
FIG. 79, is an exploded, perspective view of the assembled, shielded electronic device of Figures 77 and 78 in application with an operator interface, such as a vehicle audio system trim panel;
FIG. 80, is a perspective rear view of the assembled, shielded electronic device of Figures 77 and 78 in application with a remote closure assembly not requiring displays and operator inputs;
FIG. 81, is a perspective front view of the assembled, shielded electronic device of Figures 77 and 78 illustrated in Figure 80;
FIG. 82, is a broken, cross-sectional view of a section of molded plastic case circuit board assembly slot operative to compressively support the adjacent edges of a printed circuit board and an associated composite insert molded silicone elastomeric material - wire mesh blank;
FIG. 83, is a broken, cross-sectional view of a push/pull through integrally formed with a composite insert molded silicone elastomeric material - wire mesh blank for securing same to an associated printed circuit board;
FIG. 84, is a broken, cross-section of a portion of a composite insert molded silicone elastomeric material - wire mesh blank forming a living hinge area; and
FIG. 85, is a broken, cross-section of a portion of a composite insert molded silicone elastomeric material - wire mesh blank forming an integral switch pad dome.

Although the drawings represent varied embodiments and features of the present invention, the drawings are not necessarily to scale and certain features may be exaggerated in order to illustrate and explain the present invention. The exemplification set forth herein illustrates several aspects of the invention, in one form, and such exemplification is not to be construed as limiting the scope of the invention in any manner.

### DESCRIPTION OF THE ILLUSTRATIVE EMBODIMENTS

The present invention can be applied in its broadest sense to electronic devices and systems where shielding from radio frequency interference (RFI), electromagnetic interference (EMI), bulk current injection (BCI) and/or electrostatic discharge (ESD) is required. In addition to vehicle based radios and audio entertainment systems, the invention can be advantageously applied in "infotainment" and telematic systems. Furthermore, the present invention employs virtually "fastenerless" design architecture to facilitate low-cost, high volume production techniques.

A telematics product is a two-way communication/receiver system that enables access by a vehicle occupant to vehicle related information like geographic position/ location through the use of a GPS module with antenna, vehicle diagnostics, crash sensors and air bag deployment. It also contains a phone module that is linked through a microphone in the vehicle and the radio speaker system for hands free calling via voice recognition and links to a call center for a variety of services, including but not limited to emergency help, concierge, vehicle theft recovery, turn-by-turn route guidance, vehicle diagnostics and vehicle unlock.

For convenience of understanding, the following description will be focused primarily upon an automotive radio/CD player system.

### LIGHTWEIGHT RADIO/CD PLAYER FOR VEHICULAR APPLICATION

The present invention reflects an improved design to reduce the overall weight of an automotive radio/CD player without compromising the strength of the unit. The present invention employs a polymer based material that can be molded to provide the necessary features for the chassis as well as the frontal interface to the decorative front-end assembly described for the man-machine interface. By molding a case with the necessary details to accept the playback mechanisms (if desired) as well as the circuit board(s) needed for the electrical control, the required functionality of the unit is maintained as compared to the typical metal box. The necessary shielding and grounding is accomplished by insert-molding a mesh screen wire that has been pre-formed to contour with the molding operation. The grounding of the circuit boards may be accomplished by using ground clips attached directly to the ground pads of the circuit board that would interface directly with exposed screen wire mesh of the molded part. While metal is also a good conductor for the thermal load inside the unit, openings must be incorporated to allow airflow for additional cooling. The same openings can compromise the shielding. With in-molded mesh screen wire, the mesh acts as a Faraday cage to shield the electronics, but the open weave allows airflow to promote the dissipation of the thermal load from inside the unit, to the exterior. Besides the reduction of mass offered by the molded polymer material for the unit chassis and front plate, the hidden benefits include ease of handling in the assembly process as well as less container and shipping weight.

To facilitate assembly, the molded polymer chassis and front plate can use integral or molded in guideways and snaps, thereby eliminating the typical screw fastener assembly method previously used for these components. To enhance the rigidity, the component parts that comprise the assembly are sandwiched at the common vehicle instrument panel attachment points such that when the mounting screws are driven, they firmly clamp the component pieces to the host vehicle. In the event a playback mechanism of substantial mass and volume is required, the subassembly structure for the mechanism would utilize formed attachment tabs that would be an intermediate layer in the aforementioned component part sandwich. Another benefit for the mounting at the back of the radio is often vehicles have a receptive hole or slot in the inner cavity of the instrument panel carrier that accepts a mounting bushing or "bullet" shaped extension that is screwed to a mounting stud that is typically swaged to the back of the metal enclosure of the radio. The mounting "bullet" can be molded directly in the polymer-based case eliminating the additional part and the assembly of that additional part.

To replace the metal structure of the vehicle radio, a galvanized (or appropriately coated) steel mesh wire screen will be cut, formed, and molded with a polymer resin to provide necessary details for assembly of components required for the functionality of the radio including, but not limited to, a circuit board assembly, a heat sink for audio power and switching components, a playback mechanism, and a man-machine interface or trim plate assembly, as well as vehicle mounting features. While the polymer or plastic provides the majority of the mechanical structure for the radio, the in-molded mesh screen wire provides the needed protection from various electrical anomalies including electromagnetic contamination, radio frequency interference, bulk current injection, and electrostatic discharge, to name a few. The screen mesh also allows openings necessary for air passage or venting of heat from the radio by molding the radio back end or case and front plate. The many details and features needed in a typical assembly can be incorporated directly into the parts, eliminating the need for fasteners and separate additional parts often required with parts fabricated in metal.

The specific materials selected for fabricating the radio case and front plate will vary depending upon the application, including the contained mass of the mechanisms employed as well as the severity of the contemplated environment (esp. temperature and vibration). Examples of materials that could be employed for typical automotive applications are:
Case: Glass-filled polyester, Glass-filled polypropylene, Polycarbonate, ABS.
Front Plate: Polycarbonate, ABS, PC/ABS and Noryl.

Major components which contact one another or are mechanically interconnected preferably are formed from material having substantially differing surface finish and hardness characteristics to minimize the possibility of resulting squeaks, rattles and the like.

Although presently viewed as cost prohibitive for automotive applications, it is contemplated that nano carbon tube filler can be employed within the plastic material forming the case and front plate to provide effective shielding and enhance the structural strength of the case assembly.

In addition to weight savings, which may amount to well over one pound (0.4536 Kg), the part handling is improved to reduce the amount of fasteners as well as separate component parts. Often a radio may be constructed from a wrap-around, a cover and the fasteners along with a mounting bushing or "bullet" screwed to a "swaged" threaded stud in the metal case. Also, the metal pieces require assembly personnel to wear gloves during handling to avoid any cuts or damage to their hands as well as protection from any metal fabrication fluid residue. Molded plastic does not require any special gloves, or the concerns of cuts to the skin. Aside to the benefit to the vehicle by reducing the radio weight by over one pound (0.4536 Kg), the savings for a manufacturer include reduced shipping cost through the weight reduction and potential container efficiency improvements. Product labeling can be improved through laser engraving the plastic with the desired number, customer logos, etc. Metal typically requires a stamping detail (not easily changed) and/or a printed label that is adhesively applied. This offers greater flexibility and eliminates additional parts (like labels) to use the plastic, as well as better durability than a label.

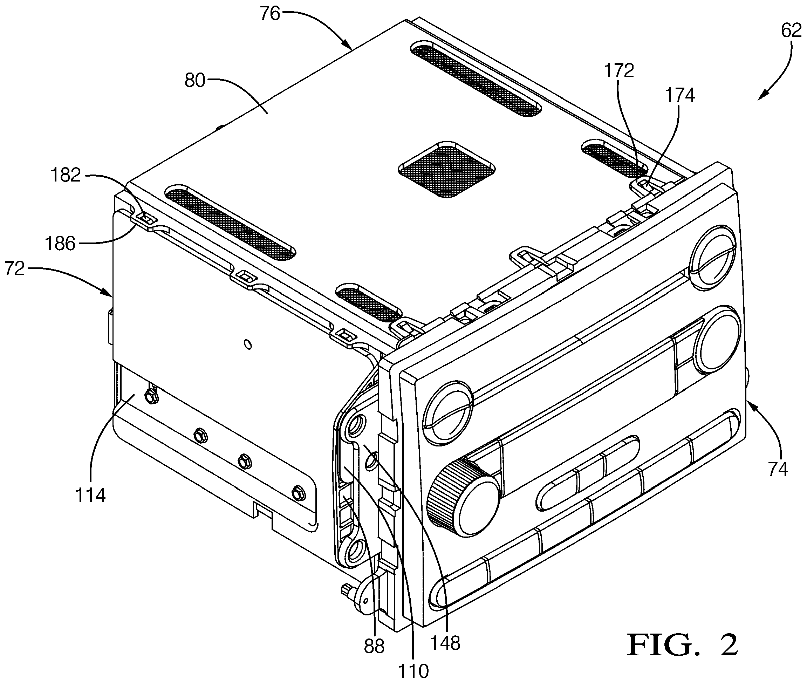

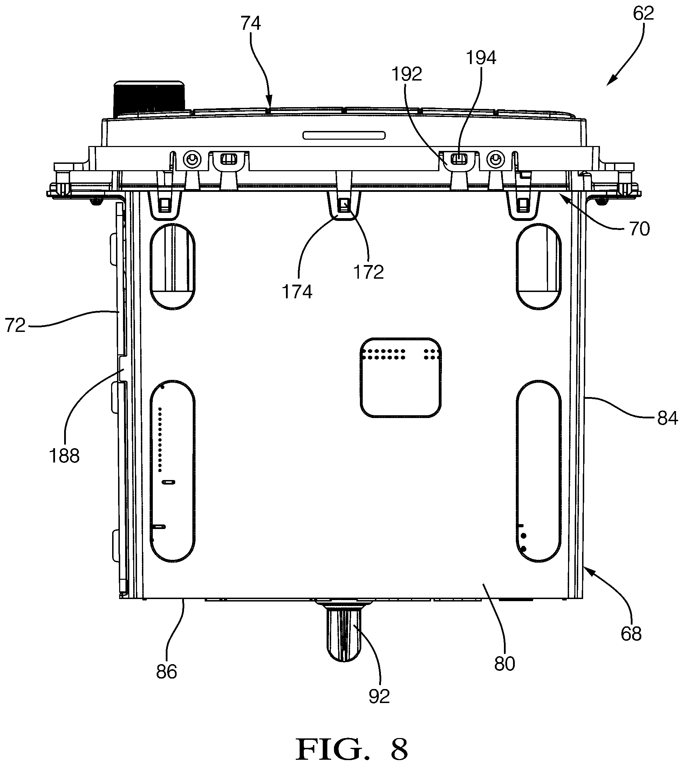

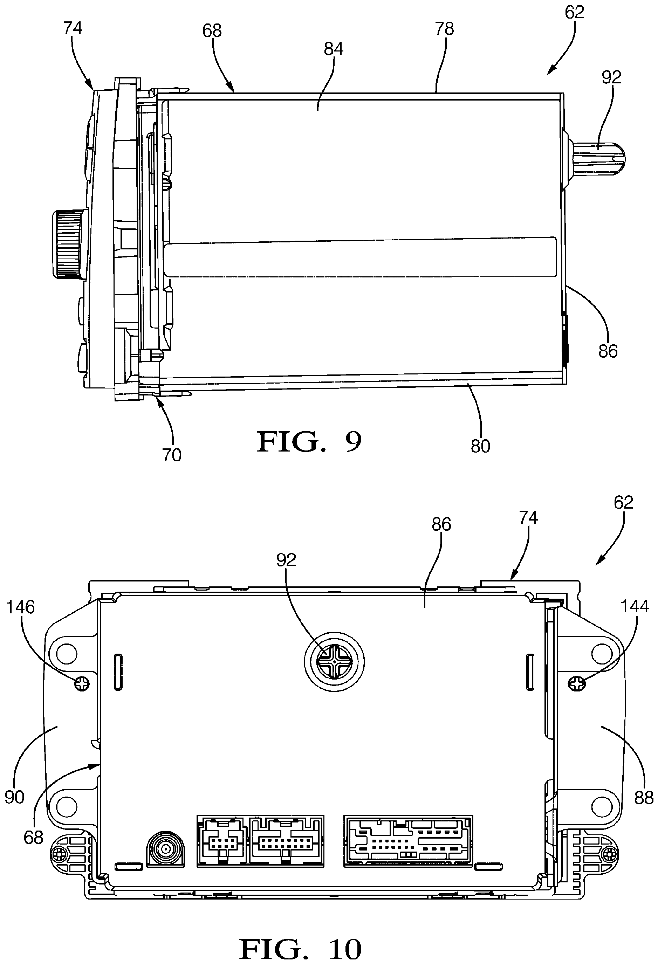

Referring to Figures 2 - 10, a consolidated radio/CD player apparatus 62 embodying many aspects of an electronic circuit enclosure assembly is illustrated. The radio/CD player 62 is an assemblage of six major components or subassemblies, a circuit board subassembly 64, a CD player subassembly 66, a box-like housing case 68, a front closure member or front plate 70, a convector or heat sink 72 and a trim plate subassembly 74.

It is envisioned that each of the major components/subassemblies would be produced "off-line" and the final assembly process would comprise the efficient, high volume joining of the major components/subassemblies and end-of-line testing of the completed units.

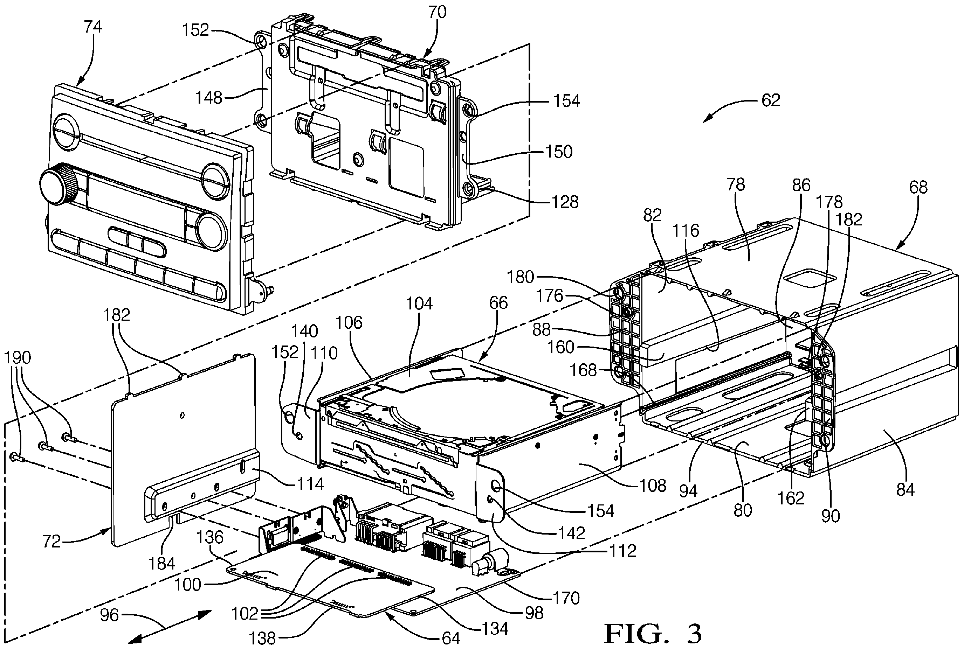

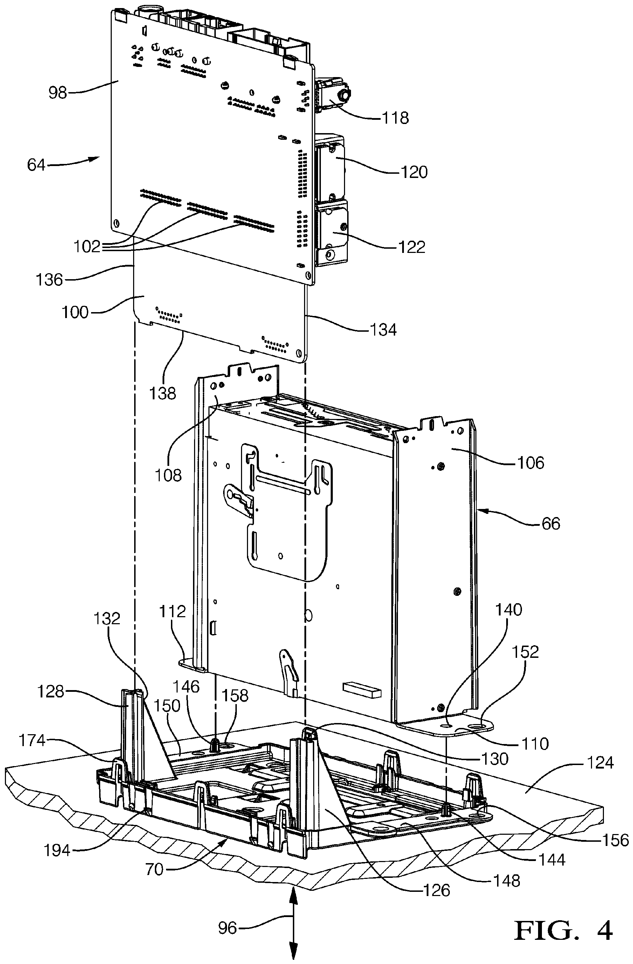

Figures 2 and 8-10 depict plan and perspective views of the fully assembled radio/CD player apparatus 62. Figure 3 is an exploded view illustrating the juxtaposition of the respective major components during the assembly process. Figures 4 - 7 depict specific assembly steps of the major components as will be described hereinbelow.

The case 68 and front plate 70 are each preferably injection molded of polymer based material and collectively comprise a substantially closed housing assembly 76. The case 68 has a box-like structure, including upper and lower wall portions 78 and 80, respectively, left and right side wall portions 82 and 84, respectively, and a rear wall portion 86. The case 68 also has mounting features extending externally of the case walls, including left and right front mounting flanges 88 and 90, respectively, extending from the forward edges of the left and right side walls 82 and 84, respectively, and a mounting stud 92 extending rearwardly from the rear wall 86. All of the case wall portions and mounting features of the case 68 are integrally formed in a single injection molding process. The case defines a front opening 94 which, upon assembly, is closed by front plate 70. An assembly axis 96 extends symmetrically from front to rear of the case 68, exiting opening 94 along the nominal centerline of the case 96.

The circuit board subassembly 64 consists of a common or main printed circuit board (PCB) 98 and a unique, application specific PCB 100 which are electrically and mechanically interconnected by several pin connectors 102. It is envisioned that edge connectors, ribbon connectors or the like could be substituted for the pin connectors 102. The common PCB 98 contains all surface mount components. The circuit board subassembly 64 comprises an audio component.

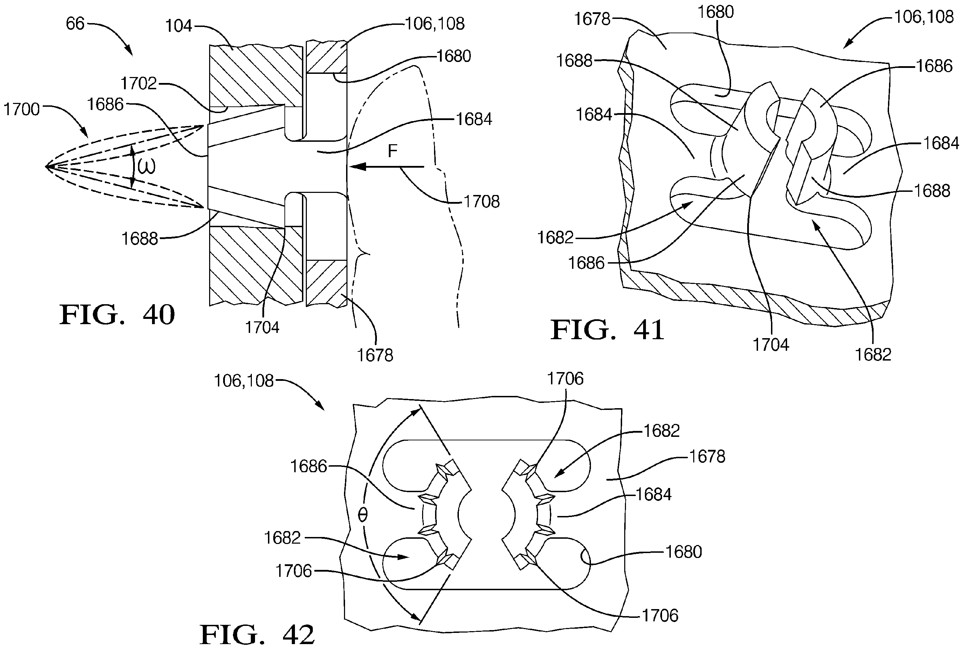

The CD player subassembly 66 consists of a conventional multi-disc player unit 104 and substantially mirror-image left and right side mounting brackets 106 and 108, respectively, affixed thereto by integral fastener devices such as "squirts" (refer Figures 40 - 42). Note that there are slight differences between the left and right mounting brackets 106 and 108, but they are deemed to be inconsequential for purposes of the present invention. The left and right mounting brackets 106 and 108 have outwardly directed mounting flanges 110 and 112, respectively, which, upon assembly, register with case mounting flanges 88 and 90, respectively. The CD player subassembly 66 comprises an audio component.

The heat sink 72 comprises a substantially flat, stamped aluminum plate adapted for mounting to the outer surface of the left case sidewall 82 and includes a recessed portion 114 which, upon installation, extends inwardly through a port 116 in left case sidewall 82 for thermal interconnection to heat generating and power circuit components 118, 120 and 122 carried on the main PCB 98.

The trim plate subassembly 74 is configured to organize audio system input/output and display devices, informational indicia and decorative display devices for an associated host vehicle operator.

Referring particularly to Figures 4 - 7, a method of assembly of the lightweight audio system 62 of an electronic circuit enclosure assembly is illustrated. Audio system 62 can be assembled manually by an ordered process wherein a single (preferably, but not limited to) operator, who sequentially assembles the six major components or subassemblies on a designated work surface 124. No specialized tools or separate/dedicated fixtures are required. No threaded fasteners/screws are required. Each or the major components and subassemblies form integral features which cooperate to interact with features of the other components and subassemblies to register, align and guide the components and subassemblies during adjoining thereof as well as to removably affix the components and subassemblies to one another when in their final design position. This process is referred to herein as the Slide-lock Snap-lock™ Screwless Assembly Technology and Method or "SLAT". In effect, the components "self-fixture one another in combination the manipulation of the

Assembly of the radio/CD player 62 is affected by the assembly technician or operator taking the following steps:

As illustrated in Figure 4, place the front plate 70 on the work surface 124 in an inverted position with the outer surface of the front plate disposed upon the work surface 124. The centerline of the front plate 70 defines an assembly axis, as designated by arrow 96 extending normally to the work surface 124.

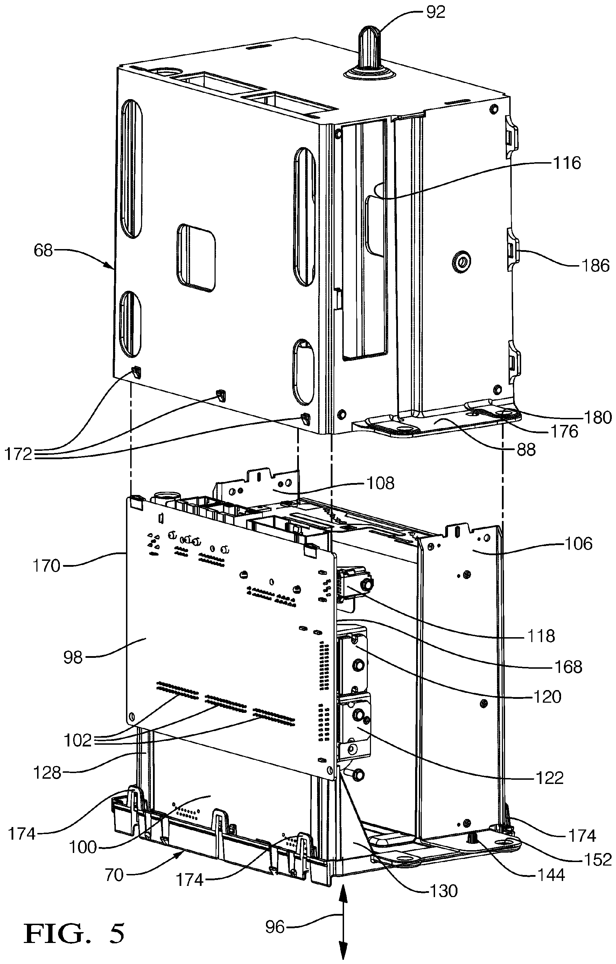

The front plate has two laterally spaced, rearwardly directed extensions 126 and 128 integrally formed therewith. Extensions 126 and 128 form guideways or opposed slots 130 and 132, respectively, which open towards one another and are directed parallel to the assembly axis 96. Lateral edge guide surfaces 134 and 136 of the application specific PCB 100 register within slots 130 and 132 and are guided thereby during the insertion process until the leading edge surface 138 of the PCB 100 contacts the inside (upward facing in Figures 4 and 5) surface of front plate 70. At this point, common PCB 98 is cantilever suspended from PCB 100 via pin connectors 102 and other supports (not illustrated). Referring Figure 5, the circuit board subassembly 64 is retained in position by the interfit of the edge surfaces 134 and 136 within slots 130 and 132.

The CD player subassembly 66 is next installed by manipulating it along the assembly axis 96 until through holes 140 and 142, formed in bracket mounting flanges 110 and 112, register with locating pins or nibs 144 and 146 integrally formed in laterally extending mounting flanges 148 and 150, respectively, integrally formed in front plate 70 . Thereafter, the CD player subassembly is displaced downwardly along the assembly axis 96 until the lower surfaces of bracket mounting flanges 110 and 112 abut the upper surfaces of front plate mounting flanges 148 and 150. The CD player subassembly 66 is retained in the position illustrated in Figure 5 by an interference fit between the front plate nibs 144 and 146, and the mounting bracket flange through holes 140 and 142.

Mounting bracket flanges 110 and 112 have secondary, larger diameter through holes 152 and 154 formed therein which register with similarly dimensioned through holes 156 and 158, respectively, formed in front plate mounting flanges 148 and 150 for receiving attachment means such as bolts, for affixing the completely assembled radio/CD player 62 to a host vehicle.

The steps of installing the circuit board subassembly 64 and the CD player subassembly can be reversed from that describer hereinabove.

The housing case 68 is next installed by manipulating it along the assembly axis 96 whereby the case wall portions 78, 80, 82, 84 and 86 fully envelop the circuit board subassembly 64 and CD player subassembly 66 in combination with the front plate 70.

As best viewed in Figures 3, 5 and 27, the centerline of the case 68 is first manually aligned with the assembly axis 96 and rotationally positioned with the subassembly consisting of the circuit board subassembly 64, CD player subassembly 66 and the front plate 70, whereby a first cooperating pair of guideways 160 and 162 integrally formed in case sidewall portions 82 and 84 register with the CD player mounting brackets 106 and 108 and, simultaneously, a second cooperating pair of guideways 164 and 166 integrally formed in case sidewall portions 82 and 84 register with lateral edge guide surfaces 168 and 170 of common PCB 98. The case 68 is then manually displaced along the assembly axis 96 until the leading edge thereof defining front opening 94 contacts the rear surface of the front plate 70. Thereafter, cooperating ramped snap-engagement features 172 and 174 integrally formed with upper and lower wall portions 78 and 80 of the case 68 and the front plate 70, respectively, momentarily self-displace one another and snap back to self-engage to establish a positive interlock therebetween.

The case mounting flanges 88 and 90 form through holes 176 and 178 which register and self-engage with nibs 144 and 146, respectively, to provide a redundant engagement feature. Furthermore, the case mounting flanges 88 and 90 form a second set of through holes 180 and 182, respectively, which register with through holes 152 and 154 of mounting brackets 106 and 108, and through holes 152 and 154 of front plate mounting flanges 148 and 150, respectively.

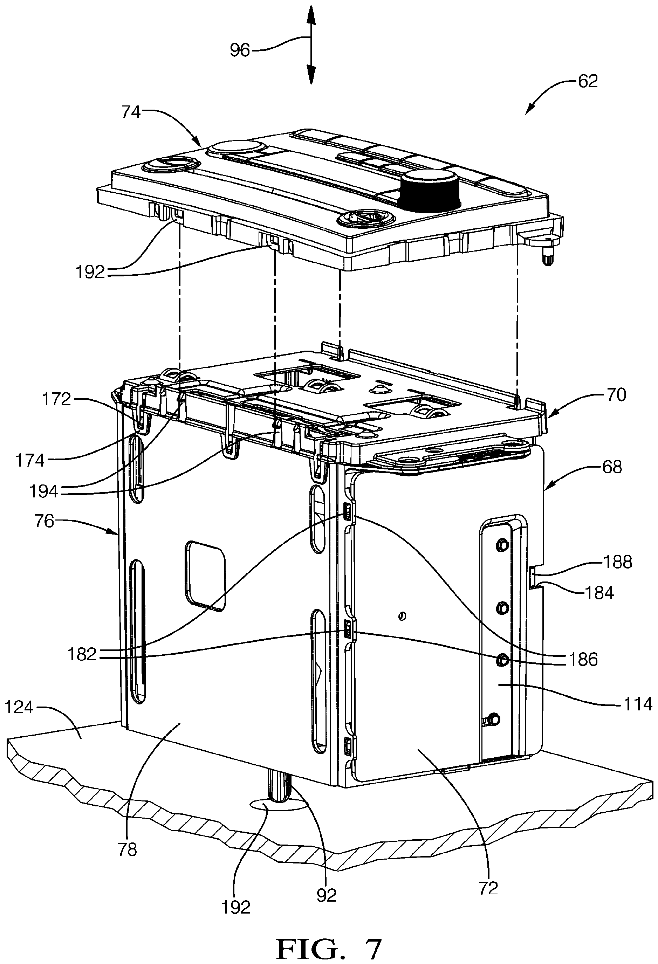

As best viewed in Figures 2, 6 and 7, the heat sink 72 is next installed. The heat sink 72 includes several locating tabs 182 integrally formed along one edge thereof and a locator recess 184 formed in an opposed edge. The heat sink 72 is manually affixed to the outer surface of the case left side wall portion 82 which defines integral tab receiving extensions 186 along the upper edge thereof. Once the heat sink locating tabs 182 are inserted within their respective case wall portion extensions 186, the heat sink 72 is rotated into its design position illustrated in Figure 7 wherein a resilient ramped catch member 188 integrally formed along the bottom edge of the left side wall portion 82 snap engages the recess 184 to fixedly interlock the heat sink 72 to the case 68.

When the heat sink 72 is in its installed position, the recessed portion 114 extends inwardly into the case 68 through the port 116. The inner surface of the recessed portion 114 establishing an abutting relationship against the power circuit components 118, 120 and 122 to provide a cooling thermal convector to the exterior of the case 68. Means are provided to ensure that components 118, 120 and 122 remain in intimate contact with the heat sink 72 such as screws 190, or, preferably to continuously resiliently urge the components into engagement with the recessed portion 114 of the heat sink 72.

It is contemplated that the heat sink 72 could be alternatively mounted to the case rear wall portion 86, whereby it would be installed along the assembly axis 96.

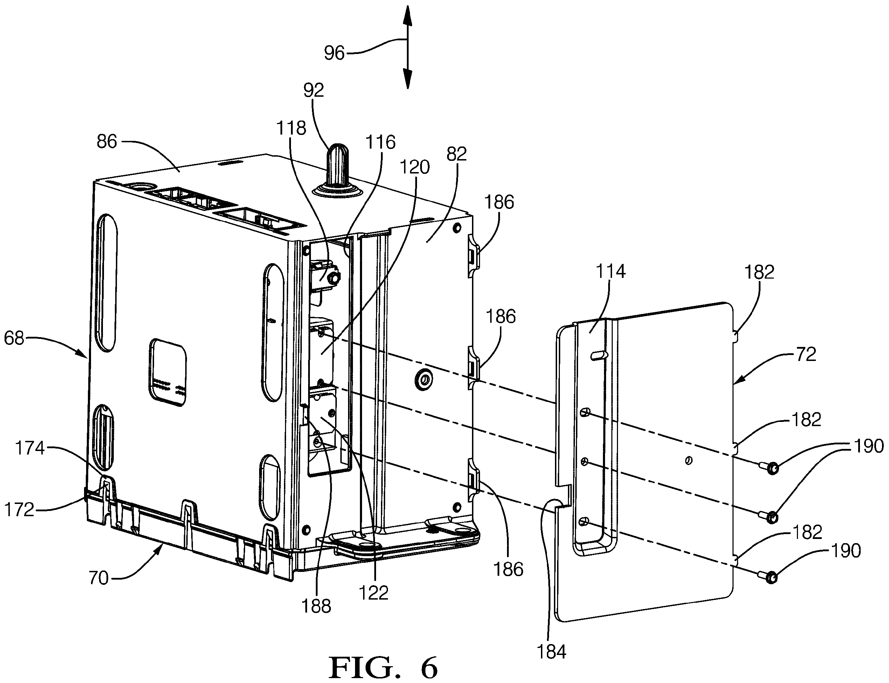

Referring to Figure 7, the final step of assembling the major components and subassemblies is illustrated. First, the subassembly of the components illustrated in Figure 6 is manually inverted, with the case rear wall portion 86 disposed on the designated work surface 124. Due to the localized outward projection of the stud 92, a stability enhancing spacer (not illustrated) or, alternatively, a recess 192 in the work surface 124 ensures a stable platform to complete assembly.

The trim plate subassembly 74 is then manipulated to become in register with the case 68 and manually displaced along the assembly axis 96 until the lower surface of the trim plate assembly 74 contacts the upper surface of the front plate 70 (as depicted in Figure 7). Thereafter, cooperating ramped snap-action engagement features 192 and 194 integrally formed with upper and lower edge skirt surfaces of the case trim plate assembly 74 and the front plate 70, respectively, momentarily self-displace one another and snap back to self-engage to establish a positive interlock therebetween.

The completed assembly of the major components and subassemblies is depicted in Figures 2, 8 - 10 and 26. Following the assembly process, the completed radio/CD player 62 is placed in a queue for testing and quality checks.

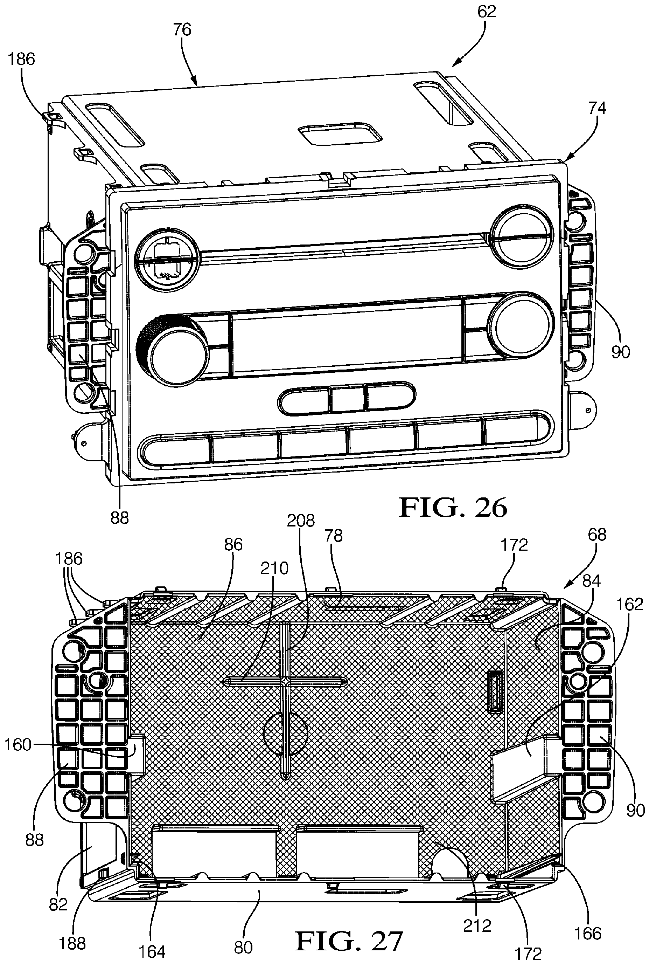

As is best illustrated in Figure 27, vertical and horizontal bosses 208 and 210, respectively, are located directly interiorly of the stud 92 to reinforce the rear wall portion 86 of the case 68 to prevent "oil-canning" and allows use of relatively thin wall section for enhanced weight saving.

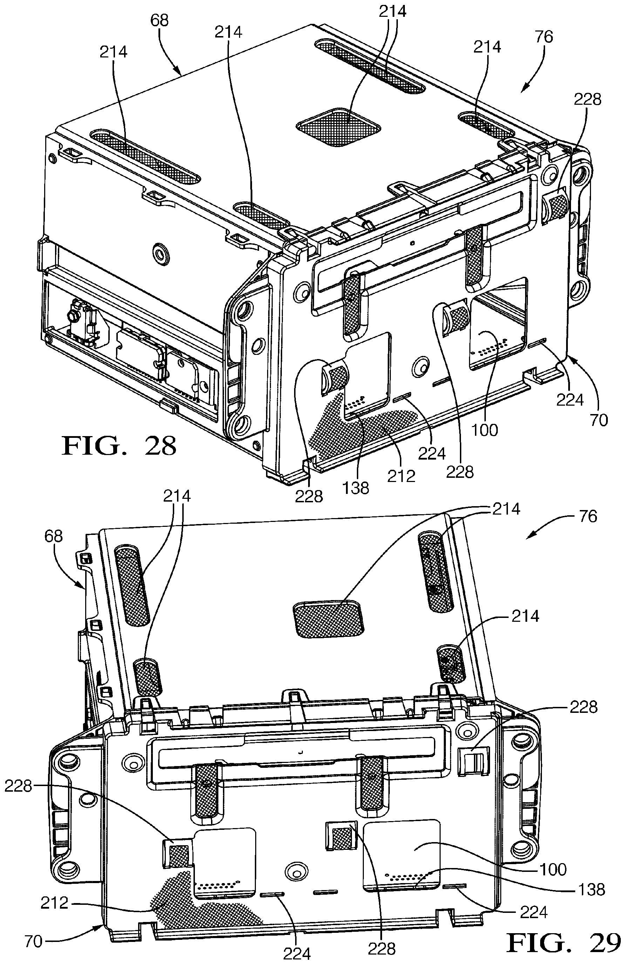

Figures 27 - 29 illustrate an alternative construction of the case 68 and front plate 70 of the housing assembly 76 wherein both elements of the case assembly 76 are formed of a composite of relatively rigid polymer material and electrically conductive material operable to shield the audio components (such as the circuit board subassembly 64 and the CD player subassembly 66) from electrical anomalies including radio frequency interference (RFI), electromagnetic interference (EMI), bulk current injection (BCI) and electrostatic discharge (ESD). The electrically conductive material comprises substantially continuous planer sheet portions applied to surfaces of or within polymer housing assembly wall portions as discrete elements, electrically conductive paint, foil or electrostatic or vacuum deposition applied material. Alternatively, the electrically conductive material comprises a wire mesh screen 212 which has been cut and folded to net shape and inserted within a mold cavity whereby it is effectively insert molded within the polymer based material. Preferably, the wire screen 212 is centered within the wall portions of the case and front plate whereby electrically insulating polymer material effectively covers the wire screen 212, both inside and out, to prevent inadvertent grounding of the housing assembly to interior or exterior structures.

Through empirical testing and development, the inventors have found that it is preferable to locate the wire screen 212 near the inside surface of the case 68 and the outside surface of the front plate 70. Openings 214 are provided in the case 68 by locally eliminating the polymer material but leaving the wire screen intact, whereby judiciously positioned openings 214 provide natural convection cooling to the ambient without having a break or gap in the electrical anomaly protection provided by the wire screen 212.

### CIRCUIT BOARD GROUNDING TO WIRE MESH SYSTEM

The common circuit board and the unique circuit board are grounded to the molded in wire mesh by using a grounding clip that contacts the ground plane on the circuit board to the metal mesh by pressing the circuit board with the clip installed into a hole or recess in the plastic box that exposes the mesh. A point/ridge/protuberance is used on the clip to press into the mesh and increase the pressure for intimate contact. An alternative of this clip is one that gets surface mounted and soldered to the board and does not require manual assembly.

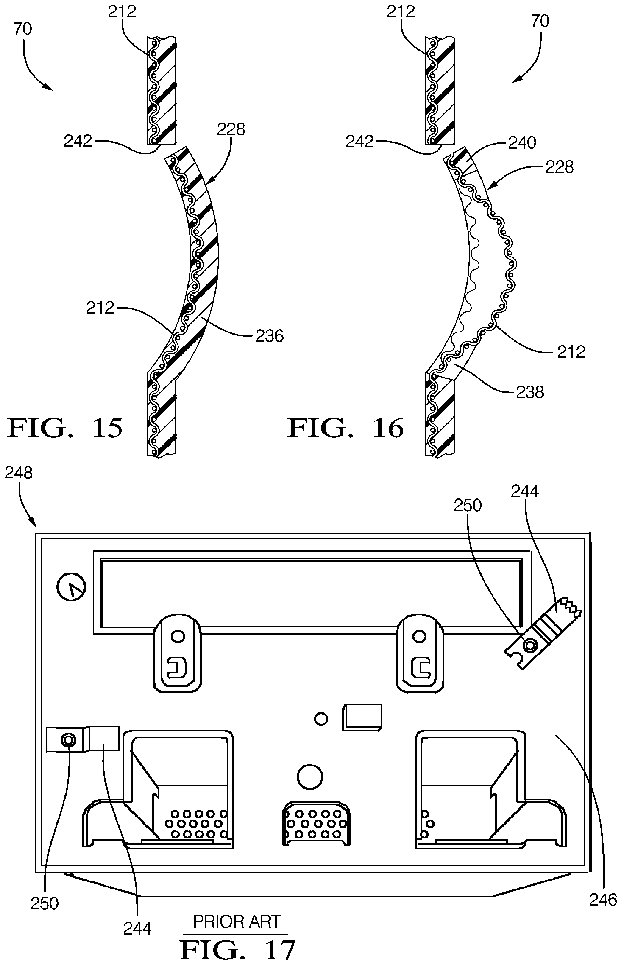

Referring to Figures 15 and 16, one form of grounding the ground plane 216 of the circuit board subassembly 64 to the wire screen 212 is illustrated. The leading edge surface138 of the unique PCB 100 carries two beryllium copper grounding clips 218, which are electrically and mechanically connected to the PCB ground plane 216. Similarly, a trailing edge surface 222 of the common PCB 98 carries two grounding clips 218. Each grounding clip 218 includes a resilient contact arm 220 extending outwardly along the assembly axis 96. Upon assembly, the grounding clips 218 carried on the leading edge surface 138 of PCB 100 register with exposed wire screen 212 within windows 224 in front plate 70 (refer Figures 94 and 95), and the grounding clips 218 carried on the trailing edge surface 222 of PCB 98 register with exposed wire screen 212 within windows 226 in the rear wall portion 86 of the case 68. The contact are 220 of each grounding clip 218 is configured to continuously bear against the adjacent exposed wire screen 212 to maintain electrical contact therewith.

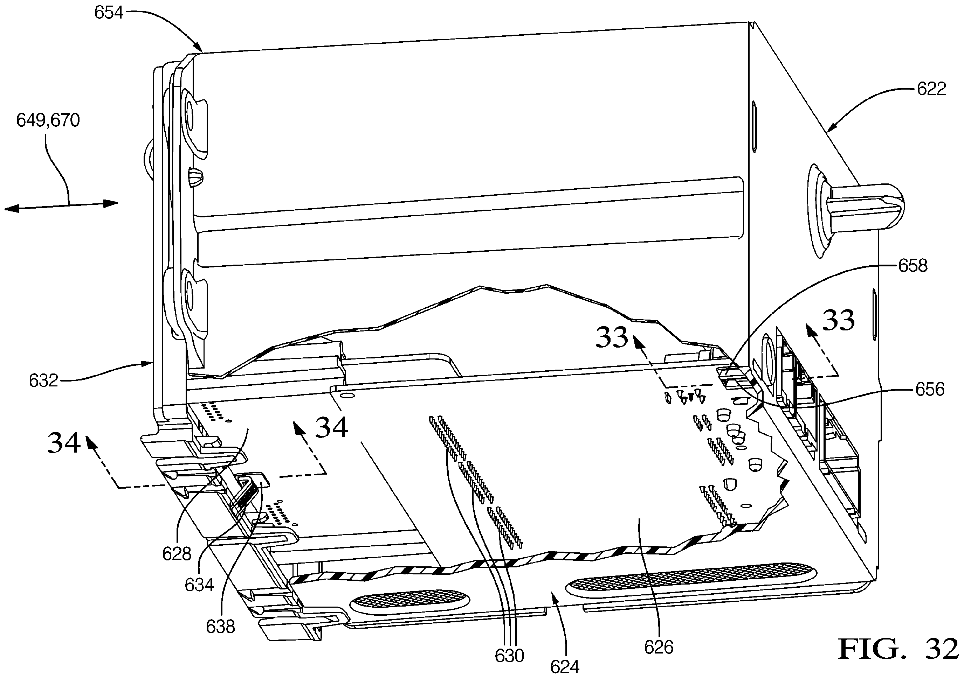

Referring to Figures 32 - 38, alternative forms of grounding the ground plane 216 of the circuit board subassembly 64 to the wire screen are illustrated. Figure 133 illustrates a radio/CD player 622 similar in all material respects to the radio/CD player 62 described hereinabove in connection with Figures 2 - 10 and 15 - 20 inter alia, with the exceptions described immediately hereinbelow. In essence, in this embodiment, the four ground clips 218 contained on the circuit board subassembly 64 are deleted and replaced by connectors integrally formed with the housing assembly 76.

Referring to Figures 32, 34 and 36, a circuit board subassembly 624 includes a common PCB 626 interconnected with a unique PCB 628 by pin connectors 630. A leading edge 631 of the unique PCB 628, when installed within a front plate 632, engages two Z-clips 634 integrally formed within the front plate 632, whereby wire screen 636 exposed in the Z-clip 634 engages a contact pad/plane 638 carried on the unique PCB 628 adjacent its leading edge 631. A trailing edge 652 of the common PCB 626, when installed in a housing case 654, engages two grounding clips 658 integrally formed within the case 654, whereby wire screen 636 exposed in the grounding clip 656 engages a contact pad/plane 658 carried on the common PCB 626 adjacent its trailing edge 652.

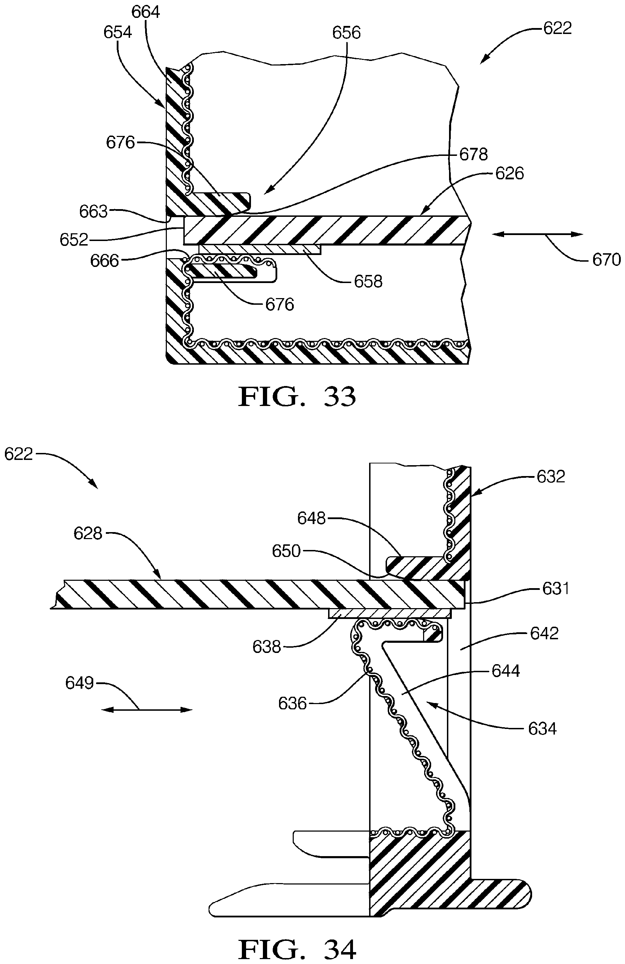

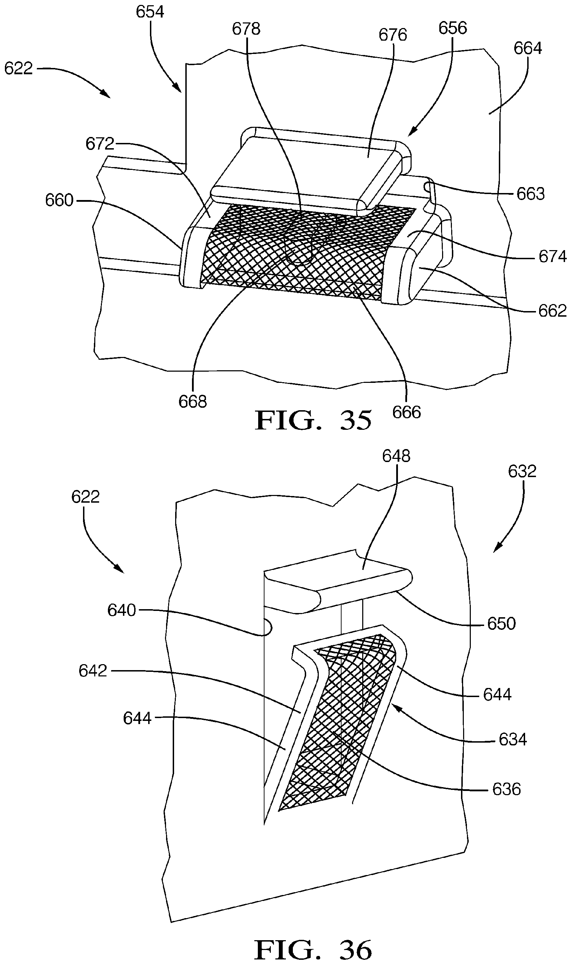

As best viewed in Figures 34 and 36, the Z-clip 634 includes a frame 640 integrally formed adjacent one side of an associated opening 642 and extending inwardly (within an associated housing case 643) therefrom as a resilient cantilever. The frame 640 includes two parallel "L' or "J" shaped leg portions 644 interconnected by a cross support portion 646. A flap of wire screen 636 is die-cut prior to being injection molded within the front plate 632. During the injection molding process, the edges of the wire screen flap are insert molded within the leg portions 644, the cross-support portion 646 and the adjacent front panel of the front plate 632, thereby exposing the wire screen flap 636 for electrical connection with the unique PCB contact pad 638. An inwardly directed boss 648 is integrally formed on the front plate 632 adjacent an edge of the opening 642 opposite from the leg portions 644, and extends substantially parallel to an assembly axis 649. The boss 648 forms a guide/abutment surface 650 which is spaced from the exposed wire screen flap 636 by a dimension slightly less than the thickness of the unique PCB 628 to ensure a tight compressive fit when the leading edge 631 of the unique PCB 628 is inserted therebetween. The natural resiliency of the polymer material forming the Z-clip frame 640 ensures continued continuity of the electrical connection between the exposed wire screen 636 of the Z-clip and the unique PCB contact pad 638.

As best viewed in Figures 33 and 35, the grounding clip 656 includes a cooperating pair of laterally spaced support members 660 and 662 integrally formed in a rear wall portion 664 of the case 654 adjacent the bottom edge of an associated opening 663 and extending inwardly therefrom. A flap of wire screen 666 is die-cut prior to being injection molded within the case 654. During the injection molding process, the lateral edges of the wire screen flap 666 are insert molded within the support members 660 and 662 and the adjacent portion of the case rear wall portion 664, thereby exposing the wire screen flap 666 for electrical connection to the common PCB 626 contact pad 658. A wire screen positioning finger 668 is integrally formed in the rear wall portion 664 of the case 654 laterally intermediate the support members 660 and 662, and extends inwardly from the rear wall portion 664 substantially parallel to an insertion axis 670 as a resilient cantilever. The positioning finger 668 is vertically positioned with respect to the support members 660 and 662 to continuously contact the lower surface of the wire screen flap 666 to ensure that the lateral center portion of the wire screen flap 666 is bowed slightly upwardly and resiliently maintained at least slightly above the upper surface portions 672 and 674 of the support members 660 and 662, respectively. An inwardly directed boss 676 is integrally formed on the rear wall portion 664 of the case 654 adjacent the top edge of the opening 663 opposite from and laterally centered with the support members 660 and 662. The boss 676 forms a guide/abutment surface 678 which is spaced from the exposed wire screen flap 666 by a dimension slightly less than the thickness of the common PCB 636 to ensure a tight compressive fit then the trailing edge 652 of the common PCB 636 is inserted therebetween. The natural resiliency of the polymer material forming the ground clip 656 structural elements ensures continued continuity of the electrical connection between the exposed wire screen 666 of the ground clip 656 and the common PCB contact pad 658.

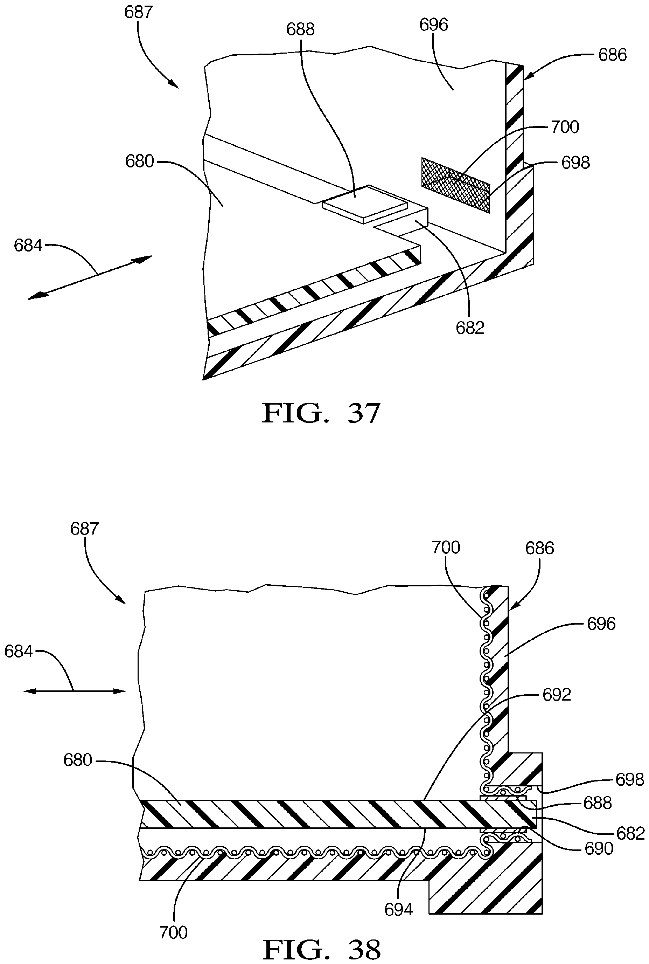

Referring to Figures 37 and 38, another example of self-grounding is illustrated wherein a PCB 680 includes an extension 682 projecting forwardly therefrom in line with an assembly axis 684 of a housing case 686 for an audio system 687. Contact pads 688 and 690 are carried on upper and lower surfaces 692 and 694 of the PCB extension 682. A rear wall portion 696 of the case 686 forms a window 698 exposing a portion of wire screen 700 which is aligned with the PCB extension 682. When the wire screen 700 is insert molded within the polymeric material forming the case 686, the portion thereof coinciding with the window 698 is left intact. During the assembly process of the audio system 687, wherein the PCB is installed by insertion along guideways (not illustrated) within the case 686, the PCB is inserted with sufficient force to locally rupture and penetrate the exposed wire screen 700 within the window 688. Following the rupture of the wire screen 700, the residual separation edges thereof are drawn into the window 698 by friction caused by motion of the upper and lower PCB surfaces 692 and 694, respectively. When the PCB 680 assumes its installed position, as illustrated in Figure 139, the rended portions of the wire screen 700 are compressively fit between the contact pads 688 and 690 and the adjacent edges of the window 698, ensuring continued continuity of the electrical connection between the exposed wire screen 700 and the PCB contact pads 688 and 690. It is contemplated that a single (one side of the PCB) contact pad can also be employed. However, the redundancy afforded by the dual contact pads 688 and 690 is preferable.

A modification of the self-grounding system described in connection with Figures 138 and 139 can enhance assembly of an audio system 702 for simplified and improved unit-to-unit repeatability. A housing case 704 includes a wall portion 706 forming a window 708 exposing a wire screen 710 to establish a point of electrical connection to an audio component within the case 704. After the wire screen 710 is insert molded within the polymer material forming the case 704, but before the assembly if the audio system 702, a tool, such as a cooperating punch 712 and die 714 is pressed simultaneously against the inner and outer surfaces of the exposed screen 710 within the window 708 to form perforations or weakenings, indicated by dotted lines 716. This process step is indicated by arrows 718. The perforations 716 make the exposed wire screen 710 more predictably frangible for improved unit-to-unit quality. Thereafter, during final assembly of the audio system 702, the wire screen 710 separates along the perforations 716 when contacted by the leading edge of a PCB extension 682 (refer Figures 37 and 38).

An alternative self grounding approach involves modifying a leading surface 720 of an extension 722 of a PCB 724 to form a sharpened, laterally extending leading edge 726. The leading edge 726 can be formed by the PCB material itself or, preferably, by hardened material, such as a metal applique or band formed in a "U" or a "V" configuration engaging the PCB 724 by upper and lower members 728 and 730 affixed to the upper and lower surfaces 732 and 734 of the PCB extension 722 such as by soldering. The upper and lower members 730 and 732 can serve as electrical ground pads. Upon installation of the PCB 724, the sharp leading edge 726 first contacts and cleaves the exposed wire screen 710 into the form illustrated in Figure 139.

In addition to the forgoing, punch dies 712/714 such as those depicted in Figure 156 can be employed in modified form to actually sever and/or remove a portion (or all) of the wire screen 710 after the molding of the housing case 704, but before the final assembly of the audio system 702. Furthermore, one or more service access windows can be provided elsewhere in the walls of the housing case 704. The service windows are closed at the time of manufacture by exposed screen including perforations, as depicted in Figure 155. The exposed screen could be severed by a tool or process later in the service life of the audio system 702 to service or modify the system.

### FRONT PLATE ESD GROUNDING TO KEYBOARD THROUGH WIRE MESH

The method of grounding the plastic front plate (with molded in metal mesh) to the keyboard is by using plastic spring clip that contains an open window to expose the mesh where the spring clip comes into contact with a tinned pad on the keyboard. This provides an ESD path to ground when inserting a static charged CD into the CD changer.

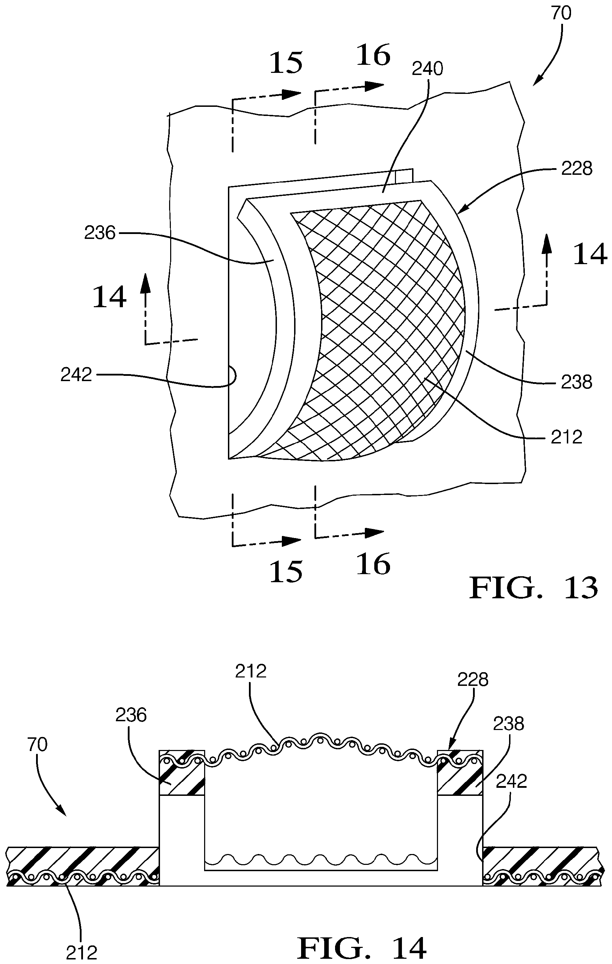

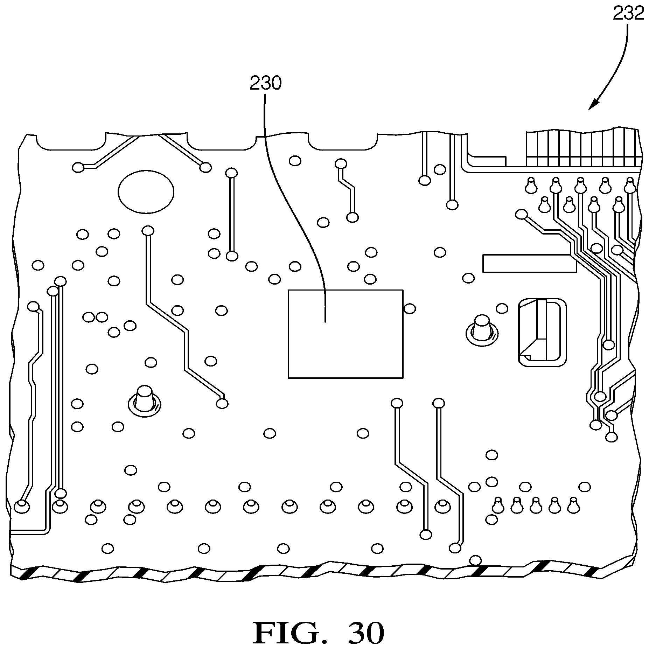

Referring to Figures 13 - 17 and 28 - 30, several spring clip structures 228 are integrally formed in the front plate 70 which, in assembly, continuously resiliently bear locally exposed segments of the wire screen 212 against a tinned grounding pad 230 (only one is illustrated) on a keypad PCB 232 to establish a ground path therebetween.

Each spring clip structure 228 has a frame 234 including two parallel arc shaped portions 236 and 238 and a cross-support portion 240 integrally formed with front plate 70 and extending therefrom as a resilient cantilever. An opening 242 in the front plate registers with each spring clip 228 to permit flexure thereof.

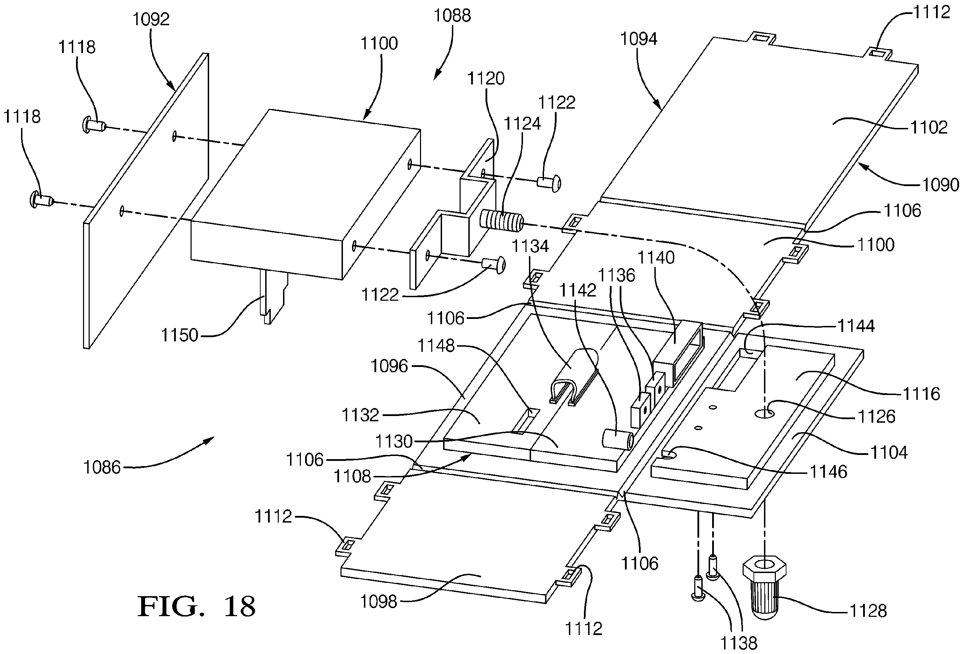

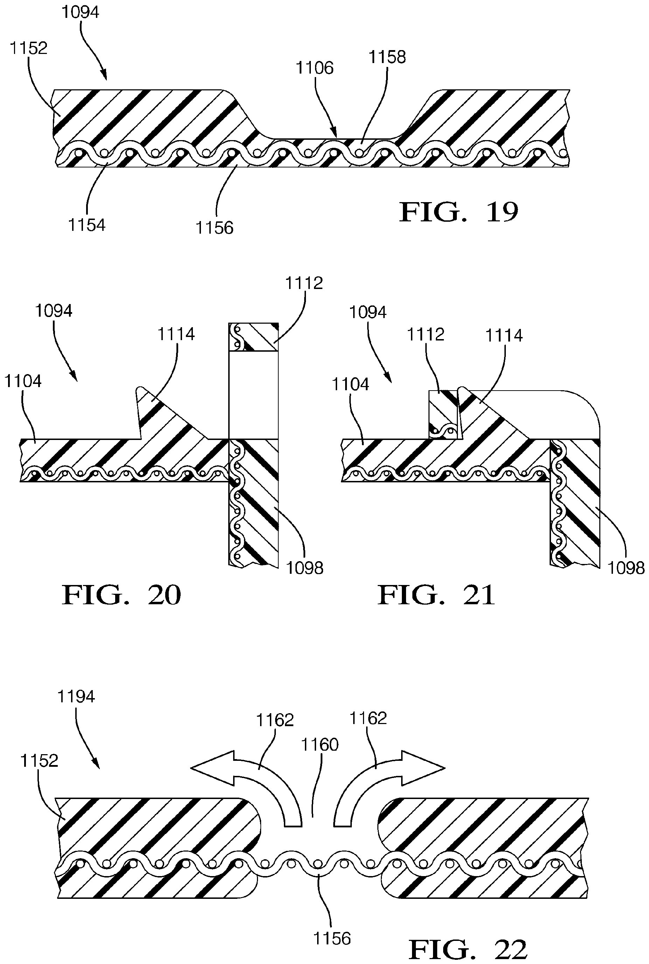

Prior to molding of the wire screen 212 within the front plate 70 the screen preform is die-cut to form an integral flap which is captured within the mold and the edges thereof encased within arc-shaped portions 236 and 238 and cross-support portion 240. The central portion of the exposed wire screen is expanded or stretched to form an outward bow shape (refer Figures 18 and 20) to ensure that the resulting exposed screen protuberance firmly contacts the PCB grounding pad 230.

Referring to Figure 17, a prior approach is illustrated wherein separate spring grounding clips 244 are each mechanically affixed to the front plate 246 of a radio/CD player assembly 248 by a rivet 250 or other suitable fastener. The rivets are required to establish an electrical ground path as well as to mechanically secure the spring clips 244 to the front plate 246, adding labor, cost and complexity to the manufacturing process.

### FRONT PLATE WITH INTEGRAL ASSEMBLY FIXTURING

Using a plastic front plate enables assembly fixturing for the CD mechanism and circuit boards for slide lock and snap lock assembly instead of the screws used in a traditional receiver.

Referring to Figures 4 and 5, guideways in the form of slotted extensions 126 and 128, as well as locator/retention features 144 and 146 integrally formed on the reverse (inside) surface of the front plate 70 provides a number of significant advantages in the manufacture and final assembly of the radio/CD player 62 by reducing product part count, assembly time, and substantially eliminates dedicated hard fixturing and tools to affect assembly.

### THERMAL MANAGEMENT SYSTEM FOR VEHICULAR RADIO APPLICATION

The thermal devices are placed in a window in the plastic box_and are attached to the heat sink, which is attached to the inside of the box. This puts a plastic wall (a good insulator) between the heat sink and the CD mechanism to minimize the temperature that a CD reaches inside the box metal case. The thermal efficiency of this system eliminates the need for a cooling/ventilation fan.

Referring to Figure 159, another simplified alternative embodiment of a fastenerless thermal control system for an audio device 342 is illustrated. The audio device 342 comprises a case 344 formed of thermally insulating material. A PCB 346 is disposed within the case 344 which has a power circuit component 348 cantilever affixed thereto via its lead frame 349 positioned adjacent a thermal port 350. A retainer/backing clip 352 is snap-engaged with a feature 353 on the exterior of the case 344 and includes a resilient integral support member 354 extending through the port 350 and continuously resiliently urging the power circuit component 350 toward the port 350. A heat sink 356 snap-engages with features on the case 344 and backing clip 352 to retain it in its illustrated position wherein the power circuit component 348 is maintained in intimate contact with the inner surface of a recessed portion 358 of the heat sink 356 extending through the port 350.

Convection air flow (arrows 359) can be provided by providing inlet and outlet windows 360 and 262 in the case 344. A pocket 364 formed on the outer surface of the heat sink 356 as part of the recessed portion 358 can be filled with a thermally conductive material 366 to increase the effective thermal mass of the heat sink 356 and to improve radiant thermal rejection as indicated by arrows 368.

### LOW COST STRUCTURAL SUPPORT FOR CD CHANGER FOR VEHICULAR RADIO APPLICATION

Using a plastic box for the receiver enables low cost location and support for the CD mechanism and enables for slide lock assembly instead of the screws used in a traditional receiver. The brackets on the CD mechanism have a 1° taper that matches a 1° taper on the support shelf in the plastic box. This makes it easy for an operator to start the slide, but all of the clearances go to zero as the box snaps into place providing a strong rattle free assembly without the use of the traditional screws.

### WIRE MESH FOR STRUCTURAL COMPONENT

Molding in metal mesh into the plastic receiver case and front plate increases the strength of the material (much like putting re-bar into_concrete) while still weighing less than a steel case. The gauge of the wire forming the mesh can be increased and the amount of plastic material can be substantially reduced, resulting in a very thin wall, robust structure.

As an alternative, the plastic can be eliminated from the center portions of some or all of the individual side, front, back, top and/or bottom panel portions of the case and front plate. This configuration would have the appearance of a screen box, with a molded plastic peripheral frame circumscribing each panel portion.

A lightweight automotive audio system 471 can include a housing case 472 constructed of a composite of polymer based material with a wire screen 474 insert molded therein to isolate audio components therein from various electrical anomalies. To further reduce overall weight, the gauge of the wire screen can be increased whereby the screen contributes a significant component of the resulting overall structural strength of the case, while the nominal section or thickness of the polymer material can be substantially reduced. By way of example, the case 472 top and bottom wall portions 476 and 478, respectively, and left and right side wall portions 480 and 482, respectively, injection molded into a single unified structure, with the enlarged gauge wire screen 474 insert molded adjacent the inner surfaces thereof. Edges and corners of the case 472 formed at the intersection of two or three adjacent wall portions can be locally thickened to increase structural rigidity of the case 472 as well as to provide internal and external mounting and interface ports. The intersecting edges of the top wall portion 476 and the left and right side wall portions 480 and 482, respectively, form thickened left and right upper edge frames 484 and 486, respectively. Likewise, the intersecting edges of the bottom wall portion 478 and the left and right side wall portions 480 and 482, respectively, form thickened left and right lower edge frames. Lower edge frames 488 and 490 are locally vertically extended openings 492 and 494 for exposing the wire screen 474 to establish electrical contact with contact clips 496 and 498 carried by PCBs 500 and 502, respectively, interconnected by pin connectors 504 within the case 472.

### SLIDE-LOCK SNAP-LOCK SCREWLESS ASSEMBLY METHOD

Using plastic for a receiver case enables low cost assembly of the components. The circuit boards and the CD mechanism can slide into place and then be locked or they can be snapped into place without screws. This reduces the number of parts required in the assembly and reduces the amount of direct and indirect labor to put a receiver together. The plastic case can be easily molded into a net shape forming the slides and snaps needed for assembly.

Referring to Figures 2 - 10, the apparatus and assembly method described substantially reduces the labor and component cost of the radio/CD player 62, as well as the required capital costs. Furthermore, it substantially enhances product quality by substantially eliminating the possibility of extraneous or missing (small) parts and/or improper assembly.

### EMC, RFI, BCI, ESD WIRE MESH PROTECTION SYSTEM

Using the molded in metal mesh in the receiver plastic box that is grounded to the circuit boards creates a Faraday cage that provides shielding protection for RFI (Radio Frequency Interference), EMI (Electro Magnetic Interference), BCI (Bulk Current Injection), and ESD (Electrostatic Discharge).

Refer to Figure 12 and their associated descriptions

### PARTITIONED MAIN BOARD INTO COMMON AND UNIQUE

Using the principle of communization and modularity, the receiver main board has been divided into a common board and a unique board. This is counterintuitive because a single board is less expensive than two boards performing the same function. However, the common board contains all surface mount components (no stick lead or wave solder) and very large volumes can be produced without reconfiguring the assembly/production line. This will substantially reduce the manufacturing cost of this portion of the main board.

Referring to Figure 11, automotive audio systems are unique in that they are typically designed in modular form and, in response to the requirements of individual customers, are produced by assembling individual units from varied combinations and permutations of modularized subcomponents. This, however, can be contrary to the manufacturing doctrine of large enterprises wherein large volume production of common designs is preferred for its inherent efficiencies. In the practice of the present invention, the individual electrical components to be assembled on the circuit board subassembly 64 are segregated into those which will be employed in each specie and sub-specie in a given product family. The commonly employed circuit elements (typically surface mount devices) are assembled on the "common" PCB 98. The application specific circuit elements (typically "stick" mount devices) are assembled on the "unique" PCB 100. The common PCB 98 is assembled employing highly automated manufacturing techniques for maximum efficiency, while the unique PCB 100 are assembled employing a different mix of labor and automation to maximize overall efficiency. Standard connector assemblies 736, 738 and 740 are provided on the common PCB 98 for interfacing the radio/CD player 62 with speakers, ground, power and associated control/readout systems via wire harnesses. A standard coaxial cable connector 742 is also provided on the common PCB 98 for interfacing with a vehicle antenna system.

An audio product manual entitled "2004 Model Year Ford Freestar Radios" (Document Number 04-RDPD-12-MA-F), dated 7 October 2005, describes in detail the circuit architecture of a family of modern automotive audio systems developed and produced by the assignee of this application. In addition, the manual enumerates the individual electrical components employed and their arrangement in various audio subsystems. In the practice of the present invention, the listed individual electrical components would be segregated into the common PCB 98 and unique PCB 100 in keeping with the teachings herein. Accordingly, the above referenced audio product manual is incorporated herein by reference for the sake of completeness and to serve as a resource in understanding and practicing the present invention.

### GUILLOTINE HEAT SINK

The guillotine heat sink uses a flat aluminum plate as a heat sink. It slides down a slot on each side of the plastic box until it comes to rest on the quad bridge amplifier (QBA) IC and the power supply IC. Each IC will have a silpad on top to provide compliance and facilitate heat transfer. A downward force will be applied to the heat sink through a molded leaf spring in the lid of the plastic bob when it is snapped into place. An additional feature of the plastic box is to provide pillars under the FR-4 board in the location of the power ICs to provide a backstop for the leaf spring force.

### SCREWLESS POWER CLIP

The screwless power clip is an extension of a clip that Grundig uses in automotive radios produced in Europe today. The Grundig clip uses a long lever arm that must be snapped after the PCB is assembled into the metal wrap around. This requires an operator to reach in with a tool and snap (distend and release) the clip.

In the present electronic circuit enclosure assembly, the long lever arm is eliminated. The present electronic circuit enclosure assembly uses the assembly action of hooking the bottom of the heat sink into plastic stirrups and rotating the top of the heat sink until it snaps at the top of the plastic box to provide the lever action. This assembly technique can be accomplished by an operator without the use of expensive or specialized tools.

An additional approach to this idea is to eliminate the clip altogether and to employ a spring material as part of the lead frame.

### FOLD-UP CASE

In this mechanical configuration, the case starts out as a flat set of plastic sides with molded in metal mesh to act as the hinges for folding the case into a three-dimensional structure. This approach allows for bottom-up assembly that starts by snapping the board to molded features in the bottom plate. The heat sink is snapped to features in the back plate and the CD mechanism is attached to the front plate with two screws. The box is then folded up and snapped together.

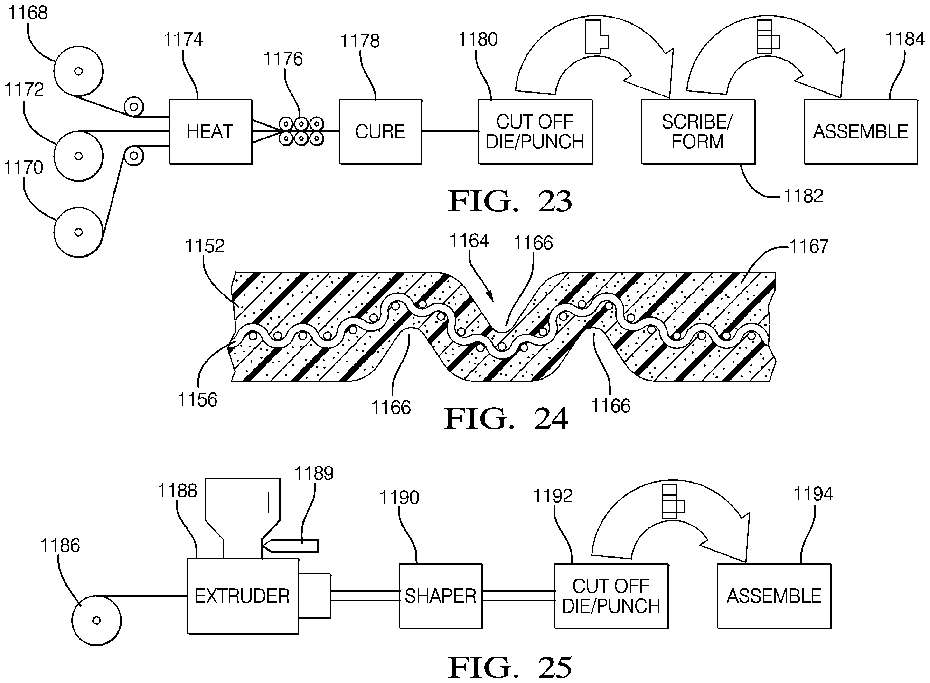

The common edges of adjacent case panels define living hinges extending partially or entirely along the length thereof. The living hinge can consist of wire mesh only, where there is a gap in the plastic material, as illustrated in Figure 22. Alternatively, the living hinge can comprise a thin web of plastic only, wherein the wire mesh has been interrupted. In another embodiment, the plastic-wire mesh composite can be molded to define a thin web as the living hinge, as illustrated in Figure 17. In another embodiment, the plastic-wire mesh composite can be crushed or deformed to define the living hinge, as illustrated in Figure 24. Finally, a portion of the plastic and/or wire mesh can be scribed or machined away to expose the wire mesh to define the living hinge. If the case material is thin enough at the hinge point, the hinge can be segmented, rather than continuous.

Referring to Figures 18 - 25, several variants of a housing assembly 1086 for an automotive audio system 1088 are illustrated. This version of the audio system 1088 is configured to be hand assembled and is nearly fastener-less. The fasteners which are employed are extremely elemental and require only the most rudimentary of hand tools to affect assembly. In essence, the audio system housing assembly 1086 comprises a case portion 1090 and a closure member or front plate 1092. The case 1090 is presented to the assembler in an unfolded, two-dimensional arrangement whereby he/she can easily complete the final assembly process on a table top, eliminating complex and expensive tooling fixtures and multiple work stations.

The case portion 1090 is initially created as a sheet-like preform 1094 consisting of a number of flat panels interconnected along their adjacent edges. As best viewed in Figure 18, the preform 1094 defines five distinct panels, which will constitute a bottom or lower wall portion 1096, a right side wall portion 1098, a left side wall portion 1100, a top or upper wall portion 1102 and a rear wall portion 1104. The adjacent panels are commonly joined or integrally interconnected by living hinges 1106, enabling the panels to be repositioned normally to one another to form a three-dimensional box-like case 1090.

The preform 1094 can be die cut from a continuous sheet of source material or, alternatively, injection molded in a net shape as illustrated in Figure 18. In either case, the material employed to make the preform is a composite of at least one layer of relatively rigid polymer based material and at least one layer of electrically conductive material capable of shielding audio components, such as a radio receiver circuit 1108 or a CD player subassembly 1110 from electrical anomalies such as radio frequency interference (RFI), electromagnetic interference (EMI), bulk current injection (BCI), and electrostatic discharge (ESD). Cooperating engagement features such as tabs 1112 and catches 1114 are affixed to or integrally formed with the preform 1094. Refer Figures 20 and 21. By way of example, after installation of the internal subcomponents, the case preform is folded to assume its ultimate box-like configuration. This places cooperating associated pairs of tabs 1112 and catches 1114 in an assembly orientation with the tab 1112 carried on the edge of one panel (the right side wall portion 1098, for example) and the catch 1114 carried adjacent the edge of a now adjoining panel (the rear wall portion 1104, for example). Final structural fixation of the preform 1094 in the form of the housing case 1086 is completed by simply snap-engaging the tab 1112 with the catch 1114 from the configuration of Figure 20 to the configuration of Figure 21. After all of the tab 1112/catch 1114 pairs are interconnected, the formation of the case 1090 is complete.

Prior to folding up the case 1090, the radio receiver circuit 1108 is positioned and affixed to the exposed surface of the lower wall portion 1096. A heat sink 1116 is similarly positioned and affixed to the exposed surface of the rear wall portion 1104. The positioning and attachment of the internal components can be accomplished by features integrally formed in the formation of the preform 1094 (such as snaps, locating guides and the like), adhesives, discrete attachment and guide elements or inter-engagement with the various wall portions and other assembly elements within the case 1090.

After formation of the case 1090, the CD player subassembly 1110 can be pre-assembled with the closure member 1092 via screws 1118 or other interconnecting features described herein. A rear bracket 1124 secured to the back side of the CD player subassembly 1110 by screws 1122 includes a rearwardly extending threaded post 1124 which, upon final assembly extends through registering passageways 1126 in the heat sink 1116 and rear wall portion 1104 and engages a mounting bushing 1128. This arrangement provides an extremely robust overall structure to the overall audio system.

The electrical components comprising the radio receiver circuit 1108 are arranged on a "common" component PCB 1130 and a "unique" PCB 1132. The common and unique PCBs 1130 and 1132 are electrically interconnected by a ribbon connector 1134. The heat generating electrical components 1136 are arranged on the common PCB 1130 and are affixed to the heat sink 1116 by screws 1138 or other suitable means, to enhance thermal coupling therebetween. Electrical connectors 1140 and 1142 are also arranged on the common PCB 1132 in register with port openings 1144 and 1146 in the rear wall portion 1104 of the case 1090. A vertically opening electrical socket 1148 is centrally disposed in the unique PCB 1132 to receive a rigid connector 1150 extending downwardly from the CD player subassembly 1110. This arrangement electrically interconnects the two audio components as well as provides structural support thereof.

One embodiment of the composite material employed for the housing assembly 1086 consists of a layer of elastomeric material 1152 with a continuous wire screen 1154 insert molder therein adjacent an interior wall surface 1156 of the composite structure. Referring to Figure 19, the living hinges can be formed by an extremely locally thin (or non-existant) layer 1158 of polymeric material and the wire screen 1156.

Referring to Figure 22, air vents 1160 can be provided in the case 1090 by locally eliminating the polymeric material layer 1152 while maintaining the continuity of the wire screen 1156 to permit airflow, as indicated by arrows 1162, therethrough.

Referring to Figure 24, an alternative living hinge 1164 can be formed post-production of the composite material by pressing alternating undulations 1166 therein along the axis of the intended living hinge 1164.

Referring to Figure 23, a first process for producing composite material is illustrated, including drawing polymeric sheet material off upper and lower continuous rolls 1168 and 1180 to enclose an intermediate layer of wire screen from a third roll 1172. The three discrete sheets are heated at station 1174, rolled together at station 1176, cured at station 1178, cut-off or die cut to form performs at station 1180, scribed, punched treated and/or formed at a station 1182, and, finally, assembled at a workstation 1184.

Referring to Figure 23, a second, alternative process for producing composite material is illustrated drawing a continuous sheet of wire screen off a roll 1186 and drawing it through a continuous extruder/molder 1188 to form the composite structure. Thereafter, the composite sheet is shaped at station 1190, cut off and/or punched at a station 1192, and, finally, assembled at a work station 1194.

Assembly of the audio system 1088 is completed by affixation of a trim plate subassembly (not illustrated) such as the device described in connection with Figures 2 - 10 hereinabove.

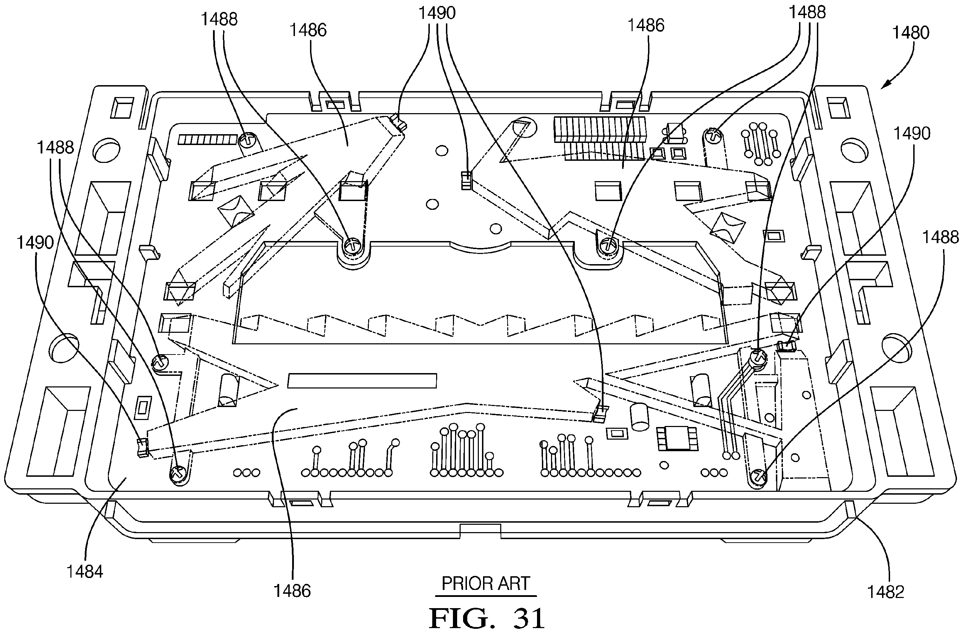

Referring to Figure 31, a known trim plate assembly 1480 is illustrated to highlight the substantial complexity, high part count, and design shortcomings resulting from providing back-illumination using traditional design and assembly techniques. The trim plate assembly 1480 includes a black plastic front panel 1482 (with operator controls and displays affixed on the opposed side), a printed circuit board (PCB) 1484 mounted on the exposed face of the front panel 1482, three separate and discrete lightpipes 1486 mounted on the exposed face of the PCB 1484 by eight fastening screws 1488 and five light emitting diodes (LEDs) 1490 carried on the PCB 1484.

### SQUIRTS

To further the innovative construction of the present invention, "squirts" or screwless retention features are employed. Restated, squirts are a drawn feature from a structural element, or a styled protrusion at the interface of two structural elements. Although applicable broadly, squirts are principally applied in the preferred embodiment of the invention to secure the CD player subassembly to the left and right CD player guide brackets. This allows the elimination of six additional screws.

A squirt is a retention feature which is integrally formed in a typically planer region of a structural member, such as a CD player guide bracket, which extends above one surface thereof and, during assembly, self-engages within an opening formed in an adjacent structural element, such as a hole in the outer case of the CD player subassembly. Squirts permit assembly of the guide brackets to the CD player assembly by hand without the need for special fixtures and power tools.

The squirts are formed from stock material during formation of the brackets themselves and do not add significant cost to the finalized bracket component. Similarly, mating holes can be easily punch formed in the adjacent case panels of the CD player subassembly.

In addition to reduced cost and ease of assembly, the squirt self-aligns the respective components during the attachment process, thereby ensuring their precise juxtaposition. Furthermore, the squirt is permissive of lower tolerances in the forming and assembly of its associated elements. In fact, the presence of slightly misshapen features or metal flash resulting from low tolerance punching operations can actually result in enhanced retention performance.

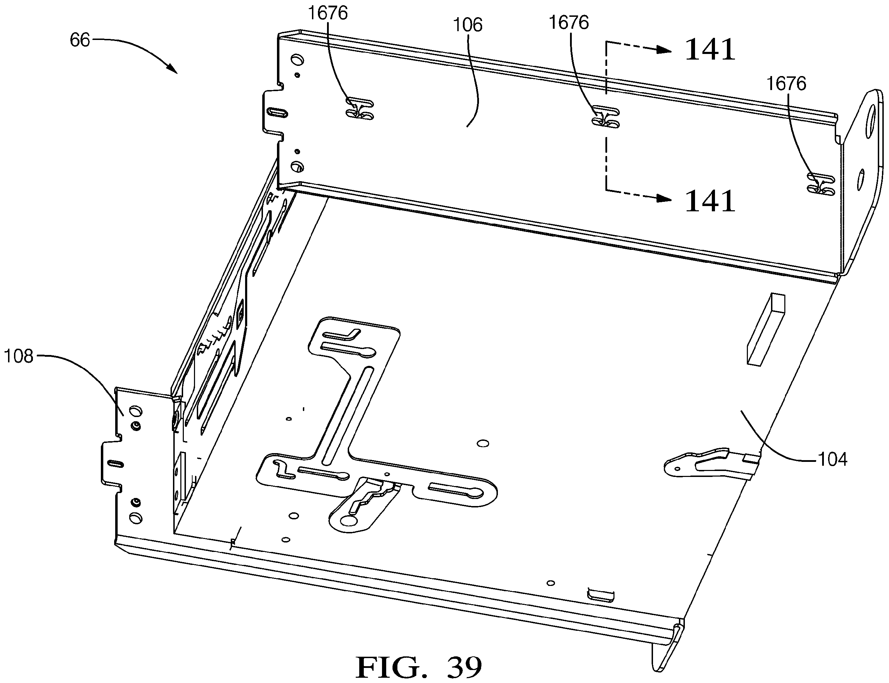

Referring to Figures 39 - 42, the application of "squirts" 1676 to affix the left and right side mounting brackets, 106 and 108, respectively to the multi-disc CD player unit 104 to form the CD player subassembly 66, is illustrated. The squirts are preferable die-punch formed simultaneously with the formation of the mounting brackets 106/108 themselves. It is noted that the brackets 106/108 can be configured symmetrically, whereby one design can be used for both sides of the CD player unit 104, thereby further reducing the overall part count. The squirts 1676 are preferably formed on relatively regions 1678 of their associated bracket 106/108. A single through passage 1680 if formed in the planer region 1678. Two or more substantially symmetrical forms 1682 extend radially inwardly from the edge of the through passage 1680. Each form 1682 has a neck region 1684 and a tapered region or sector 1686. The tapered region 1686 is supported as a cantilever by the neck region 1684. The tapered regions 1686 collectively co-act to define (in the case of two forms) a bisected frustoconical form, wherein each tapered region 1686 defines an outside peripheral surface 1688 which are acutely converging upon an axis normal to the planer region 1678. The taper of an imaginary cone 1700 extended from surfaces 1688 is designated by the angle ω. As illustrated by alternative phantom depictions, the overall shape of the imaginary cone 1700 can be parabolic or hyperbolic. The outer peripheral surface 1688 of each tapered region or sector 1686 has a circumferential range designated by the angle θ, which with two forms is preferably in the range of 90° - 120°.

In application, the collective outer peripheral surface of the sectors 1686 engage a surface forming the outer diameter of a recess or through hole 1702 in an adjacent structure 104 to which the bracket 106/108 is to be attached. As illustrated in Figure 40, the maximum diameter edge surface 1704 sectors 1686 effect line contact to maximize pull-out performance.

Referring to Figure 42, localized radially outwardly projecting knurls, ridges or extensions 1706 to provide point contacts with the adjacent structures.

Attachment of the squirt 1676 to an adjacent structures is affected simply by aligning the sector 1686 with the through hole 1702 and pressing inwardly, as indicated by the phantom finger tip and resultant force arrow 1708.

In essence, the present invention uses a multi-sided fold-up polymer based case or "preform blank", for the chassis of the radio assembly that is molded in a relatively flat state. During the assembly of the radio, the preform blank is folded into the resultant three dimensional case shape. The sections or wall portions (top, back, bottom and front) of the case are interconnected by a hinge style detail that allows the folding to occur with a snap feature to help secure the sections after folding into the three-dimensional assembly. The shielding and/or grounding may be achieved through using an insert molded wire mesh or a post molding plating process like vacuum metal deposition, as an example. The hinge portion may consist of only wire mesh, or a combination of polymer and wire mesh depending on the polymer capability. If a vacuum metal deposition process is used instead of mesh, the hinge will require special design features outside of the hinge to enable an EMC shield to overcome any potential micro-cracking that may occur in the deposited metal from the fold-up assembly at the hinge point when the walls of the fold-up are in the final assembled position. The shield will be enabled after the detail is in the resultant folded-up shape.

The case has the capability for molded-in details to enhance the assembly with mounting features and snap retention details. Also, this allows for pliable ground details that can interface with the circuit board ground pad areas. The structure of the chassis is provided using two aluminum extrusions on the opposing sides of the radio case. One or both of the extrusions may be used for heat dissipation of the power devices on the circuit board assembly. In the event of a playback mechanism like a CD player is used, the front bracket typically used to secure the mechanism in the audio assembly will also provide the vehicle mounting of the audio assembly. Unlike metal chassis radio assemblies that may use a bottom-up assembly, this approach allows the back wall to be folded up and into place to provide the back of the mechanism stability by driving screws through the wall section into the mechanism. This eliminates an extra metal bracket for securing the CD player often used with other approaches.

The extrusions are assembled to the multi-sided fold-up by loading the extrusions into a molded detail at the back of the case and pivoting the extrusion along molded rails at the top and bottom of the sides to enable an interference fit to the molded rails with the front of the extrusions deflecting molded-in snaps on the front section to reach the final seated position. In this manner, the extrusions act both as a component (side wall) and as their own assembly tool.

The molded multi-sided fold-up polymer based case allows for assembly details as described but offers the advantage of being processed through a less expensive tooling option than a molded box-like case with a frontplate as described in connection with Figure 3. The fold-up approach tooling does not require side coring and after molding the relatively flat nature of the part enables easier shipping and storage if needed. In the event an insert molded wire mesh is used, the mesh also does not require forming and can simply be cut and loaded, reducing the expenditure for the wire mesh form processing equipment.

The grounding details in the fold-up approach are better suited for interface to the circuit board than the box-style case in that they can be designed to compress against the ground pads and the folding sections can also be enabled with details locally to secure the ground points from the prior section part during the assembly as opposed to trying to provide a slide clearance and not hinder the assembly.

The design detail that enables both flexibility and minimized cost over the box-like case and front plate assembly is that the molding for the fold-up portion is one tool and the extrusions can be the same part reused on each side of the radio case. A part molded in a relatively flat state is both economical for part transportation and storage. The structure for the chassis uses a process based on the incremental strength leveraged from assembling each component part to finalize the structure as a container for the playback mechanism and circuit boards. The interface between the extruded aluminum sides and the molded fold-up offers an interference fit on molded details to help stabilize the structure of the final assembly. This is unique in that typically the extrusion may only be a heat sink for the power devices from the circuit board. This invention enables the extrusion to provide a structural and shielding component in addition to the heat flow function.

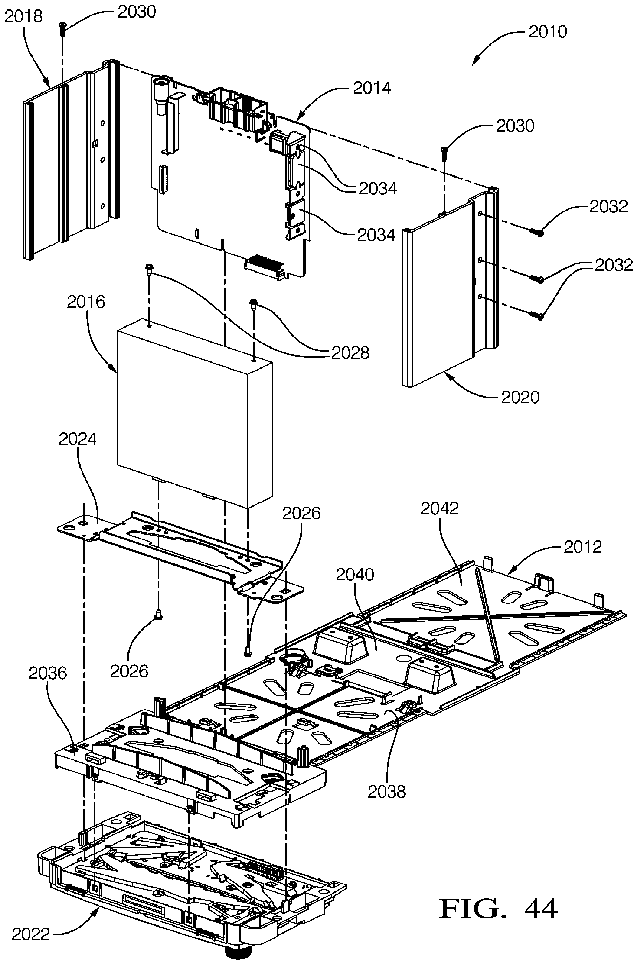

Referring to Figure 44 - 54, a consolidated radio/CD player apparatus 2010 embodying many aspects of an electronic circuit enclosure assembly is illustrated. The radio/CD player 2010 is an assemblage of six major components or subassemblies, a generally planer, composite preform blank 2012, a circuit board subassembly 2014, a CD player subassembly 2016, a left side closure member 2018, a right side closure member 2020 and a trim plate subassembly 2022. Additionally, an adaptor or mounting bracket 2024 is pre-attached to the CD player assembly 2016 by screws 2026. As will be described in greater detail hereinbelow, rear wall mounting screws 2028 are affixed to the CD player 2016, rear panel reinforcement screws 2030 are affixed to the rear edges of the left and right side closure members 2018 and 2020, respectively, and screws 2032 affix the right side closure member 2030 to three power devices 2032 mounted on the circuit board subassembly 2014.

It is envisioned that each of the major components/subassemblies would be produced "off-line" and the final assembly process would comprise the efficient, high volume joining of the major components/subassemblies and end-of-line testing of the completed units.

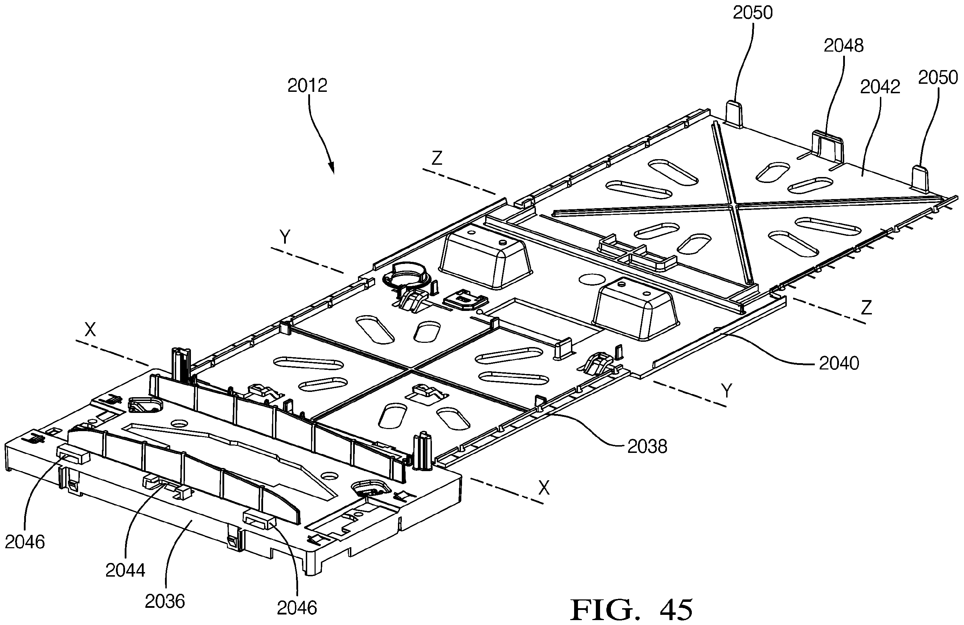

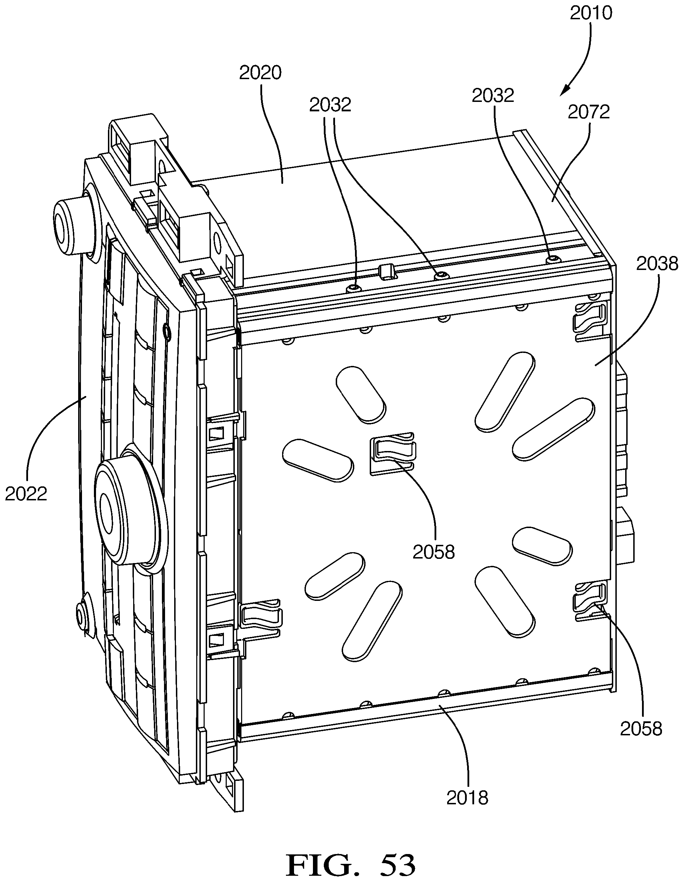

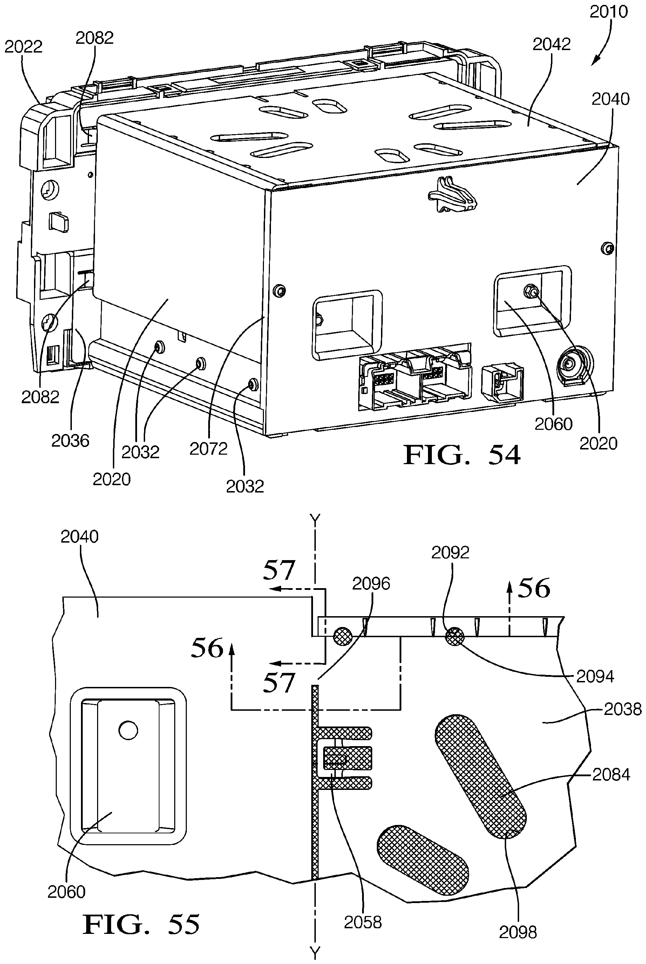

Figures 53 and 54 depict perspective views of the fully assembled radio/CD player apparatus 2010. Figure 44 is an exploded view illustrating the juxtaposition of the respective major components during the assembly process. Figures 45 - 53 depict specific assembly steps of the major components as will be described hereinbelow.

As best seen in Figure 45, the preform blank 2012 is preferably injection molded of polymer based material in a generally planer configuration and, when finally assembled, forms a box-like, three dimensional case. The blank 2012 defines a front wall portion 2036, a bottom wall portion 2038, a rear wall portion 2040 and a top wall portion 2042 respectively integrally interconnected by "living hinges" extending along axes designated as X - X, Y - Y and Z - Z, respectively. All of the blank wall portions are integrally formed in a single injection molding process and comprises a composite of a pre-shaped planer piece of wire screen wire insert molded within a layer of relatively rigid polymer material such as glass filled polypropylene. Each of the wall portions is deemed to have a leading edge, a trailing edge and an opposed pair of side edges.

The front wall portion 2036 has a female engagement feature 2044 and a pair of female guide features 2046 integrally formed adjacent the leading edge thereof. Similarly, the top wall portion 2042 has a male engagement feature 2048 and a pair of male guide features 2050 integrally formed adjacent the trailing edge thereof. The trailing edge of the front wall portion 2036 is interconnected with the leading edge of the bottom wall portion 2038 along hinge line X - X. The trailing edge of the bottom wall portion 2038 is interconnected with the leading edge of the rear wall portion 2040 along hinge line Y - Y. The trailing edge of the rear wall portion 2040 is interconnected with the leading edge of the top wall portion 2042 along hinge line Z - Z.

The circuit board subassembly 2014, CD player subassembly 2016 and trim plate subassembly 2024 are substantially similar to the corresponding major components described hereinabove in connection with the embodiment of Figure 3. For the sake of brevity, the details thereof will not be repeated here.

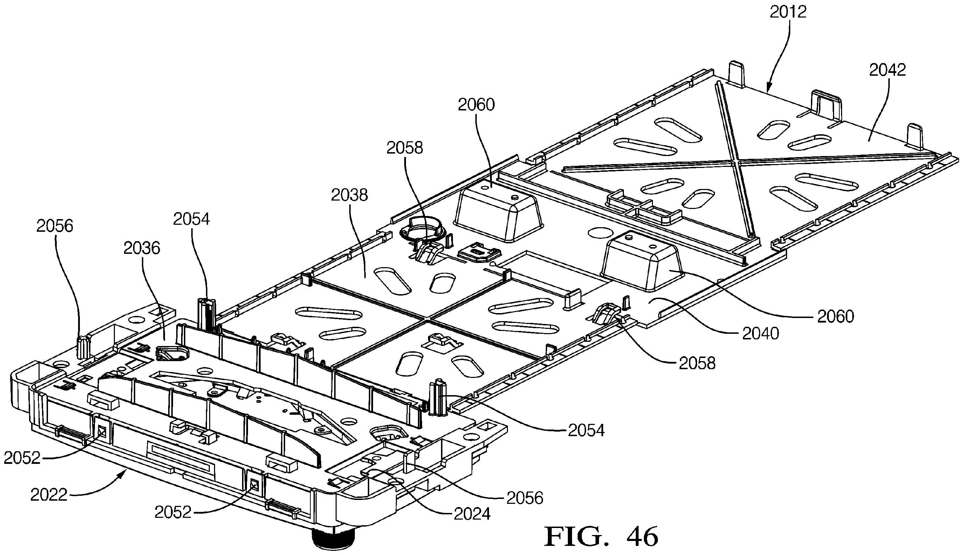

Referring particularly to Figures 46 - 53, a method of assembly of the lightweight audio system 2010 is illustrated. Audio system 2010 can be assembled manually by an ordered process wherein a single (preferably, but not limited to) operator, who sequentially assembles the six major components or subassemblies on a designated work surface. No specialized tools or separate/dedicated fixtures are required. No threaded fasteners/screws are required. Each or the major components and subassemblies form integral features which cooperate to interact with features of the other components and subassemblies to register, align and guide the components and subassemblies during adjoining thereof as well as to removably affix the components and subassemblies to one another when in their final design position. This process is referred to herein as the Slide-lock Snap-lock™ Screwless Assembly Technology and Method or "SLAT". In effect, the components "self-fixture" one another in combination. The assembly of the radio/CD player 2010 is effected by the assembly technician or operator taking the following steps:
Referring to Figure 46, the trim plate subassembly 2022 can be affixed to the outer (bottom as depicted) surface of the front wall portion 2036 by self-aligning, self-engaging engagement features 2052. Thus configured, the illustrated subassembly defines rearwardly (upwardly) directed extension pairs 2054 and 2056 integrally formed on the inner surface of the front wall portion 2036 and trim plate subassembly 2022, respectively. The inner surface of the bottom wall portion 2038 defines four integrally formed grounding clips 2058 and two pedestals 2060 extending upwardly.

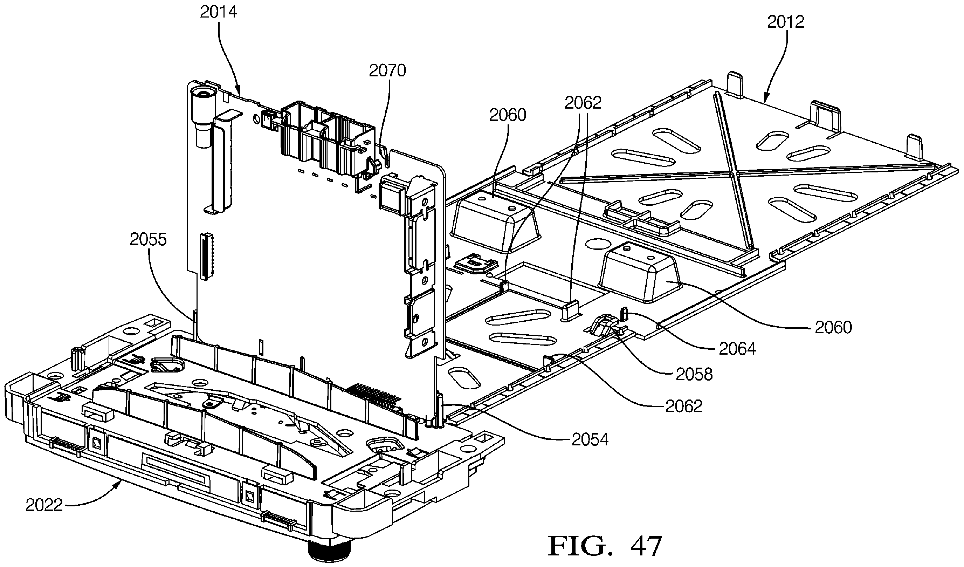

Referring to Figure 47, the circuit board subassembly 2014 is inserted downwardly to self-align, self-position and self-engage with guideways formed by the extensions 2054. Insodoing, the electrical circuitry contained on the circuit board subassembly 2014 is electrically interconnected with the circuitry on the trimplate subassembly 2022, as well as the other components via registering interconnects and plugs (not illustrated).

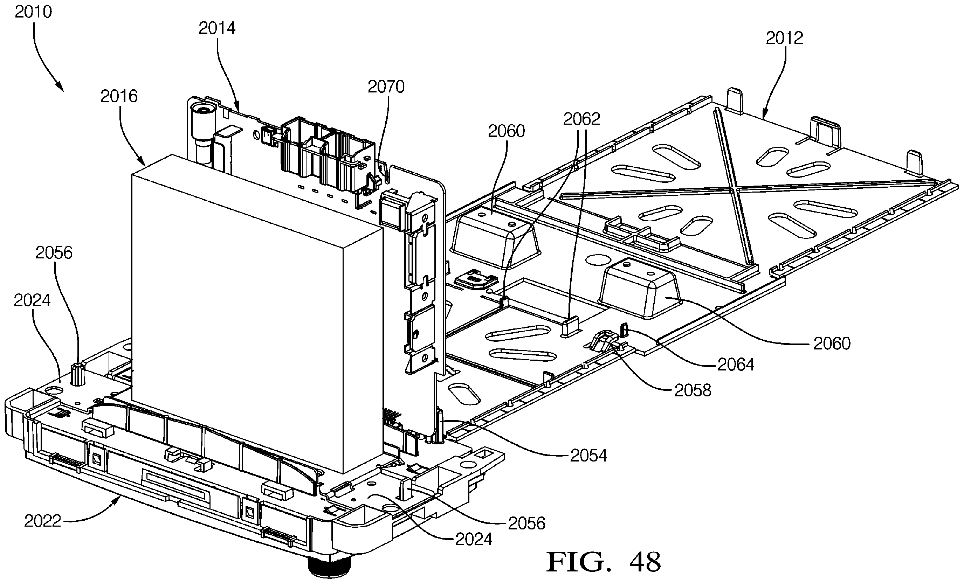

Referring to Figure 48, the CD player subassembly 2016 is inserted downwardly to self-align, self-position and self-engage with locating pins formed by the extensions 2056. Typically, an electrical umbilical (not illustrated) interconnects the CD player subassembly 2016 and the circuit board subassembly 2014.

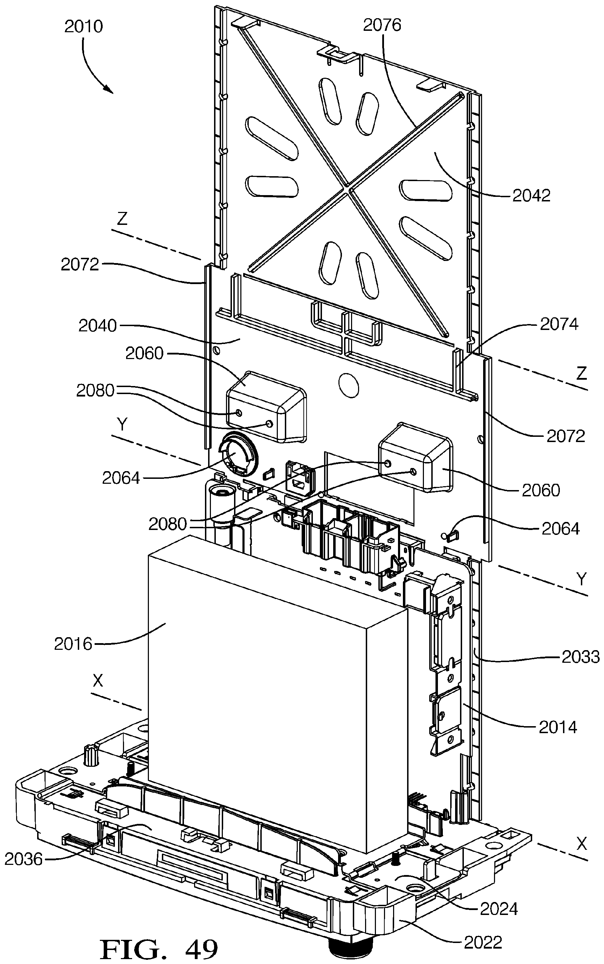

Referring to Figures 49 - 51, the preform blank 2012 is then folded, transitioning it from its original generally planer configuration to a three dimensional box-like configuration. Referring to Figure 49, the first step of folding the preform blank entails manually or mechanically rotating bottom wall portion 2038 substantially 90° about axis X - X from its original horizontal orientation illustrated in Figure 48 co-planer with the front wall portion 2036 to a vertical orientation substantially perpendicular or normal with front wall portion 2036. Note that in this step, rear wall portion 2040 and top wall portion 2042remain co-planer with bottom wall portion 2038, assuming a vertical orientation.

As best viewed in Figure 47, the inner surface of the bottom wall portion 2038 has integrally formed inwardly directed guide retainer features 2062 which, in combination with the grounding clips 2058, function to position, secure and electrically ground the circuit board subassembly 2014 upon final assembly of the radio/CD player apparatus 2010. The guide retainer features 2062 positionally secure the circuit board subassembly 2014 by engaging side edges and slots 2070 formed therein.

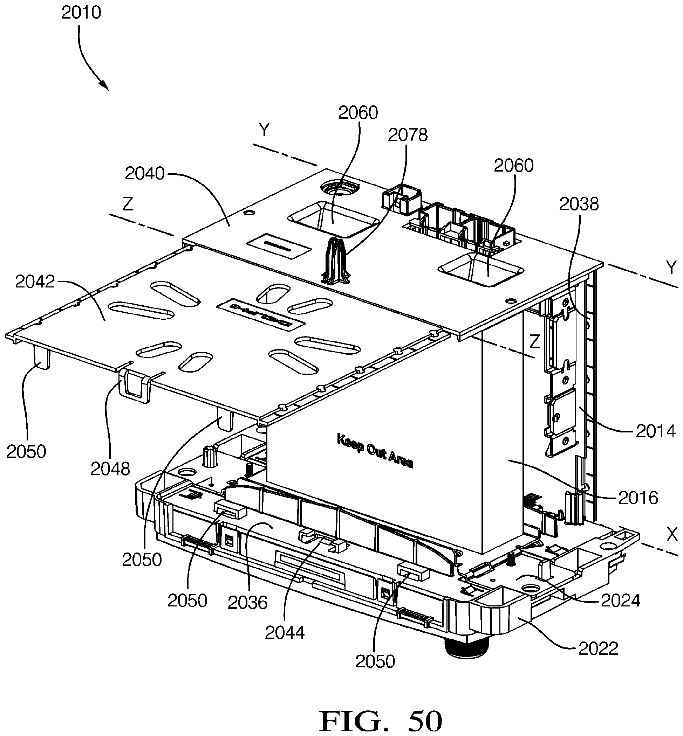

Inwardly directed, laterally opposed edge retention ribs 2072 are integrally formed on the inner surface of the rear wall portion 2040. Furthermore, integral reinforcing ribs 2074 extend from the inner surface of the rear wall portion 2040 to secure a rear integral mounting stud 2078 extending from the outer surface of the rear wall portion 2040. See Figure 50. Similarly, the inner surface of the top wall portion 2042 has X-shaped reinforcement ribs 2076 integrally formed on the inner surface thereof to prevent "oil canning".

Referring to Figure 50, the second step of folding the preform blank entails manually or mechanically rotating rear wall portion 2040 substantially 90° about axis Y - Y from its vertical orientation illustrated in Figure 49 co-planer with the bottom wall portion 2038 to a horizontal orientation substantially parallel with front wall portion 2036. Note that in this step, top wall portion 2042 remains co-planer with rear wall portion 2040, assuming a horizontal orientation. Although not illustrated, after completion of the step of Figure 50, guide retainers 2064 serve to abut the rearmost edge surface of the circuit board subassembly 2014 to effect longitudinal support thereof..

Referring to Figures 49, 50 and 54, screws 2028 are then applied, extending through holes 2080 formed in the pedestals 2060 of rear wall portion 2040 and engaging the rear wall of the CD player subassembly 2016, rigidly securing rear wall portion 2040 and bottom wall portion 2038 in their respective positions as illustrated in Figure 50.

Note that during the process of forming the preform blank 2012, the screen is stretched, punched or weakened in the areas corresponding with the pedestals 2060 such as illustrated in Figures 37 and 38. Extra screen inserts can be provided within the portions of the mold forming the pedestals or external EMI patches or surface coatings can be provided to ensure complete shielding is provided by the final assembly.

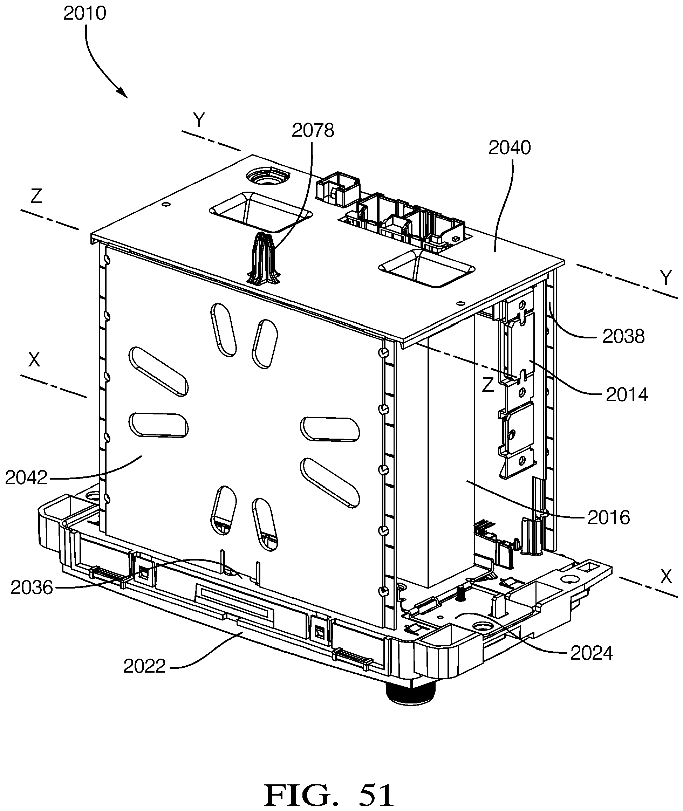

Referring to Figure 51, the third step of folding the preform blank entails manually or mechanically rotating top wall portion 2042 substantially 90° about axis Z - Z from its horizontal orientation illustrated in Figure 50 co-planer with the rear wall portion 2040 to a vertical orientation substantially parallel with bottom wall portion 2038. While transitioning from the orientation of Figure 50 to that of Figure 51, the male engagement feature 2048 and guide features 2050 extending from the leading edge of the top wall portion 2042 are respectively guidingly received within the corresponding female engagement feature 2044 and guide features 2046 to self-position and self-engage the top wall portion 2042. As illustrated in Figure 51, the perform blank 2012 has been fully folded into a three-dimensional box-like configuration.

The wire screen/conductive layer is continuous throughout the full extent of the four contiguous wall portions 2036, 2038, 2040 and 2042, with the exception of where the leading edge of the front wall portion 2036 adjoins the trailing edge of the top wall portion 2042. The slight gap at the point of contact of the front wall portion 2036 and 2042 is believed by the inventors to result in only deminimus RF leakage that, if required can be effectively blocked by application of a local conductive patch.

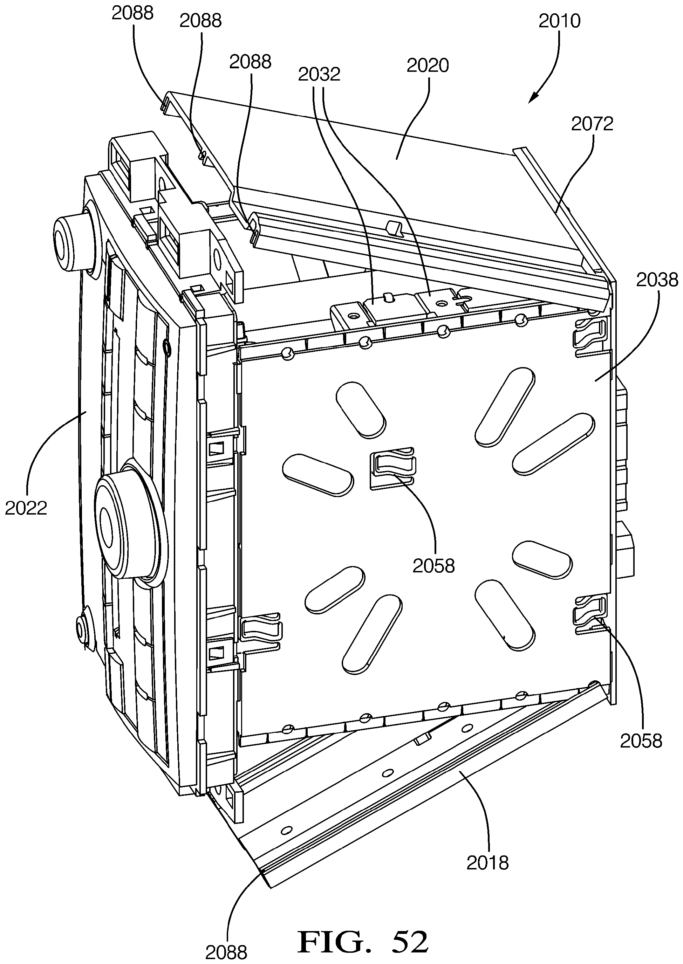

Referring to Figures 52, 53 and 54, the application of the left and right side closure members 218 and 220 is illustrated. As illustrated in Figure 52, the rear edge portions of closure members are initially angularly positioned under their respective retention rib 2072 and then pivoted thereabout to assume the final, installed position illustrated in Figure 53. As the side closure members 2020 and 2022 are fully installed, the forward edges thereof are retained in the installed position by self-engaging retention features 2082 integrally formed on the rear surface of the front wall portion 2036. Thereafter, screws 2032are applied through holes in the right side closure member 2020 to engage their respective power devices 2034 to establish the right side closure member 2020 an a heat sink. After this step, final assembly is essentially complete.

As best viewed in Figure 52, the side closure members 2018 and 2020 are identical, formed from a continuous extrusion process, having a typical cross-section defining inwardly directed upper channels 2086, lower channels 2088 and center channels 2090. During installation, each upper channel 2086 forms an interference fit with a respective edge portion of the top wall portion 2042. Similarly, each lower channel 2088 forms an interference fit with a respective edge portion of the bottom wall portion 2038. Redundant retention can be applied by screws 2030 which extend through mating holes formed in the front and rear wall portions 2036 and 2042, to engage the adjacent center channel 2090.

Referring to Figure 55, the exposed edges or alternatively, a molded rail, of the top wall portion 2042 and bottom wall portion 2038 have a series of openings 2092 exposing the screen 2084. The exposed segments of screen have an upward/downward extending dome or distension 2094 locally raising the screen above the outer surface of the adjacent wall portion. Once installed, the inner surfaces of the channels 2086 and 2088 compressively engage the screen domes 2094 to establish reliable, multi-point electrical contact therebetween.

Referring to Figures 55 - 57, detail of one of the "living hinges" is illustrated. Adjacent edges of the bottom wall portion 2038 and rear wall portion 2040 are slightly spaced apart to expose electrically conductive material such as screen 2084 extending along the hinge axis Y - Y. This arrangement assures that each of the wall panels remain substantially rigid while the hinge portions are relatively flexible, and maintains its EMI isolation characteristics.

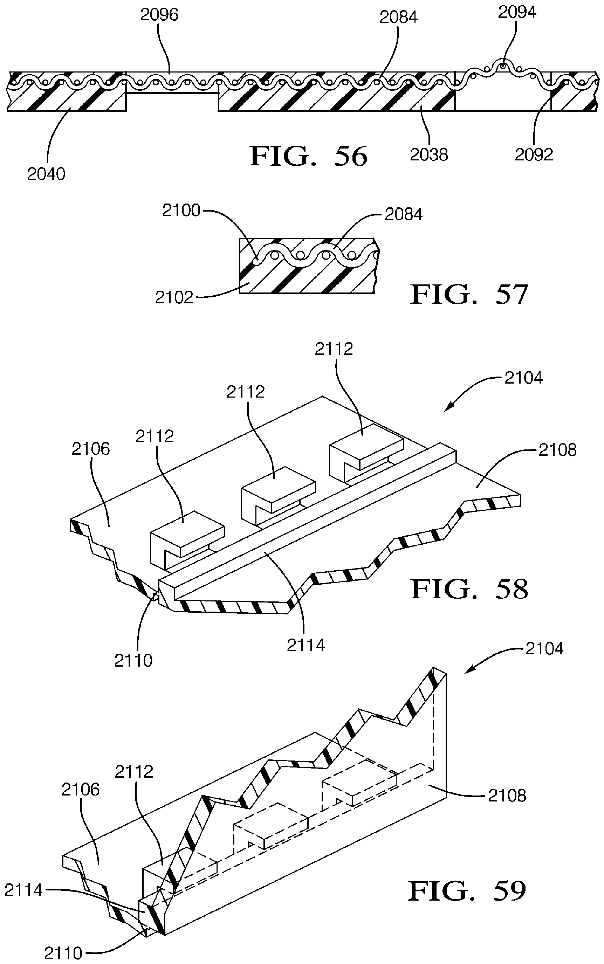

Referring to Figures 55 and 56, preferably, at each end of each living hinge is a relatively this web of plastic 2096 integrally interconnecting the adjacent wall portions 2038 and 2040 to provide torsional rigidity to the hinge, as well as the overall housing assembly.

Air flow openings 2098 are formed in the top and bottom wall portions closed by screen 2084 while permitting free ventilation of the interior of the housing assembly.

Referring to Figure 57, all cut edges 2100 of the screen 2084 are fully encased in a layer of plastic 2102 to prevent unraveling of the screen 2084 and/or inadvertent electrical shorts or injury to an assembly technician.

Referring to Figures 58 and 59, an alternative hinge design 2104 is illustrated. Adjacent edges of a first wall portion 2106 and a second wall portion 2108 are integrally interconnected by a thin web 2110 of plastic material. In this embodiment, the inner surfaces of both wall portions 2106 and 2108 are coated by an electrically conductive surface layer (not illustrated). A similar web with wire mesh is depicted in Figure 19 above. A series of spaced retention hooks 2112 are integrally formed on the first wall portion 2160 extending adjacently along the hinge line/axis. A cooperating retention rib 2114 is integrally formed on the second wall portion 2108 extending adjacently parallel to the hinge line/axis. The hooks 2112 and cooperating rib 2114 are dimensioned to cooperatively self-engage one another as the wall portions 2016 and 2018 are transitioned from the co-planer orientation depicted in Figure 58 to the right angle configuration depicted in Figure 59. This embodiment ensures robust continuous electrical interconnection between the adjacent conductive layers, even in the case of micro-cracking during the folding process.

Insert molded wire mesh in plastic has been successful for replacing metal enclosures typically utilized for packaging electronics that require EMC shielding and grounding. Virtually any plastic resin can be molded with a wire mesh which makes it advantageous for almost any application requiring these unique characteristics that offer many assembly and weight reductions that are the result of replacing metal enclosures with a molded plastic version. A limiting factor with some plastic resins is the ability for dimensional stability and especially warpage characteristics that may be a hindrance to the final molded part to meet the same requirements as a similar metal version. As an example, some plastic resins like polypropylene may tend to warp during the cooling phase after mold ejection which can disrupt the dimension stability. This may, in turn, threaten the ability of the part to mate with conjoining component parts in an assembly.

By using a nozzle injected gas product like the MuCell process (offered by Trexel) for the insert molded part operation, the wire mesh insert molding can be fabricated to offer a dimensionally stabilized part that is resistant to warpage that is now better suited for the assembly of the electronics enclosure. Without the process, additional fixtures or clamping may be necessary to prevent post molding warpage or creep of the material due to non-uniform cooling that can take place after the part is molded and ejected from the tool. This is critical for use with the wire mesh in plastic molding with electronic enclosures to prevent unwanted wire mesh contact with electrical contacts due to warpage or dimensional variation. This also allows interface contact between assembly parts to be aligned within normal material tolerance eliminating the need to construct additional controls into the parts and/or molding.

Referring to Figures 24 and 25, an injection molding machine or extruder 1188 can be modified to accommodate nitrogen gas injection via an injector 1189 to implement the MuCell process. As a result, the resulting molded or extruded plastic parts are filled with micro-bubbles of nitrogen gas 1167whereby the flow of the molten plastic within the mold in enhanced, reducing warpage and improving part-to-part repeatability. Furthermore, the process further reduces weight of the molded parts and reduces the required tonnage of the molding machine.

### Hydroforming

In generally accepted engineering parlance, the term "hydroforming", (or, alternatively "hydramolding") is a cost-effective way of shaping malleable metals such as aluminum or brass into lightweight, structurally stiff and strong work pieces or end products. One of the largest applications of hydroforming is for automotive components, which makes use of the complex shapes possible by hydroforming to produce stronger, lighter and more rigid unibody structures for vehicles. This technique is particularly popular with the high-end sports car industry and is also frequently employed in the shaping of aluminum tubes for bicycle frames.

Hydroforming is a specialized type of die forming that uses high pressure hydraulic fluid to press room temperature working material into a die. To hydroform aluminum into a vehicle's frame rail, a hollow tube of aluminum is placed inside a negative mold that has the shape of the desired end result. High pressure hydraulic pistons then inject a fluid at very high pressure inside the aluminum, which causes it to expand until it matches the mold. The hydroformed aluminum is then removed from the mold.

Hydroforming allows complex shapes with concavities to be formed, which would be difficult or impossible with standard solid die stamping. Hydroformed parts can often be made with a higher stiffness to weight ratio and at a lower per unit cost than traditional stamped or stamped and welded parts.

In sheet hydroforming (SHF), there is "bladder forming" (where there is a bladder that contains the liquid, with no liquid contacting the sheet stock) and hydroforming where the fluid contacts the sheet stock (no bladder). A work piece is placed on a draw ring (blank holder) over a male punch then the hydraulic chamber surrounds the work piece and a relatively low initial pressure seats the work piece against the punch. The punch then is raises into the hydraulic chamber and pressure is increased to as high as 15,000 psi which forms the part around the punch. Then the pressure is released, the punch is retracted and the hydraulic chamber lifted and the process is complete.

In tube hydro forming (THF) there arte two major practices: high pressure and low pressure. With the high pressure process, the tube is fully enclosed in a die prior to pressurization of the tube. In the low pressure process, the tube is slightly pressurized to a fixed volume during the closing of the die (formerly known as the Variform process). In tube hydro forming, pressure is applied to the inside of the tube that is held by dies with the desired cross-sections and forms. When the dies are closed, the tube ends are sealed by axial punches and the tube is filled with hydraulic fluid. The internal pressure can go up to a few thousands of bars causing the tube to calibrate against the dies. The fluid is injected into the tube through one of the two axial punches. Axial punches are movable and their action is required to provide axial compression and to feed material towards the center of the bulging tube. Transverse counterpunches may also be incorporated in the forming die in order to form protrusions with small diameter/length ratio. Transverse counterpunches may also be used to punch holes in the work piece at the end of the forming process.

Industrial hydroforming machines use a piston to generate pressure in the hydraulic fluid used in hydroforming, but an experimental alternative is the use of explosives to generate the pressure. Called explosive hydroforming, this method places an explosive charge, with or without an additional working fluid, on the high pressure side of the material. When the charge is ignited, the explosive pressure forces the working material into the die, at pressures up to millions of pounds per square inch.

One advantage of hydroforming is the savings on tools. For sheet metal only, a draw ring and punch (metalworking) or male die is required. The bladder of the hydro form itself acts as the female die eliminating the need to fabricate a matching female die. This allows changes in material thickness to be made with usually no necessary changes to the tool. However, dies must be highly polished and in tube hydro forming a two-piece die is required to allow opening and closing. Tools and punches can be interchanged for different part requirements.

Another advantage of hydro forming is that complex shapes can be made in one step. In sheet hydroforming (SHF), with the bladder acting as the female die, almost limitless geometries can be produced. However, the process is limited by a very high closing force required in order to seal the dies, especially for large panels and thick, hard materials. Small concave corner radii are difficult to be completely calibrated, i.e. filled. Because too large a pressure would be required. Limits on the SHF process are due to risks of excessive thinning, fracture, wrinkling and are strictly related to the material formability and to the proper selection of process parameters (e.g. hydraulic pressure vs. time curve). Tube hydroforming (THF) can produce many geometric options as well, reducing the need for tube welding operations. Similar limitations and risks can be listed as in SHF. However, the maximum closing force is seldom a limiting factor in THF.

Hydroforming is capable of producing parts within tight tolerances including aircraft tolerances where a common tolerance for sheet metal parts is within thirty thousandths of an inch. Sheet metal hydroforming also allows for a smoother finish as draw marks produced by the traditional method of pressing a male and female die together are eliminated.

Electronic assemblies typically contain a circuit board assembly that may have ground points from the circuit board to the enclosure. When the enclosure has been constructed of a non-metallic material such as plastic, the grounding and shielding has been provided by a variety of methods including, but not limited to using a wire screen mesh that is formed and insert molded with the structure of the plastic enclosure. While the plastic enclosures are desirable for manufacturing assembly simplification, through the elimination of fasteners as well as weight reductions from the metal enclosures, the capitalization to provide a wire mesh part insert to a molded plastic part has been a limiting factor, especially with low volume build applications. The manufacturing process flow has typically coupled the plastic molding press directly with the wire mesh insert fabrication cell. This coupling may not be desired if the molding press utilization is not at a high enough percentage of the available molding press time.

Hydroforming has been a process typically used for producing metal parts that can have some complex details and patterns. Due to the nature of the hydroforming equipment having a bladder to impart the forming and a form cavity to enable the final desired shape the investment for the equipment offers a less costly alternative to typical mesh cell forming equipment. Also, to change the set-up to produce different parts is easier, for only the form cavity is the only part change required, since the bladder is universal for this process. By using insulating elastomeric material to provide localized areas of encapsulation of the wire mesh, this not only allows for isolation from electrical contact where it is not desired on the circuit board in the final assembly, but also helps to prevent wear or damage of the hydroform equipment from any cut or sharp areas of the wire mesh fabric.

To enable the elastomeric material to encapsulate the wire mesh, the wire mesh can be precut to allow exposed mesh areas and the elastomeric material either to be positioned to provide the wire mesh as the interlayer or the elastomeric material may be applied in a controlled dispensing format directly to the form with the wire mesh placed on top of it such that when the process is initiated, the wire mesh will be substantially embedded in the elastomeric material as the elastomeric material solidifies or cures after the hydroforming has been completed. If elastomeric layers are to be used in the hydroforming process with the wire mesh at the middle layer an adhesive may be used that is activated with pressure to provide a "binder" for the layers.

Hydroforming wire mesh in an elastomeric material reduces the investment required for the mesh forming cell. It also offers greater flexibility for change-over to accommodate different component configurations. The final part could conceivably be an enclosure for a circuit board assembly or function as a ground/shield within a plastic enclosure.

The present invention offers an encapsulated wire mesh in an elastomeric to provide a volume efficient electronics enclosure that offers shielding and grounding capabilities produced through a hydroforming process that minimizes the tooling for there is typically only one die required used in conjunction with an oil bladder.

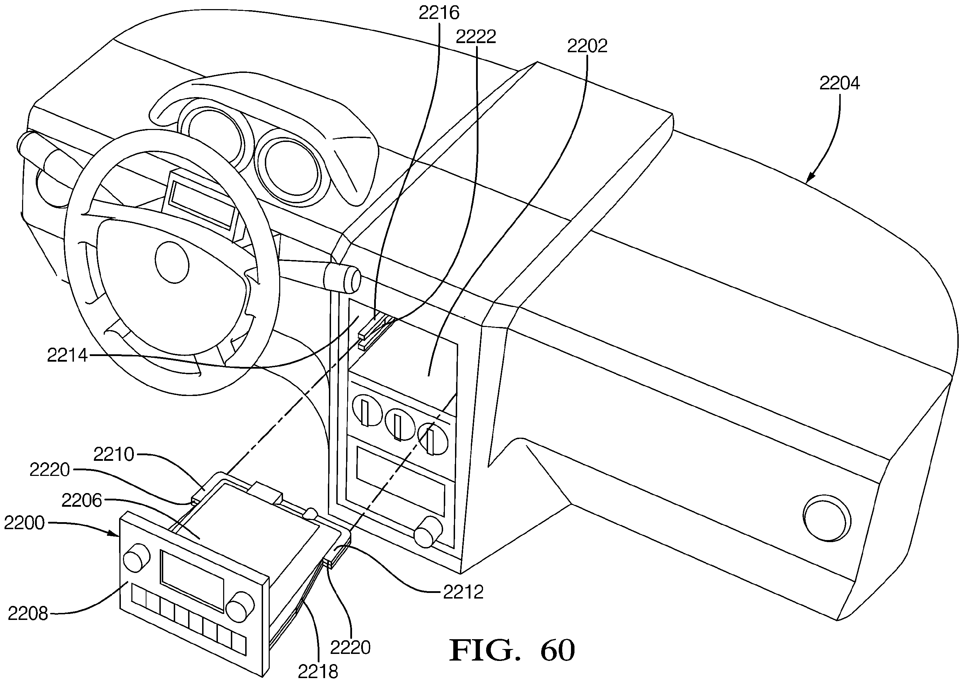

Referring to Figure 60, an electronic system housing assembly 2200, embodied in one application as an automotive audio system, is illustrated in assembly within a central opening 2202 formed in an instrument panel 2204 of a host automobile. The housing assembly 2200 includes a three-dimensional case 2206 cooperating with an operator accessible trim panel 2208. As will be described in greater detail herein, the case 2206 and trim panel 2208 and/or a discrete closure member cooperate to define a substantially closed cavity for carrying at least one electronic component such as a radio circuit assembly.

Although primarily intended for application in automotive audio systems, the present invention can also be employed in packaging navigation, object detection, telematics, system controllers, power supplies and other systems including electronic devices requiring shielding from electronic anomalies.

In the illustrative embodiment of the invention, the instrument panel opening 2202 is located conveniently adjacent a designated operator seating position whereby input/output devices and displays of the audio system 2200 installed therein are easily accessible. The case 2206 includes left and right longitudinally extending guides 2210 and 2212, respectively, integrally formed therewith. The instrument panel opening 2202 is configured to nestingly receive the audio assembly 2200 which is front-loaded therein. The instrument panel opening 2202 defines left and right sidewalls 2214 which include opposed, cooperating longitudinally extending guideways 2216 configured to slidingly receive the audio system guides 2212 and 2214. Each case guide 2210 and 2212 forms a laterally inwardly directed notch 2218 therein including a rearwardly facing stop surface 2220. Guideways 2216 form an integral catch 2222 which, upon installation of the audio system 2200, self-engages a corresponding stop surface 2220 to secure the front surface of the trim panel 2208 with the adjacent portion of the instrument panel 2204 without the need for separate fasteners.

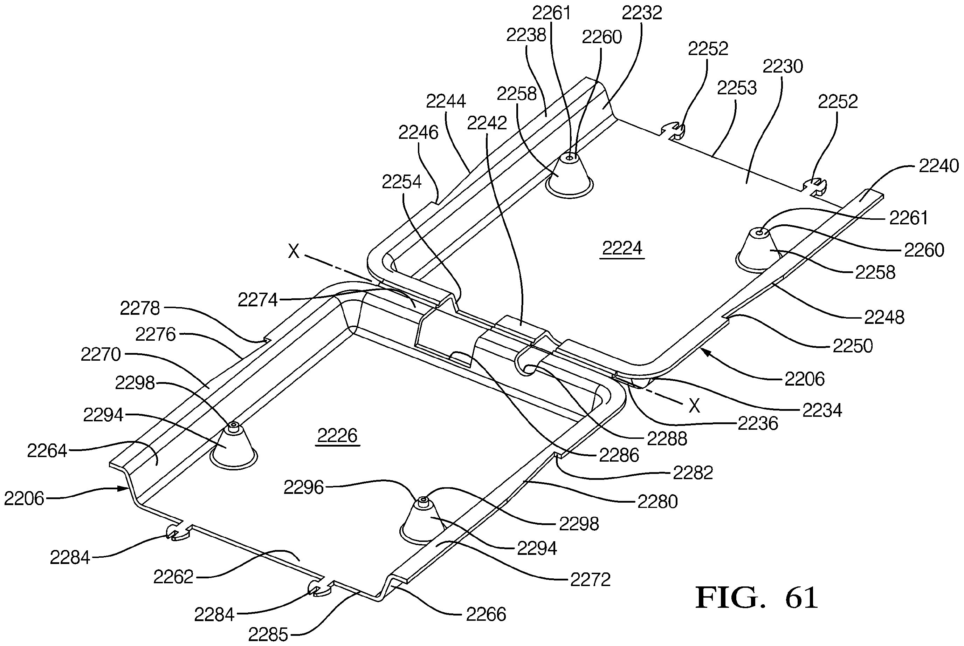

Referring to Figure 61, case 2206 is illustrated in its "as formed" configuration illustrating the internal details thereof. As described herein, case 2206 is compression molded by hydro forming process forming a layered coalesced composite of inner and outer discrete layers of relatively rigid polymer sheet material enclosing an intermediate discrete layer of electrically conductive sheet material, preferably wire screen. The sheets of polymer and conductive material are continuously fed in parallel alignment into the hydroforming press which serially forms three-dimensional case blanks, which are trimmed and punched to final net form either during the hydroforming process or thereafter as a separate process step.

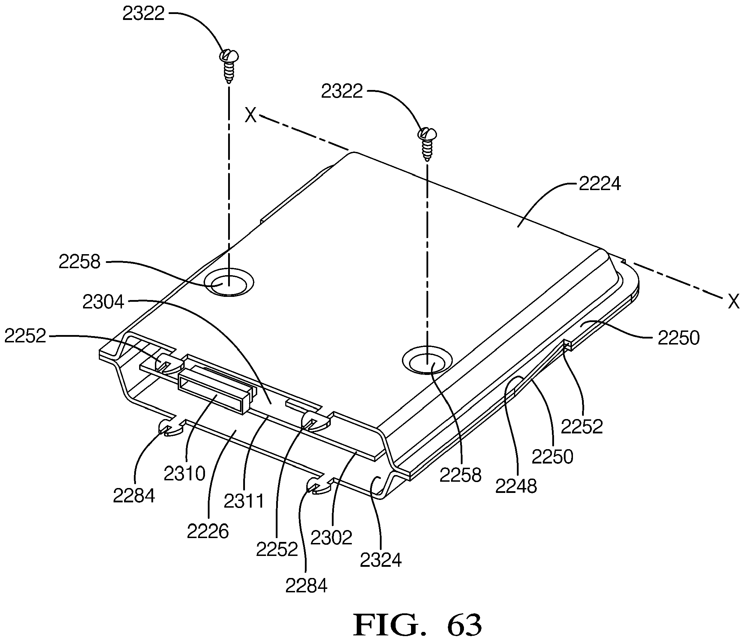

In the preferred embodiment, case 2206 is formed in a unitary clamshell configuration including a first or upper case half 2224 and a second or lower case half 2226 integrally interconnected along a common edge by a living hinge 2228. The case halves 2224 and 2226 are substantially mirror-images of one another and configured to be manually folded about common edge axis X - X from the initial open position of Figure 61 to the closed orientation of figure 63 during the final assembly process. Details of the case 2206 are described herein below as if the case 2206 is in the folded orientation as illustrated in Figure 63.

The upper case half 2224 defines a top wall 2230, left and right upper partial side walls 2232 and 2234, respectively, and an upper partial rear wall 2236. The lowermost edges of the left and right upper partial side walls 2232 and 2234 transition into laterally outwardly extending integral flanges 2238 and 2240, respectively, and the lowermost edge of the upper partial rear wall 2236 transitions into a rearwardly extending integral flange 2242. Flanges 2238, 2242 and 2240 extend substantially continuously about the lower edge of the upper case half 2224 to provide a seat surface with the lower case half 2226 and to rigidify the overall structure of the housing assembly 2200. A laterally inwardly transiting notch edge 2244 terminating in a stop surface 2246 is formed in the outer portion of the flange 2238. Likewise, a laterally inwardly transiting notch edge 2248 terminating in a stop surface 2250 is formed in the outer portion of the flange 2240.

The top wall 2230 of the upper case half 2224 integrally forms two resilient, bifurcated engagement tabs 2252 extending forwardly from the leading edge 2253 thereof for mounting the case 2206 to the trim panel 2208. A first, generally rectangular opening 2254 extends through a portion of the upper partial rear wall 2236 and the adjacent flange 2242. A second, semi-circular opening 2256 extends through a portion of the upper partial rear wall 2236 and the adjacent flange 2242. A pair of spaced-apart pedestals 2258 are integrally formed in the top wall 2230 and extend downwardly, terminating on an mounting surface 2260.

The lower case half 2226 defines a bottom wall 2262, left and right lower partial side walls 2264 and 2266, respectively, and an lower partial rear wall 2268. The uppermost edges of the left and right upper partial side walls 2264 and 2266 transition into laterally outwardly extending integral flanges 2270 and 2272, respectively, and the uppermost most edge of the lower partial rear wall 2268 transitions into a rearwardly extending integral flange 2274. Flanges 2270, 2274 and 2272 extend substantially continuously about the upper edge of the lower case half 2226 to provide a seat surface with the upper case half 2224 and to rigidify the overall structure of the housing assembly 2200. A laterally inwardly transiting notch edge 2276 terminating in a stop surface 2278 is formed in the outer portion of the flange 222270. Likewise, a laterally inwardly transiting notch edge 2280 terminating in a stop surface 2282 is formed in the outer portion of the flange 2272.

The bottom wall 2262 of the lower case half 2226 integrally forms two resilient, bifurcated engagement tabs 2284 extending forwardly from the leading edge 2285 thereof for mounting the case 2206 to the trim panel 2208. A first, generally rectangular opening 2286 extends through a portion of the lower partial rear wall 2268 and the adjacent flange 2274. A second, semi-circular opening 2288 extends through a portion of the lower partial rear wall 2268 and the adjacent flange 2274. Rectangular openings 2254 and 2286 are in lateral register to cooperatively form a rectangular opening in the rear wall of the case 2206. Likewise, semi-circular openings 2256 and 2288 are in lateral register to cooperatively form a round opening in the rear wall of the case 2206. A pair of spaced-apart pedestals 2294 are integrally formed in the bottom wall 2262 and extend upwardly, terminating in a mounting surface 2296. A short locating boss 2298 extends above the mounting surface 2296. A patch of wire screen 2300 is exposed on one or more of the mounting surfaces 2260 and 2296 to affect electrical interconnection with an electronic device subsequently mounted within the case 2206.

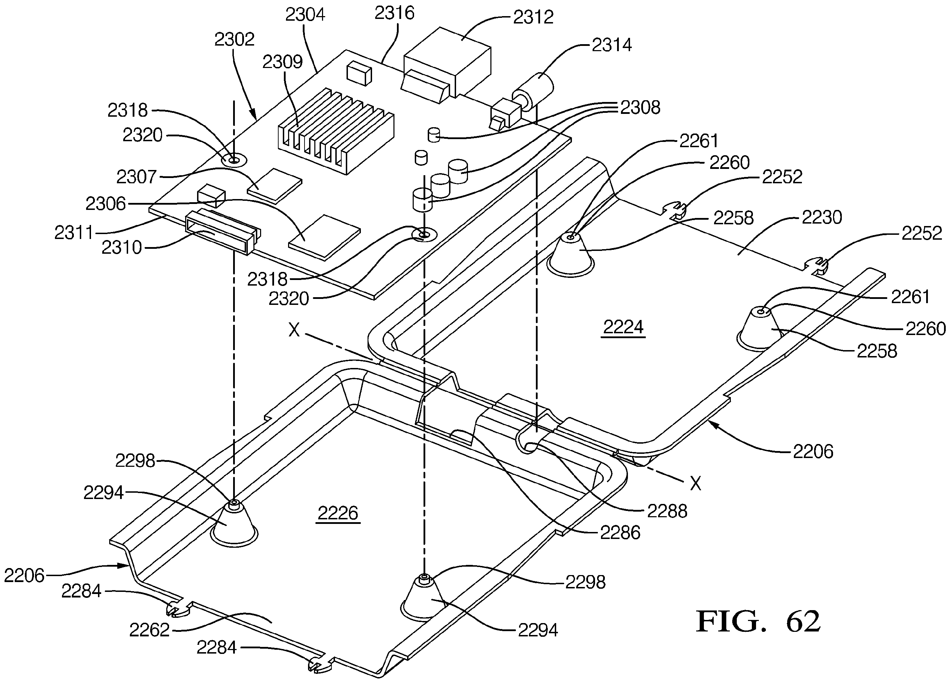

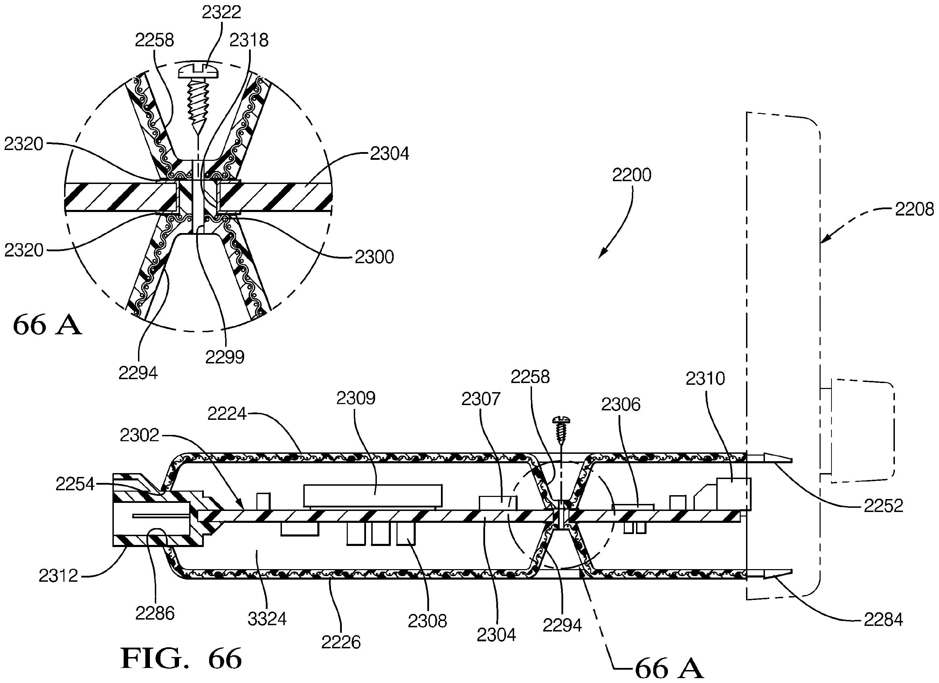

Referring to Figure 62, an electronic component configured to be carried within a cavity defined by the case 2206. An electronic circuit assembly 2302 consists of a generally planer substrate or circuit board 2304 configured to carry processors 2306, integrated circuits 2307, discrete components 2308, a heat sink 2309 and interconnecting circuit traces. As best seen in Figure 66, circuit components can be mounted on both sides of the circuit board 2304. A multi-circuit connector 2310 is mounted on a leading edge 2312 of the circuit board 2304 for interfacing with the trim panel 2208. A multi-circuit power and output connector 2312 and an antenna feed connector 2314 are mounted on a trailing edge 2316 of the circuit board 2304 for interfacing with the host vehicle wire harness and antenna cable. The circuit board 2304 has a pair of spaced-apart mounting holes 2318 positioned to register with their respective mounting pedestals 2294. Ground pads 2320 are formed on one or both sides of the circuit board 2304 concentric with their respective mounting holes 2318.

The case 2206 is assembled by placing it on a generally flat work surface with the internal surfaces of the case halves 2224 and 2226 facing upwards. The electronic circuit assembly 2302 is installed by manually aligning it within one of the case halves 2224/2226. Insodoing, the power/input connector 2312 is nestingly received within the rectangular opening 2286 and the antenna feed connector 2314 is nestingly received within the semi-circular opening 2288 of the lower case half 2226. Simultaneously, the pedestals 2294 register with their respective mounting holes 2318 with the locating boss 2298 extending there through. When placed in the assembled position, the mounting surface 2296 of each pedestal 2294 retains the electronic circuit assembly 2302 in a spaced relation above the inner surface of the lower case half 2226 and the exposed wire screen patch electrically contacts the adjacent ground pad 2320.

Referring to Figure 63, after installation of the electronic circuit assembly 2302 on the lower case half 2226, the upper case half 2224 is manually folded about 180° counterclockwise from the position illustrated in Figure 62 about living hinge 2228 axis X - X to assume its assembled (closed) position illustrated in Figure 63. The subassembly of the case 2206 with the electronic circuit assembly 2302 is completed by the installation of fasteners such as screws 2322 through holes 2261 in upper pedestals 2258, and through mounting holes 2318 in the circuit board 2304, threadably into corresponding holes 2299 in pedestals 2294.

When in the closed position, the flanges 2240, 2242 and 2244 of upper case half 2224 abut flanges 2272, 2274 and 2276, respectively, of lower case half 2226 to assure a rigid structure of case 2206. Insodoing, openings 2254 and 2256 engage and capture the power/output connector 2312 and antenna feed connector 2314 in their installed positions. Furthermore, when in the closed position, notched edge 2276 and stop surface 2278 of flange 2270 register with notched edge 2244 and stop surface 2246 of flange 2238 to define left-hand notch 2218 and stop surface 2220 of Figure 60. Similarly, when in the closed position, notched edge 2280 and stop surface 2282 of flange 2272 register with notched edge 2248 and stop surface 2250 of flange 2240 to define right-hand notch 2218 and stop surface 2220 of Figure 60.

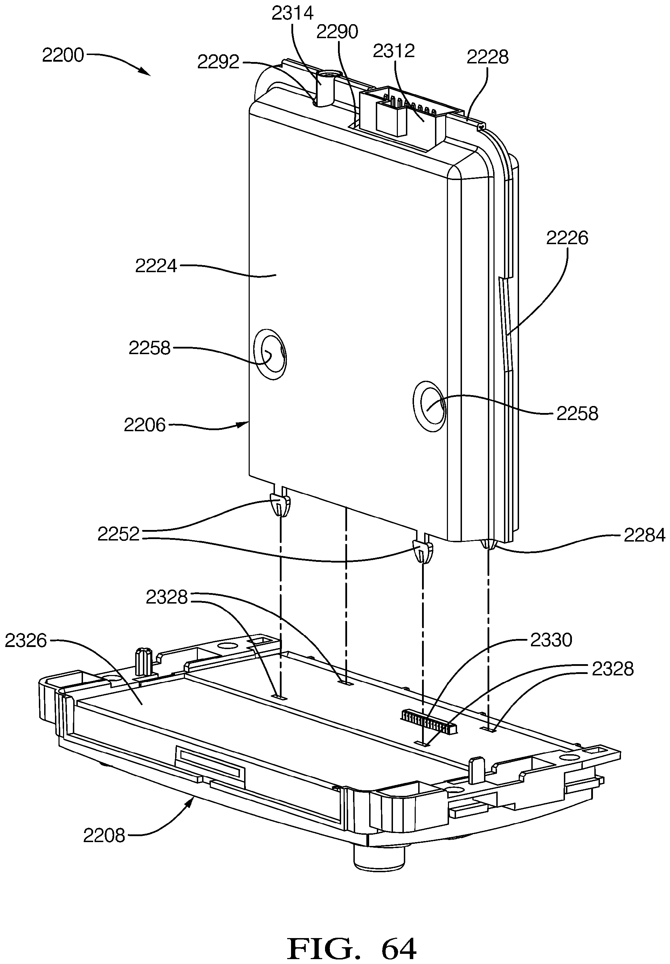

As illustrated in Figure 63, the clamshell-type case 2206 forms a three-dimensional configuration defining a substantially closed cavity 2324 which, in application shields the electronic circuit assembly 2302 from electrical anomalies as described herein above. It is contemplated that the case can be configured to fully enclose the electronic circuit assembly 2302 by the addition of integral front wall portions, or alternatively, to enclose the electronic circuit assembly 2302 in combination with a discrete metal or composite front closure member 70 (refer Figure 3) or, preferably, by mounting the case 2206 directly to the read surface of the trim panel 2208 as illustrated in Figure 64.

Referring to Figure 64, final assembly of the electronic system housing assembly 2200 is affected by manual mating engagement of the case 2200 - electronic circuit 2302 subassembly with the operator accessible trim panel 2208. The trim panel 2208 is constructed substantially as described herein above, with the exception that a rear surface closure member 2326 protectively encloses internal components of the trim panel 2208. The closure member 2326 has an array of slot openings 2328 arranged to register with engagement tabs 2252 extending forwardly from the case 2206. A multi-circuit plug 2330 extends through the closure member 2326 to matingly engage the circuit board connector assembly 2310 to complete the electrical interface between the electronic circuit assembly 2302 and the trim panel circuitry. During final assembly, each engagement tab 2252 registers with and engages an associated slot opening 2328. Accordingly, no separate fasteners are required. If desired, the screws 2322 of Figure 63 can be replaced by appropriate self-engaging features formed with the case halves 2224 and 2226.

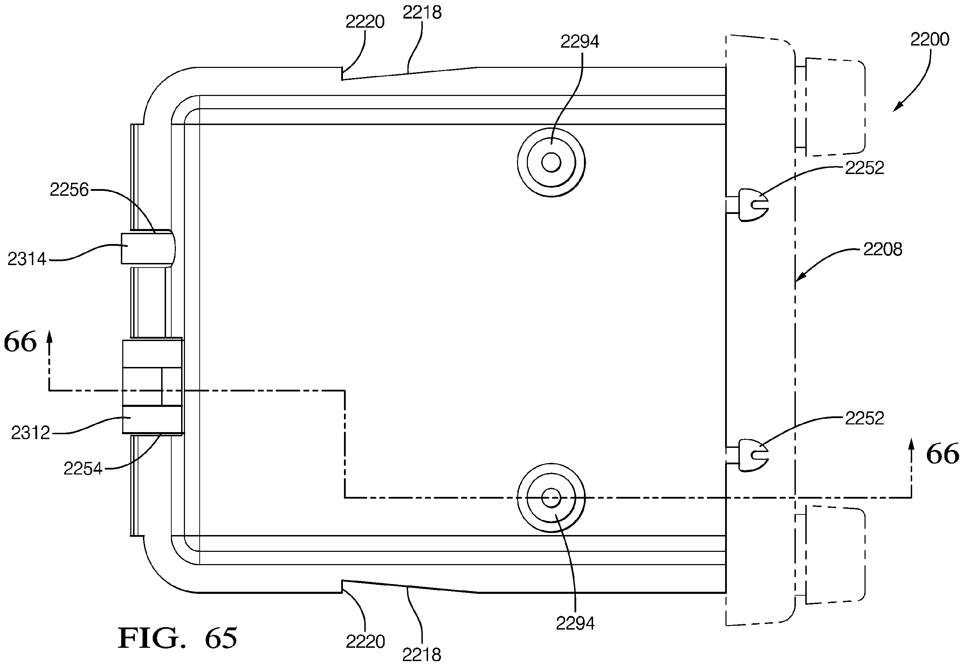

Referring to Figures 65, 66 and 66A, details of the fully assembled electronic system housing assembly 2200 are illustrated. When fully assembled, the electronic circuit assembly 2302 is supported at two locations between cooperating pedestals 2258 and 2294, as well as at two locations along the rear case wall 2236 and 2268 via (1.) power output/connector 2314 extending through rectangular opening 2254 and 2286 and (2.) antenna feed connector 2314 extending through circular opening 2256 and 2288. The electronic circuit assembly 2302 is generally centered vertically within the cavity 3324 formed by the case 2206 with components carried on both the upper and lower surfaces of the circuit board 2304. It is contemplated that other features for positioning, locating, spacing, and/or isolating the electronic circuit assembly 2302 as well as other components disposed within the case 2206 or externally thereof can be integrally formed in as part of the hydroforming process. For example, a heat sink can be mounted externally of the case via integral retention features such as described earlier herein with the addition of a window in the case 2206 for routing a thermal interconnection with a power device disposed within the case 2206.

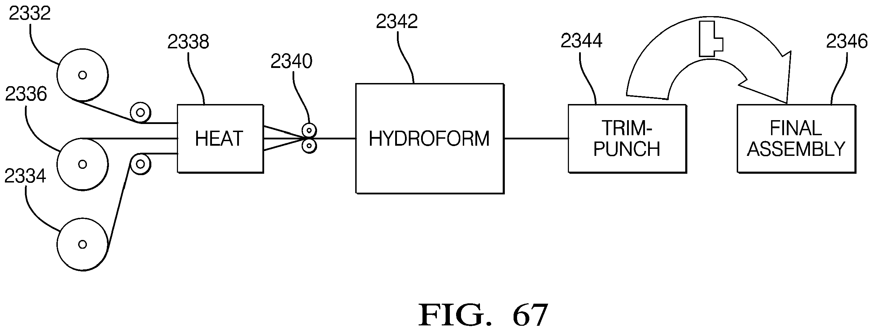

Referring to Figure 67, a hydroforming process for producing composite material is illustrated, including drawing polymeric sheet material off upper and lower continuous rolls 2332 and 2334 to enclose an intermediate layer of wire screen from a third roll 2336. The three discrete sheets are heated at station 2338, rolled together at station 2340, hydroformed at station 2342, cut-off or die cut, scribed, punched and treated at a station 2344, and, finally, assembled at a workstation 2346.

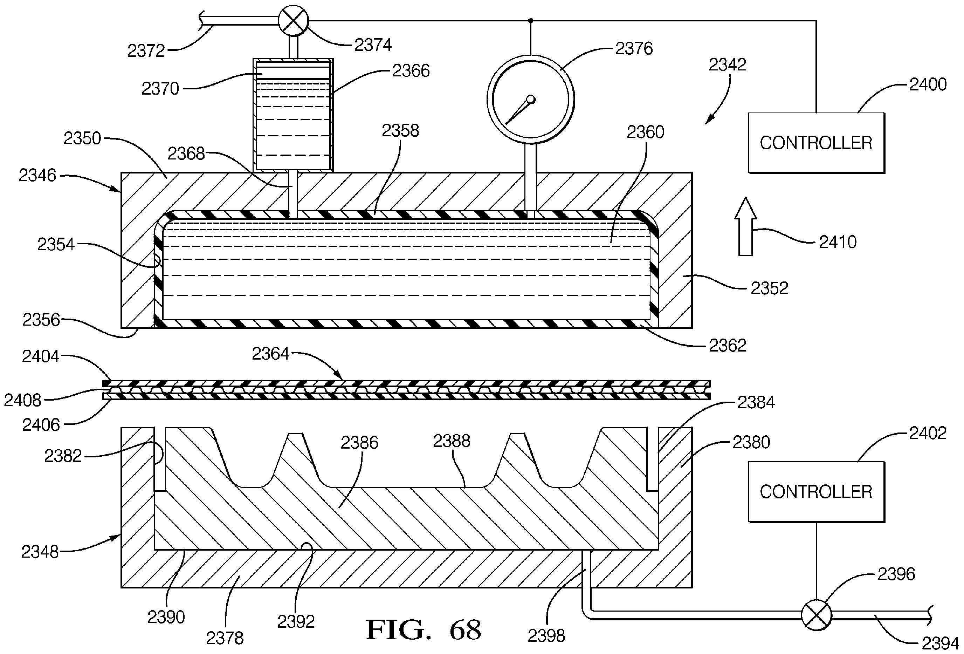

Referring to Figures 68 - 71, details and operation of the hydroform station 2342 are illustrated. The hydroform station 2342 includes an upper die portion 2346 and a lower die portion 2348. The upper die portion 2346 includes a top wall 2350 and downwardly extending peripheral side walls 2352 defining a downwardly opening cavity 2354 and which serves as a draw ring and an upper blank holder 2356. A closed flexible bladder 2358 occupies the entire volume of the cavity 2354. The bladder 2358 is entirely filled with a substantially incompressible liquid such as hydraulic fluid 2360. In operation, the exposed, lower wall 2362 of the bladder 2358 acts upon the upper surface of a work piece blank 2364 disposed immediately there below.

The hydraulic fluid 2360 in the bladder 2358 is selectively pressurized/de-pressurized from a reservoir 2366 fluidly coupled with the bladder 2358 via a sealed feed line 2368. A piston 2370 is displacable within the reservoir 2366 to effect the controlled pressurization/de-pressurization of the bladder 2358 in response to a control valve 2374 fed by a pressure source 2372. A pressure sensor 2376 communicating with the bladder 2358 operates to sense and display the instantaneous pressure therein and provide a feedback signal to the control valve.

The lower die portion 2348 includes a bottom wall 2378 and upwardly extending peripheral side walls 2380 defining an upwardly opening cavity 2382 and serves as a lower blank holder 2384. A male punch 2386 is disposed within said walls 2380 and is displacable upwardly/downwardly. The upper surface 2388 of the male punch 2386 forms fixed contours and concavities which substantially mimic the basic "as molded" shape of the case 2206 of Figures 60 - 66. In the released position illustrated in Figure 68, the male punch 2386 is in its fully-retracted, downward most position, with the bottom surface 2390 of the male punch 2386 in close proximity with bottom wall 2378. The variable volume extending between the bottom surface 2390 of the male punch 2386 and the inner bottom wall 2378 of the lower die portion 2348 defines a sealed cavity 2392. Cavity 2392 is filled with an incompressible liquid such as hydraulic fluid which is selectively pressurized/de-pressurized from a pressurized reservoir feed 2394 through a control valve 2396 interconnected with cavity 2392 through a sealed feed line 2398. Suitable controllers 2400 and 2402 provide control signals to activate, cycle and deactivate the hydroforming station 2342.

Referring to Figures 67 and 68, feedstock for the hydroform station 2342 consists of a continuous upper sheet 2404 of relatively rigid polymer material from upper roll 2332, a continuous lower sheet 2406 of relatively rigid polymer material from lower roll 2334, and a continuous intermediate sheet 2408 of conductive material (preferably perforated sheet or wire screen) from middle roll 2336. The three sheets are heated and rolled together at station 2340, forming a continuous sheet of at least partially coalesced composite, which enters the hydroforming station 2342 either as a continuous sheet or as work piece blank 2364. Although cutting, punching and trimming process steps are illustrated as taking place in a subsequent process step at station 2344, they can be implemented within the hydroforming station 2342 whereby, the continuous composite sheet material can be formed to net or final shape in the hydroform station 2342.

Referring to Figure 68, the hydroforming station 2342 is illustrated at the beginning or first step of a cycle of operation. As illustrated, the fluid in both the upper and lower die portions 2346 and 2348, respectively, have their hydraulic fluids de-pressurized, whereby the bladder 2358 is fully drawn upwardly into the cavity 2354 of the upper die portion 2346 and the male punch 2386 is fully drawn downwardly into the cavity 2382 of the lower die portion 2348. As indicated by arrow 2410, the upper and lower die portions 2346 and 2348, respectively, are vertically separated sufficiently to enable horizontal insertion of the work piece blank 2364 in register with the upper and lower blank holders 2356 and 2384, respectively.

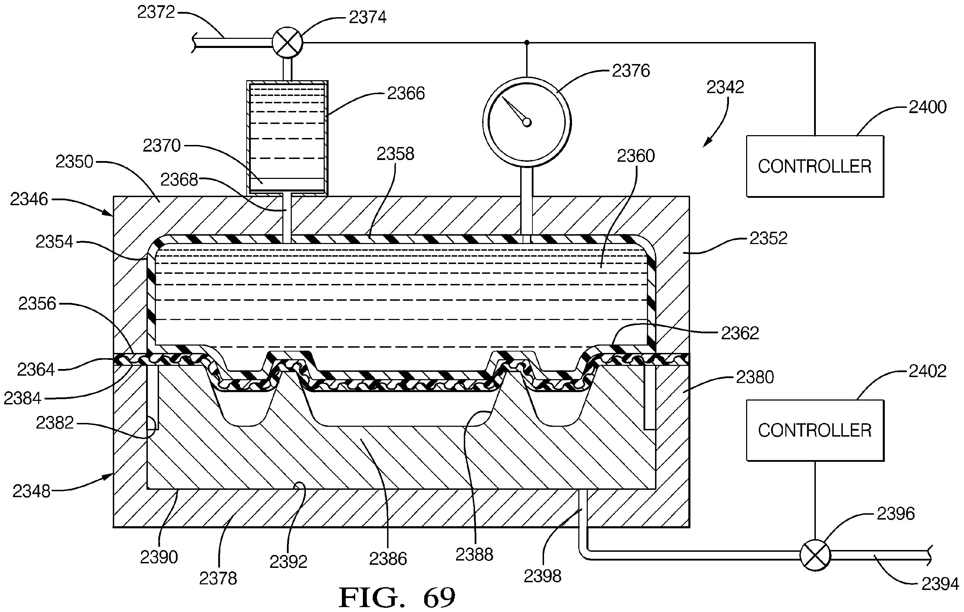

Referring to Figure 69, the hydroforming station 2342 is illustrated at the second step of a cycle of operation. As illustrated, the work piece blank 2364 has been registered with the upper and lower blank holders 2356 and 2384, respectively, and the upper and lower die portions 2346 and 2348, respectively, have been closed to clampingly engage the peripheral edge of work piece blank 2364. The fluid in the bladder 2358 in the upper die portion 2346 has been pressurized, whereby the lower bladder wall 2362 is distended downwardly at least partially into the cavity 2382 of the lower die portion 3248. Insodoing, the lower bladder wall 2362 displaces the exposed portion of the work piece 2364 downwardly into at least partial engagement and conformance with the upper surface 2388 of the male punch 2386. This is accomplished by opening valve 2374 to drive piston 2370 to its downward most limit of travel, thereby injecting additional fluid into the bladder 2358. As indicated by the pressure sensor 2376, the pressure within the bladder 2358 has increased sufficiently to at least partially deform the work piece 2364.

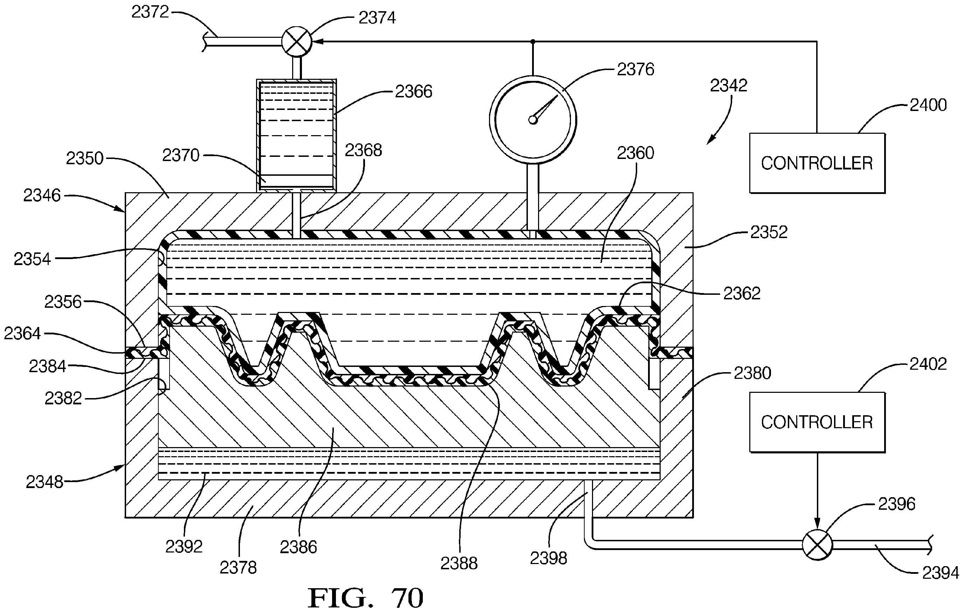

Referring to Figure 70, the hydroforming station 2342 is illustrated at the third step of a cycle of operation. As illustrated, the bladder 2358 remains fully charged with fluid and, simultaneously, control valve 2396 is opened by controller 2402, diverting pressurized fluid into sealed cavity 2392 through feed line 2398. As cavity 2392 fills, the male punch 2386 is forcefully displaced upwardly against the exposed lower surface of the work piece blank 2364 until the offsetting downward force applied by the fluid-filled bladder applies an offsetting force. Insodoing, the lower bladder wall 2362 displaces the exposed portion of the work piece 2364 downwardly into complete engagement and conformance with the upper surface 2388 of the male punch 2386. As indicated by the pressure sensor 2376, the pressure within the bladder 2358 has increased sufficiently to fully deform the work piece 2364 into its final net shape.

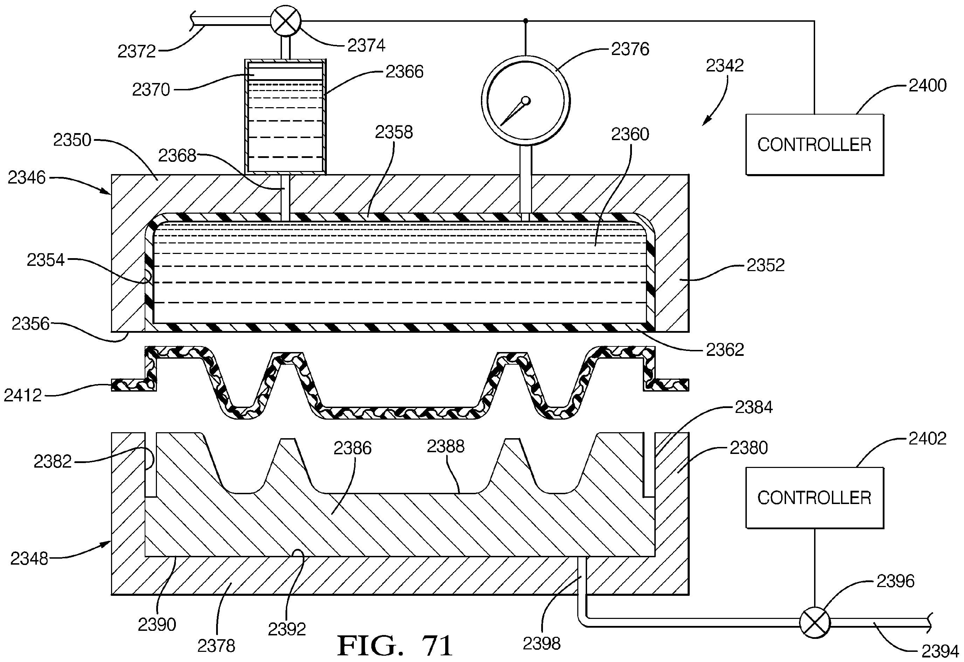

Referring to Figure 71, the hydroforming station 2342 is illustrated at the fourth step of a cycle of operation. As illustrated, the sealed cavity 2392 in the lower die portion 2348 has been drained, lowering the male punch 2386 back to its retracted position illustrated in Figure 68. Simultaneously, the bladder 2358 has been partially drained with the fluid flowing back into the reservoir 2366, driving the piston 2370 back to its original position illustrated in Figure 68. As indicated by the pressure sensor 2376, the pressure within the bladder 2358 has returned to its initial released value. Finally, the upper and lower die portions 2346 and 2348, respectively, have been opened to release the peripheral edge of work piece blank 2364 which has been transformed into a fully coalesced composite case 2412.. Subsequently, the compression molded hydroformed case 2412 is horizontally removed from the hydroforming station 2342 and transferred to the trim-punch station 2344 (if required), and ultimately to the final assembly station 2346.

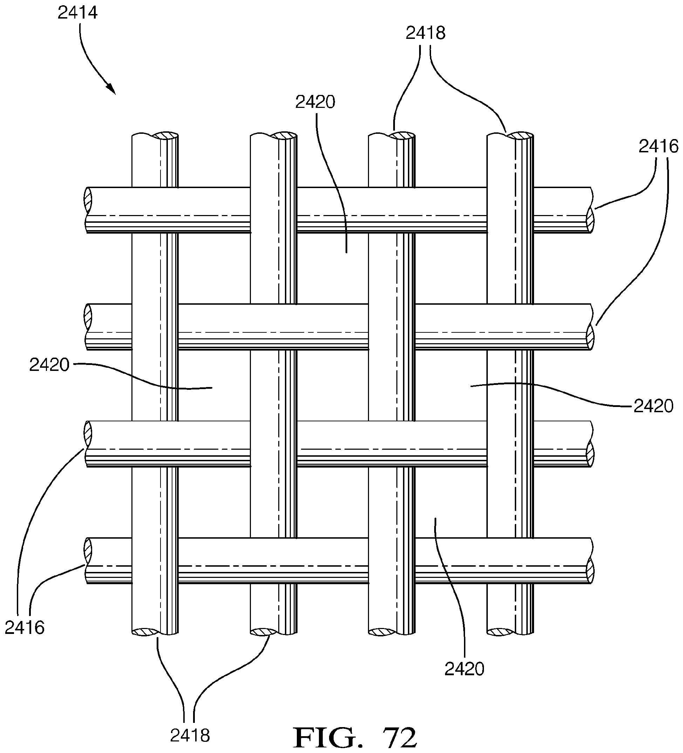

Referring to Figures 72 - 74, the coalescence process that takes place in the work piece blank 2346 during the process steps of Figures 68 - 71 is illustrated. Figure 72 illustrates a representative broken segment of wire screen 2414 consisting of a number of substantially horizontal, spaced filaments 2416 and a number of substantially vertical, spaced filaments 2418 configured in a basket weave to form an array of openings or interstices 2420 there between. It is contemplated that other weave types or, alternatively, an array of perforations formed in a sheet of conductive material can be employed in practicing the present invention.

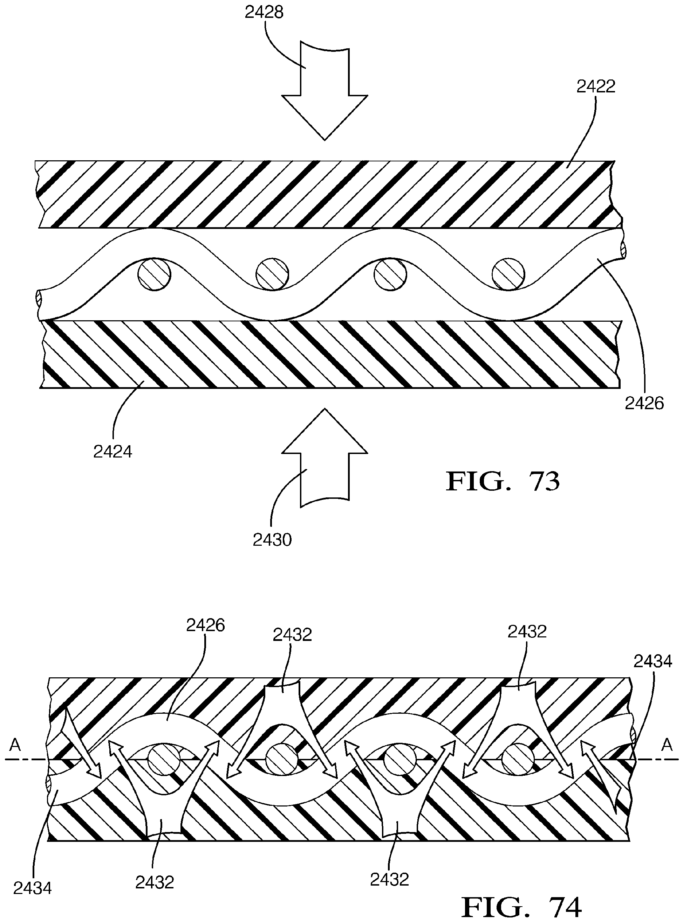

Referring to Figure 73, a representative arrangement of an upper polymer sheet 2422, a lower polymer sheet 2424 and an intermediate sheet of wire screen 2426 juxtaposed as fed into the roller station 2340 of Figure 67 is illustrated. As illustrated, the upper and lower polymer sheets 2422 and 2424, respectively, are not yet deformed, but may be adhered or bonded to one another by adhesive, welding, plating, coating or the like. The roller station 2340 presses the three sheets 2422, 2424 and 2426 together in intimate surface contact as a "sandwich". The sheets 2422, 2424 and 2426 may be partially deformed in this step, but retain their distinctive discrete appearance. During the next process steps (refer Figures 69 and 70) the bladder 2358 applies high downward pressure to the entire exposed surface of the composite as indicated by an arrow 2428. Simultaneously or subsequently, the male punch 2386 applies a high, substantially offsetting upward pressure to the entire exposed lower surface of the composite as indicated by an arrow 2430.

Referring to Figure 74, the process affected by the hydro forming station 2342, wherein the substantially discrete layers of the composite feed stock or work piece blank are compressed and reduced into a coalesced composite, is illustrated. An important aspect of the hydroforming process is that the individual filaments of the wire screen are reshaped during hydroforming from their original serpentine configuration to their final net form simultaneously as adjacent polymer material flows inwardly, encasing the elements in a unified structure. Because of this phenomena, the individual filaments are supported along their entire length, and are not unduly stressed and do not tend to undesirable localized necking, thinning or rupturing. Figure 74 illustrates, in cartoon form, localized flow regions 4232 which extend inwardly from both polymer sheets through adjacent interstices and around the individual strands or filaments composing the wire mesh. Taking a macroscopic view, the discrete generally planer constituent sheets of polymer and conductive materials are locally selectively deformed by the hydroforming process in conformance with the concavities defined by the male punch while avoiding localized thinning or rupturing.

When inner and outer polymer sheets of nearly equal thickness are employed, the flow of the polymer material during the hydroforming process will result in the wire mesh being oriented substantially centrally in the resultant composite structure, with a knit line 2434 between the two polymer sheets being centered with the nominal center plane A - A of the wire mesh 2426. In this condition, material from each of the two sheets of polymer material fully encases at least segments of the individual wire filaments, resulting in an extremely robust composite structure, which in not prone to delamination. Alternatively, with inner and outer polymer sheets of differing thickness, the flow of the polymer material during the hydroforming process will result in the wire mesh being oriented closer to the outer surface of the composite structure associated with the thinner polymer sheet. This can position the wire mesh, or a selected portion thereof adjacent a surface of the composite structure or actually exposed through.

Electronic assemblies typically contain a circuit board assembly that may have ground points from the circuit board to the enclosure. When the enclosure has been constructed of a non-metallic material such as plastic, the grounding and shielding has been provided by a variety of methods including, but not limited to using a metal wire mesh that is formed and insert molded with the structure of the plastic enclosure (see Figure 27). Another method may include using localized shields that are assembled and soldered to the circuit board. (see U.S. Pat. Appln. No. 2009/0122507). However, this approach only provides a shield, not a ground. While plastic enclosures are desirable for manufacturing assembly simplification through the elimination of fasteners as well as weight reductions from metal enclosures, the capitalization to provide a wire mesh insert to a molded plastic part has been a drawback especially in low volume applications. Also, the manufacturing process flow has typically coupled the wire mesh insert fabrication cell directly with the plastic molding process, which may not be desired if the molding press utilization is not at a high enough percentage of the available press time. Another limitation of insert molding of wire mesh in plastic is the ability to check for the wire mesh presence or any anomalies after molding without using an X-ray or running a special translucent or clear material, which is not generally used for a typical application. For audio and navigation system assemblies, as the enclosure evolves away from containing a playback mechanism and the circuit board assemblies are integrated into a single circuit board that has to function as a key board and main board oriented for user interface, the insert molded wire mesh in plastic capability is limited by the tendency to avoid using the mesh in the trim plate portion of the package that is typically identified as a decorative part which is not conducive to receiving the wire mesh needed for the shield or ground aspect that may be required for the enclosure.

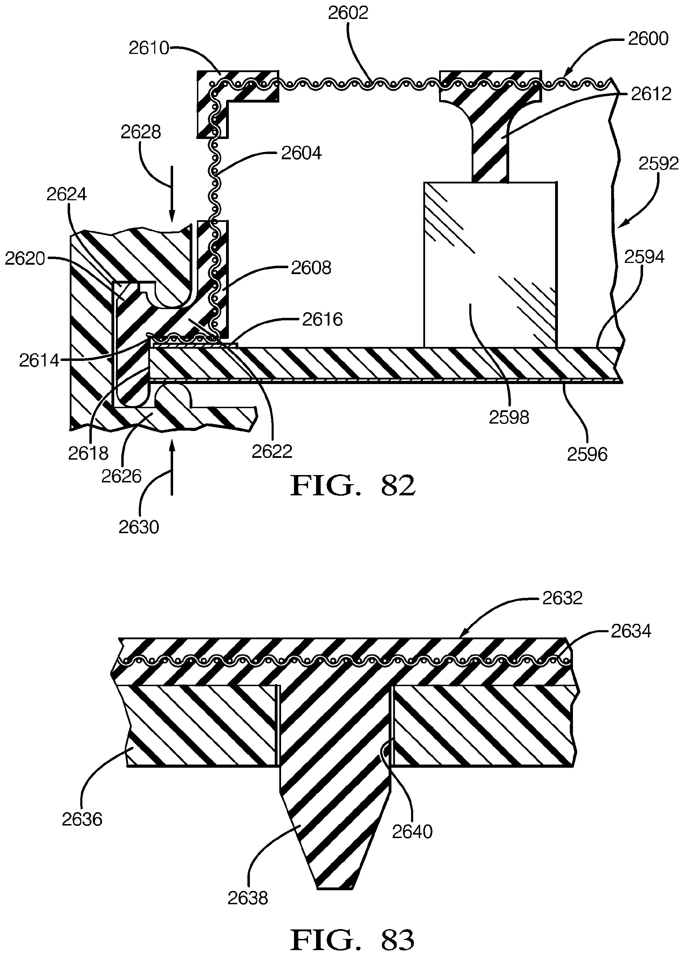

By molding wire mesh directly into a pliable material such as silicone rubber, a more efficient shielding and grounding component can be produced to provide a flexible member that can be incorporated within an enclosed system. This will provide a more efficient shielding and grounding capability by minimizing the amount of wire mesh needed to perform the same functions as a wire mesh insert molded in a plastic enclosure. This allows the grounding and shielding to be reduced to the direct area of the circuit board as opposed to the volumetric boundary of the actual enclosure around the circuit board, which may be larger to facilitate the inclusion of other features not relevant to the shielding or grounding. The pliable material has the capability to have molded features to enable assembly to the circuit board to ensure both a secure attachment of the part as well as a preassembled ground point contact that may be further enabled with the assembly into the mechanical structure of the enclosure (see Figure 82). These may, as an example, be a push/pull through style detail used in silicone rubber switch pads assembled by switch control boards (see Figure 83). Another example may be a molded groove that has exposed mesh to provide the interface for the contact from the ground point of the circuit board to the mesh that will be further enhanced when the mesh in the pliable material with the circuit board assembly is slid into the enclosure to where a compressive force is applied as the circuit board assembly is seated. The pliable material can also be used to provide stand-offs to prevent the wire mesh from contacting components on the circuit board as well as the material itself can be used to prevent contact of the wire mesh to areas of the circuit board that must remain insulated from the wire mesh.

Another advantage of the present invention, as an example, is if the pliable material is a silicone rubber and the rubber is produced in a compression mold, the mesh can be formed directly in the mold, eliminating having to use a forming station that is necessary with the insert molded wire mesh in plastic method.

The wire mesh in rubber may be constructed to encapsulate the circuit board assembly if necessary, but the more likely approach may be to cover the top with mesh and utilize a copper layer of the circuit board on the bottom and possibly plating the circuit board edges to provide the ground and shield for that portion of the assembly. This enables an easier assembly and reduces the mesh size. Also, any combination of layers and plated edges may be used to provide the best method according to the application as best determined by empirical testing.

The present invention enables separated shielding and grounding of multiple circuit board assemblies within an enclosure, if required. Also, the shielding provided by the present invention allows for removal and replacement in the event a circuit board component requires inspection or repair after assembly. With the silicone rubber material capability allowing for an almost clear or translucent appearance, the wire mesh can be inspected if required for presence or anomalies after the insert molding operation.

For a radio application or one where there may be a power device such as an amplifier on the circuit board that must be affixed with an external heat sink, the wire mesh in rubber approach can be designed to include an area of rubber that will provide the power device an interposer comprised of a special heat transfer compound much like a Sill Pad that will enable the heat transfer from the circuit board mounted device through the rubber to the heat sink component external to the enclosure. The thermally conductive rubber portion can be insert molded in the silicone rubber, just like the wire mesh to eliminate the addition of heat sink grease which is the typical approach for the assembly. Although in some cases it may be desired to simply provide an open area for the typical application of the heat sink grease to the device interface to the heat sink as a method for heat dissipation from the circuit board assembly.

Also, as stated before as the radio assembly evolves away from containing a playback mechanism and the separate circuit boards are integrated into a single board that functions as a key board and main board, the present invention offers the capability to provide the frontal shield that, if required, could be incorporated in the silicone rubber of the switch pad. The wire mesh cab be removed during the die cut process in the switch dome areas to allow the switch contact and still provide an adequate shield for the circuit board on the front side if needed.

With an enclosure where a seal is needed, the rubber portion of the present invention can perform the duty of a seal with the correct orientation of the halves of the enclosure which provides less parts to fulfill the requirements of the assembly.

The assembly to the enclosure can be accomplished by several methods including direct connection to the circuit board as described earlier via push/pull throughs and the exposed mesh in a groove. The wire mesh with rubber component may also be loaded directly to the enclosure with features from the enclosure to help locate and capture the rubber such that the circuit board or boards requiring the shields and grounding can be assembled afterward.

Finally, besides the shielding and grounding capabilities, the rubber can provide rattle prevention and the compliant nature of the material enables less tolerance stack-up considerations by conforming to the non-compliant features of the assembly components.

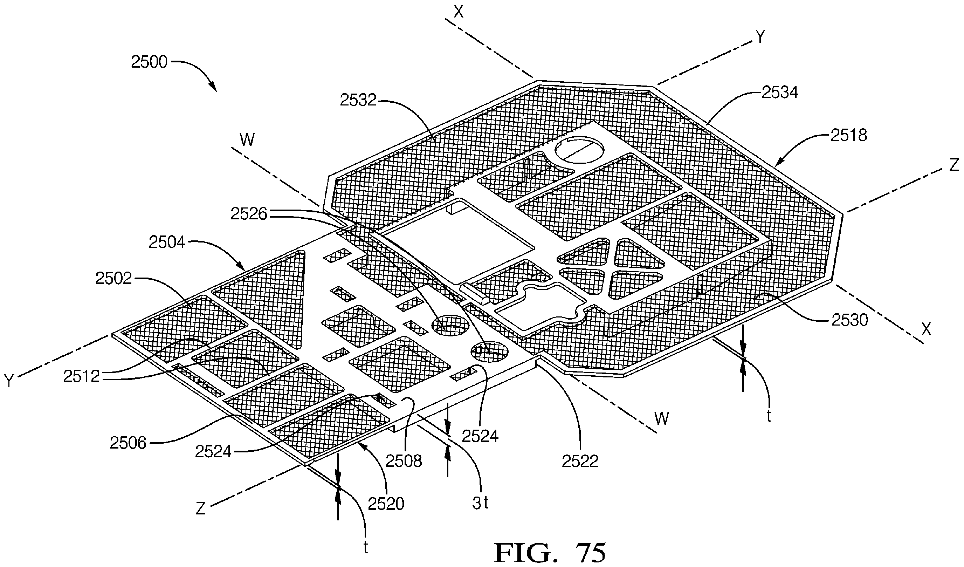

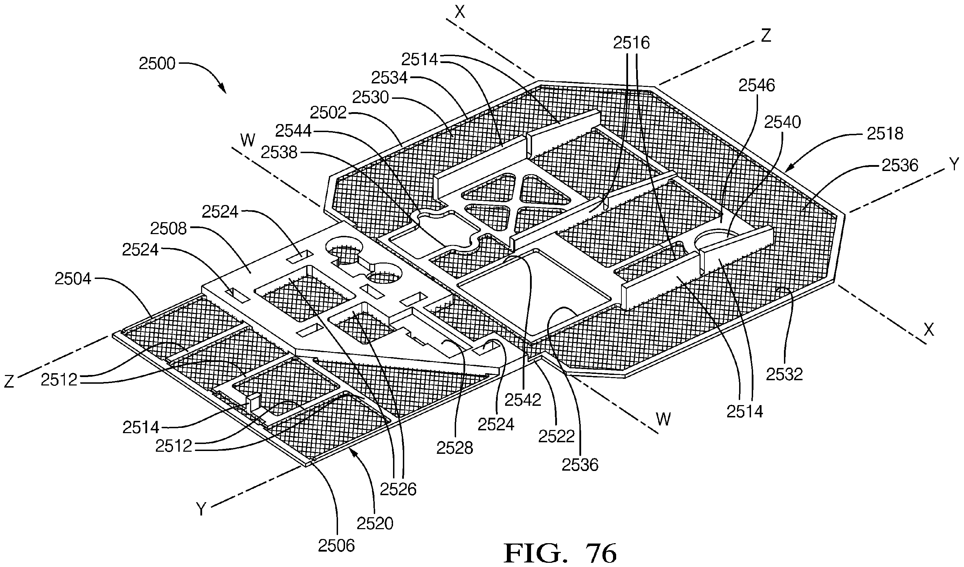

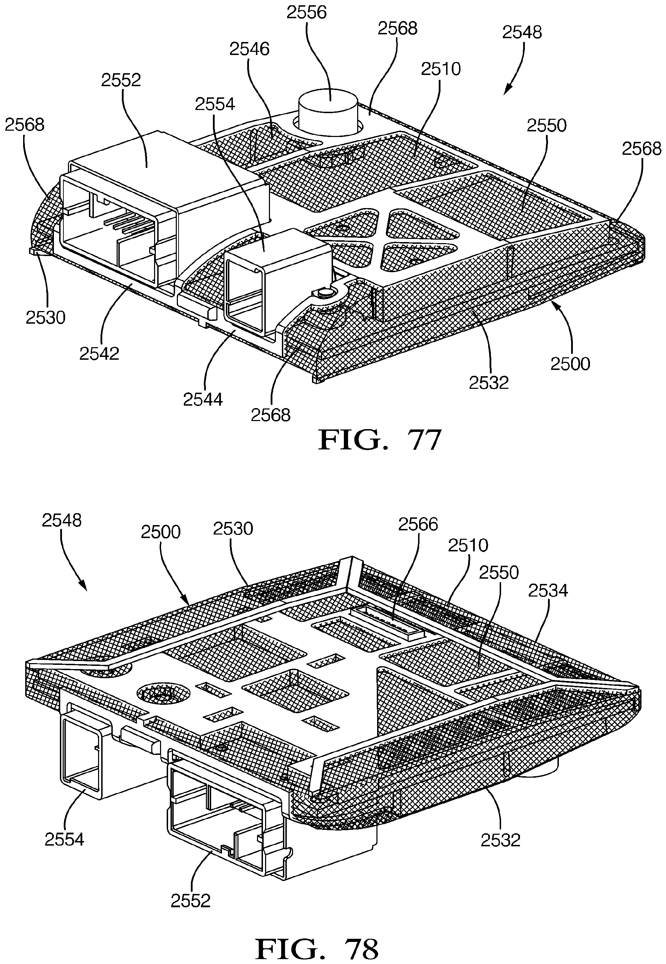

Referring to Figures 75 and 76, a flexible enclosure assembly 2500 for insulating electronic circuit assemblies from electrical anomalies, is illustrated. Flexible enclosure assembly 2500 is formed by first die-cutting a preform 2502 constructed of electrically conductive sheet material such as wire mesh. The preform 2502 can be punch-formed from a continuous roll of stock in a preferably two-dimensional form. The preform 2502 is subsequently selectively insert molded within a framework 2504 of relatively flexible electrically insulating material such as silicone elastomeric material. The framework 2504 serves to form a peripheral frame portion 2506 enclosing the edges of the preform 2502 to prevent fraying or unraveling of conductive wire mesh strands. This prevents exposure of sharp preform edges during the assembly process and reduces the likelihood of electrical shorts in application. The framework 2504 further forms a base portion 2508 which is thicker, and somewhat more rigid that the peripheral frame portion 2506 and is configured for positioning and mounting an electronic circuit assembly 2510 (refer Figures 77 and 78) within the enclosure assembly 2500. The framework also forms ribs 2512 operative to rigidify the overall framework 2504, standoffs 2514 to ensure maintenance of minimum separation between the preform 2502 and electrically conductive components of the electronic circuit assembly 2510, and guide extensions 2516 operative to interact with the base portion 2508 to form one or more expanded cavities within the enclosure assembly 2010 after final assembly. The peripheral frame portion 2506, base portion 2508, ribs 2512, standoffs 2514 and guide extensions 2516 are integrally formed simultaneously from the same material such as silicone elastomeric material by injection molding. Alternatively, they can be molded by a multi-shot process wherein elastomeric material having differing properties (ex. durometer rating, thermal conductivity, and electrical conductivity) can be employed at different locations of the framework 2504. The ribs 2512 are positioned to extend between two spaced-apart locations of the framework 2504 to enhance localized stability while maintaining flexibility of the overall enclosure assembly 2500. The guide extensions 2516 are positioned to embrace locations of the electronic circuit assembly 2510 such as the substrate, PCB or circuit components carried thereon.

The peripheral frame portion 2506 and ribs 2512 have a nominal thickness of dimension "t", and the base portion 2508 has a nominal dimension "3t", whereby, in assembly, the electronic circuit assembly 2510 is matingly supported by the base portion 2508 and the thinner sectioned portions of the enclosure assembly resiliently conform around the electronic circuit assembly 2510.

The enclosure assembly 2500 forms a top half portion 2518 and a bottom half portion 2520, interconnected by a flexible interconnecting bridge or "living hinge" 2522 extending along axis W-W. The base portion 2508 is integrally formed in the bottom half 2520 of assembly 2500 and defines locating and engagement features 2524 for receiving locating tabs (not illustrated) extending from the electronic circuit assembly 2500, and through passages 2526 and recesses 2528 aligned to register with heat generating power devices in the electronic circuit assembly 2510 for enhanced ventilation.

The top half portion 2518 of the flexible enclosure assembly 2500 is dimensioned somewhat larger than the bottom half 2520, and forms leftwardly and rightwardly laterally extending side flaps 2530 and 2532, respectively, as well as a longitudinally extending end flap 2534. The side flaps 2536, 2538 and 2580 are integrally carried and extend from the upper portion 2518 of the preform 2502, interconnected through flexure axes Z, Y and X, respectively, in cantilevered fashion, terminating in free end portions. The top half portion 2518 forms a plurality of shaped openings 2536, 2538 and 2540, each surrounded by a peripheral frame portion 2542, 2544 and 2546, respectively. The shaped openings 2536, 2538 and 2540, each have the wire mesh removed to enable out-sized components carried on the electronic circuit assembly to extend there through. Further, each is dimensioned and shaped to closely conform with their associated out-sized component to minimize potential leakage of electrical anomalies. A peripheral frame portion 2546 defines the opening 2540 while enclosing the edge of the screen.

Referring to Figures 76 - 78, a shielded electronic circuit assembly 2548 is completed by securing the fully-formed electronic circuit assembly 2510, including a rigid substrate such as a printed circuit board (PCB) 2550, to the base portion 2508 of the flexible enclosure assembly 2500. Next, the top half portion 2518 of the flexible enclosure assembly 2500 is rotated nearly 180 degrees about living hinge 2522 axis W-W to fully cover the electronic circuit assembly 2510. Insodoing, outsized components, namely an electrical connector receptacle 2552, an antenna lead connector receptacle 2554 and an electrolytic capacitor 2556 extend outwardly through their respective shaped openings 2536, 2538 and 2540, respectively.

The assembly of shielded electronic circuit assembly 2548 is completed by serially rotating the flaps 2534, 2532 and 2530 180 degrees about their respective living hinge axes X, Y and Z, whereby the outermost portions of flaps 2530, 2532 and 2534 abut the lowermost surface of the bottom half portion 2520 of the flexible enclosure assembly 2500. The flaps 2530, 2532 and 2534 are retained in their design intent position illustrated in Figure 78 by double sided tape dressed along the lowermost surfaces of the peripheral frame portions of the flaps adhesively engaging the adjacent bottom surface of the bottom half portion 2520 of the flexible enclosure assembly 2500. Alternatively, the flaps 2530, 2532 and 2534 are retained in their design intent position illustrated in Figure 78 by self-engaging cooperating latch features (not illustrated) formed in the flaps 2530, 2532 and 2534 and the bottom half portion 2520 of the flexible enclosure assembly 2500. During their 180 degree rotation,, the flaps form relatively large radius or squared side walls to fully cover any gap or spacing between the top and bottom half portions, 2518 and 2520, respectively.

Figures 77 and 78 illustrate a fully assembled shielded electronic circuit assembly 2548 ready for installation in a final application.

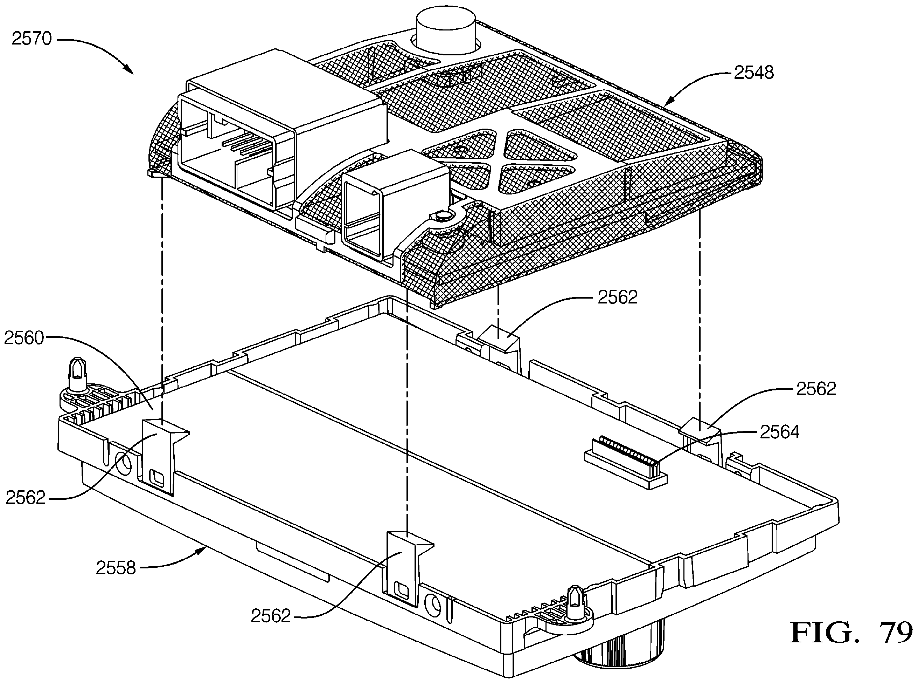

Referring to Figure 79, final assembly of the shielded electronic circuit assembly 2548 is effected by manual mating engagement with an operator accessible trim panel 2558. The trim panel 2558 is constructed substantially as described herein above, with the exception that a rear surface closure member 2560 protectively encloses internal components of the trim panel 2558. The closure member 2560 has an array of integrally formed lock tabs 2562 arranged to self-engage with the upper and lower side walls and outer surface of the shielded electronic circuit assembly 2548. A multi-circuit plug 2564 extends through the closure member 2560 to matingly engage the circuit board connector assembly 2566 extending through the bottom half portion 2520 of the shielded electronic circuit assembly 2548 to complete the electrical interface between the shielded electronic circuit assembly 2548 and the trim panel 2558 circuitry. During final assembly, each lock tab 2562 registers with and engages an associated engagement surface 2568. Accordingly, no separate fasteners are required to affect final assembly of the shielded electronic circuit assembly 2448 or interconnecting the shielded electronic circuit assembly 2448 with the trim panel 2558. As illustrated, the electrical connector receptacle 2552 and antenna lead connector receptacle 2554 face downwardly when the finalized assembly 2570 is installed within a host vehicle.

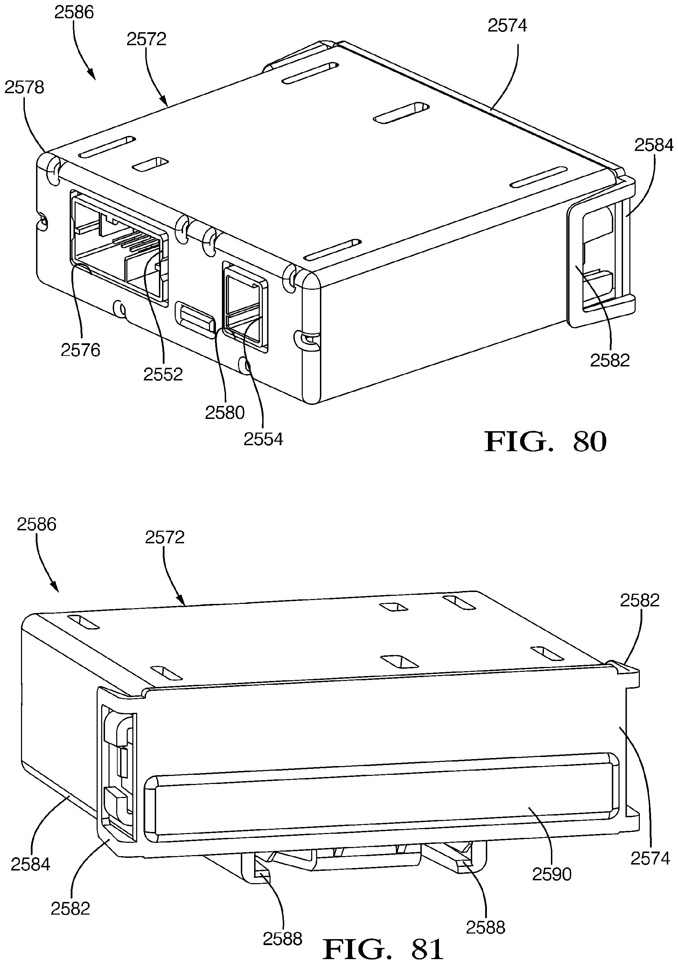

Referring to Figures 80 and 81, an alternative application of the shielded electronic circuit assembly 2548 is illustrated wherein the shielded electronic circuit assembly 2548 of Figures 77 and 78 is installed remotely from any direct operator displays or controls. For such remote applications, the electronic circuit assembly 2548 is nestingly disposed within a substantially closed elastomeric housing consisting of a box-like case 2572 and a closure member 2574. The rear wall 2576 of the case 2572 has first and second openings 2578 and 2580, for receiving the electrical connector receptacle 2552 and antenna lead connector receptacle 2554, respectively.

The case 2572 has integral abutment surfaces 2586 formed therein. The closure member 2574 has corresponding engagement tabs 2582 integrally formed therein. After the shielded electronic circuit assembly 2548 is nestingly disposed within the case 2572, the closure member 2574 is installed by the snap action and self-engagement of the engagement tabs 2582 and corresponding engagement surfaces 2584. Again, no separate fasteners are required to affect final assembly. Lastly, the remote assembly 2586 is adapted for in-vehicle installation via slip-fit mounting features 2588 integrally formed on the bottom surface 2590 of the case 2572.

Referring to figure 82, an alternative embodiment of the present invention employs an electronic circuit assembly 2592 including a printed circuit board 2594 with an electrically conductive sheet 2596 mounted on the lower surface of the PCB 2594. The conductive sheet 2596 can be copper sheet, wire mesh or the like. The upper surface of the PCB 2594, as well as electronic componentry 2598 carried on the PCB 2594 is isolated from external electrical anomalies by a closed flexible wire mesh box 2600, in combination with the conductive sheet 2596. The closed flexible wire mesh box 2600 has a top wall 2602 integrally formed with side walls 2604 extending about the perimeter of the top wall 2602. The closed flexible wire mesh box 2600 is locally rigidified by a being insert molded within framework 2606 of relatively flexible electrically insulating material such as silicone elastomeric material. The framework 2606 serves to form a peripheral frame portion 2608 enclosing the edges of the wire mesh preform to prevent fraying or unraveling of conductive wire mesh strands. This prevents exposure of sharp preform edges during the assembly process and reduces the likelihood of electrical shorts in application. The framework 2606 also forms a corner-edge frame portion 2610 extending along the edges and corners formed between adjacent top and side walls 2602 and 2604, respectively, as well as localized extensions/standoffs 2612 keeping hot or electrically conductive components 2598 spaced from adjacent wire mesh. The type of elastomeric material employed in such locations can be thermally conductive or thermally insulative.

The lowermost portion of the side walls 2604 forms integral outwardly directed wire mesh flanges 2614 also insert molded within the peripheral frame portion 2608 normally to the adjacent side wall 2604. The flanges 2614 register with a ground pad or contacts 2616 formed on the upper surface of the PCB 2574 to ensure that the closed flexible wire mesh box 2600 is robustly electrically grounded. Alternatively, the wire mesh box 2600 can, if required, be electrically biased by a conductive lead from the associated electronic circuit assembly 2510. The peripheral frame portion 2608 extends outwardly beyond the adjacent edge surface 2618 of the PCB 2594 and terminates in an upwardly and downwardly integral locating flange 2620. The locating flange serves to positionally align and lockingly register the closed flexible wire mesh box 2600 with the associated PCB 2594. The locating flange 2620 is integrally interconnected with the peripheral frame portion 2608 by an intermediate neck region.

During final assembly of the electronic circuit assembly 2592, the combined outermost portions of the PCB 2594 and peripheral frame portion 2608 of the subassembly of the closed flexible wire mesh box 2600 and the PCB 2594 is compression-fit within an inwardly opening C-shaped rigid retention channel 2624 formed in an associated mount or housing 2626. The retention channel 2624 is dimensioned to ensure that the housing 2626 applies continuous compressive loading downwardly against the elastomeric neck region 2622 and upwardly against the bottom surface of the PCB 2594 as indicated by arrows 2628 and 2630, respectively.

Referring to the previously described embodiments of the invention as reflected in Figure 79 and Figures 80 - 81, the continuous compressive loading of the shielded electronic circuit subassembly 2548 (illustrated in Figures 77 and 78), is affected, as in the case of the embodiment of Figure 82. In the case of the embodiment illustrated in Figure 79, the four lock tabs 4562 simultaneously engage their respective engagement surfaces 2568 in the shielded electronic circuit subassembly 2548 after it is pressed downwardly into engagement with the trim panel 2558, compressing the silicone elastomeric material making up the framework 2504. These compressive forces, maintain the flaps 2530, 2532 and 2534 in their design intent positions illustrated in Figure 78. In the case of the embodiment illustrated in Figures 80 and 81, the shielded electronic circuit subassembly 2548 is compressed as it is being installed within the case 2572. After final assembly, a degree of residual compressive forces on the silicone elastomeric material making up the framework 2504 will remain. These compressive forces also maintain the flaps 2530, 2532 and 2534 in their design intent positions illustrated in Figure 78.

Referring to Figure 83, another feature of the present invention is illustrated. A peripheral frame portion 2632 of silicone elastomeric material has a wire mesh preform 2634 insert molded therein, which overlays the upper surface of a PCB 2636. An elongated push/pull through feature 2638 dimensioned for interference with and extending through a through passage 2640 formed in the PCB 2636 (and adjacent wire mesh preform 2634) is integrally formed with the peripheral frame portion 2632. This provides a simple and inexpensive, yet tenacious point of interconnection between the peripheral frame portion 2632 and associated PCB 2636 that can be easily removed for servicing and/or replacement.

Many types of molded silicone elastomeric material can be employed in practicing the present invention. It is envisioned that a single type of homogenous material having a mid-range durometer Shore A rating can be successfully employed in insert molding the wire mesh preform within the framework described in connection with Figures 75 - 78 described herein above. However, with the utilization of more sophisticated multi-shot molding techniques, a more utilitarian framework structure can be achieved.

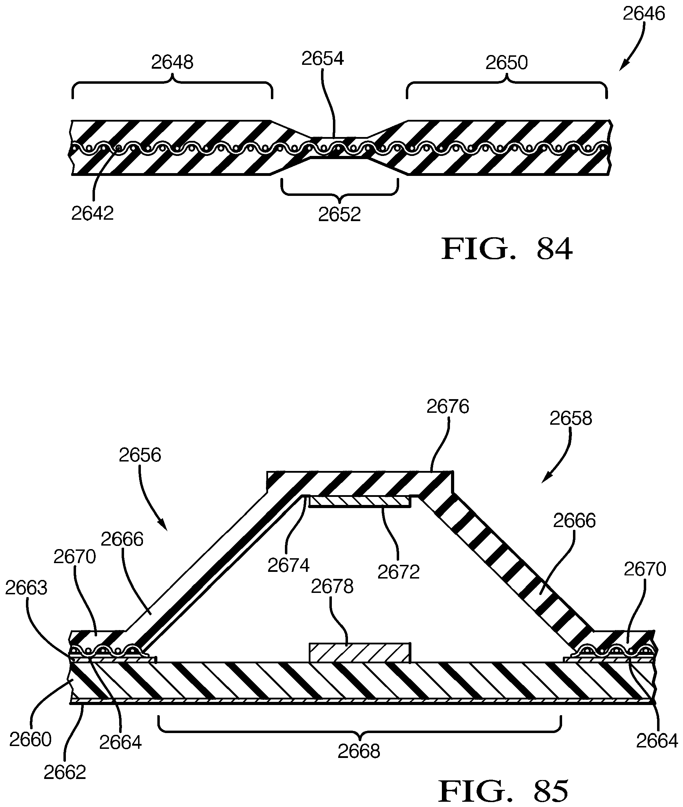

Referring to Figure 84, a wire mesh preform 2642 can be insert molded within a foldable framework 2644 to form a tailored flexible enclosure assembly 2646. Regions 2648 and 2650 which, in application, do not require significant amounts of flexure or resilience, can be formed from a more rigid material, such as 75 durometer Shore A. Region 2652 which, in application, requires a significant degree of flexure or resilience, can be formed from a less rigid material, such as 45 durometer Shore A. Furthermore, the thickness of the silicone elastomeric material within region 2652 can be thinned to define a living hinge 2654 to better define specific folding axes. The specified durometer ratings follow the ASTM D2000 classification standard.

Referring to Figure 85, a switch pad dome 2656 can be incorporated within a flexible enclosure assembly 2658 mounted on the upper surface of a PCB 2660. A conductive sheet 2662 of copper, wire mesh or the like is affixed to the lower surface of the PCB 2660. A wire mesh preform 2664 is insert molded within a framework 2666 mounted to the upper surface of the PCB 2660. A frusto-conically shaped region 2668 extends above the upper surface of the PCB 2660 to form the switch "dome". This region 2668 which, in application, requires a significant degree of flexure or resilience, can be formed from a less rigid material, such as 45 durometer Shore A. A circumferentially surrounding region 2670 which, in application, do not require significant amounts of flexure or resilience, can be formed from a more rigid material, such as 75 durometer Shore A. A circle of wire mesh, concentric with the switch pad dome 2656, is removed to enable switch contacts to function. A first electrical contact 2672 is affixed to the inner surface 2674 of the apex 2674 of the dome 2656 for manual displacement there with. The outer surface 2676 of the apex 2674 of the dome 2656 defines a switch actuation point. A second electrical contact 2678 is fixedly attached to the upper surface of the PCB 2660 in line of displacement of the first contact 2672.

It is to be understood that the invention has been described with reference to specific embodiments and variations to provide the features and advantages previously described and that the embodiments are susceptible of modification as will be apparent to those skilled in the art.

Furthermore, it is contemplated that many alternative, common inexpensive materials can be employed to construct the basis constituent components. Accordingly, the forgoing is not to be construed in a limiting sense.

The invention has been described in an illustrative manner, and it is to be understood that the terminology, which has been used is intended to be in the nature of words of description rather than of limitation.

Obviously, many modifications and variations of the present invention are possible in light of the above teachings. It is, therefore, to be understood that within the scope of the appended claims, wherein reference numerals are merely for illustrative purposes and convenience and are not in any way limiting, the invention, which is defined by the following claims as interpreted according to the principles of patent law, including the Doctrine of Equivalents, may be practiced otherwise than is specifically described.

## Claims

1. A flexible enclosure assembly configured to enclose an electronic circuit assembly (2510), the flexible enclosure assembly forming an upper closure portion (2518) and a lower closure portion (2520), and comprising a preform blank (2502) formed of pliable electrically conductive sheet material and a framework (2504) formed of resilient elastomeric material insert molded over selected portions of said preform blank (2502), wherein the framework (2504) comprises a base portion (2508) operative to mountingly engage said electronic circuit assembly (2510); said flexible enclosure assembly (2500) being **characterized in that** the preform blank (2502) is shaped so as to define upper (2518) and lower (2520) closure portions integrally interconnected along a first hinge axis, wherein the upper closure portion (2518) forms a leftwardly extending side flap (2530), a rightwardly extending side flap (2532) and a longitudinally extending end flap (2534) that are integrally interconnected with said upper closure portion (2518) along a related discrete dedicated hinge axis; and **in that** the flexible enclosure assembly is configured so that the upper closure portion (2518) covers the electronic circuit assembly when it is rotated about said first hinge axis, the outermost portions of the flaps (2530, 2532, 2534) abut the lowermost surface of the lower closure portion (2520) when the flaps are rotated about their respective hinge axes and the flexible enclosure assembly comprises means operative to secure said outermost portions of the flaps portion (2530, 2532, 2534) to said lower closure portion (2520) so that the flexible enclosure assembly envelops the electronic circuit assembly (2510) to shield electronic circuit assembly components from electrical anomalies.

2. The flexible enclosure assembly of claim 1, wherein said means operative to secure the free end of each said sidewall closure portion (2530, 2532, 2534) to said lower closure portion (2520) comprises a relatively rigid external mounting structure (2558) operative to continuously compressively load said flexible enclosure assembly (2500).

3. The flexible enclosure assembly of claim 2, wherein said relatively rigid external mounting structure (2558) comprises an audio system trim panel

4. The flexible enclosure assembly of claim 2, wherein said relatively rigid external mounting structure comprises a substantially closed housing assembly.

5. The flexible enclosure assembly of claim 1, wherein said framework (2504) cooperates with said preform blank (2502) to form living hinges along each said axis.

6. The flexible enclosure assembly of claim 1, wherein said preform blank (2502) is formed from electrically conductive wire mesh.

7. The flexible enclosure assembly of claim 1, wherein said elastomeric material comprises natural silicone rubber or neoprene based material having a characteristic range of 45 - 75 durometer Shore A.

8. The flexible enclosure assembly of claim 1, wherein said framework (2504) comprises a peripheral frame portion(2506) extending circumferentially about and enclosing the exposed edges of the upper (2518) and lower (2520) closure portions and the sidewall closure portions (2530, 2532, 2534) of said preform blank (2502).

9. The flexible enclosure assembly of claim 1, wherein said framework (2504) comprises at least one rib portion (2512) extending between opposed locations of a peripheral frame portion (2506).

10. The flexible enclosure assembly of claim 1, wherein said framework (2504) comprises elongated guide extensions (2516) formed in said upper closure portion (2518) and extending downwardly therefrom to engage registering features of an electronic circuit assembly substrate or upstanding components.

11. The flexible enclosure assembly of claim 1, wherein said framework (2504) comprises a standoff (2514) formed in said upper closure portion (2518) and extending downwardly therefrom to ensure spacing maintenance between said upper (2518) and lower (2520) closure portions and any intermediate electronic circuit assembly components.

12. The flexible enclosure assembly of claim 1, wherein said framework (2504) comprises at least one opening (2536, 2538,2540) formed in said upper closure portion (2518), wherein said opening (2536, 2538,2540) is configured and dimensioned to receive an outsize electrical component mounted on said electronic circuit assembly (2510) and extending outwardly through said opening (2536, 2538,2540).

13. The flexible enclosure assembly of claim 1, wherein said outsize electrical component comprises an electrical and/or antenna connector receptacle (2552).

14. The flexible enclosure assembly of claim 1, wherein said preform blank (2502) is configured for electrical interconnection with a ground circuit within said electronic circuit assembly (2510).

15. The flexible enclosure assembly of claim 1, wherein said elastomeric material is transparent or translucent.

16. The flexible enclosure assembly of claim 1, wherein said preform blank (2502) is electrically isolated from conductive elements of said electronic circuit assembly (2510).

17. The flexible enclosure assembly of claim 1, wherein said preform blank (2502) is electrically biased from said electronic circuit assembly (2510).

18. The flexible enclosure assembly of claim 1, wherein said electronic circuit assembly (2510) comprises a circuit board or substrate supporting electrical components and conductive traces comprising an electrical circuit.

19. The flexible enclosure assembly of claim 1, wherein one portion of said framework (2504) employs elastomeric material having a first, relatively high thermal resistance value and a second portion of said framework employs elastomeric material having a second, relatively low characteristic thermal resistance value.

20. The flexible enclosure assembly of claim 19, wherein said second, thermally conductive framework portion is disposed near a heat sink portion of a power device in said electronic circuit assembly (2510).

21. The flexible enclosure assembly of claim 20, wherein said thermally conductive framework portion contains conductive material therein.

## Patentansprüche

1. Flexible Ummantelungsbaugruppe, die derart konfiguriert ist, eine elektronische Schaltungsbaugruppe (2510) zu ummanteln, wobei die flexible Ummantelungsbaugruppe einen oberen Verschlussabschnitt (2518) und einen unteren Verschlussabschnitt (2520) bildet und einen Vorformrohling (2502), der aus einem nachgiebigen, elektrisch leitenden Bahnmaterial gebildet ist, sowie einen Rahmen (2504) umfasst, der aus nachgiebigem elastomerem Material geformt ist, das über gewählte Abschnitte des Vorformrohlings (2502) einsatzgeformt ist, wobei der Rahmen (2504) einen Basisabschnitt (2508) umfasst, der dazu dient, montierend mit der elektronischen Schaltungsbaugruppe (2510) in Eingriff zu treten, wobei die flexible Ummantelungsbaugruppe (2500) **dadurch gekennzeichnet ist, dass** der Vorformrohling (2502) so geformt ist, dass ein oberer (2518) und unterer (2520) Verschlussabschnitt definiert werden, die einteilig entlang einer ersten Gelenkachse verbunden sind, wobei der obere Verschlussabschnitt (2518) eine sich nach links erstreckende Seitenklappe (2530), eine sich nach rechts erstreckende Seitenklappe (2532) und eine sich längs erstreckende Endklappe (2534) bildet, die einteilig mit dem oberen Verschlussabschnitt (2518) entlang einer zugeordneten diskreten dedizierten Gelenkachse miteinander verbunden sind; und dass die flexible Ummantelungsbaugruppe derart konfiguriert ist, dass der obere Verschlussabschnitt (2518) die elektronische Schaltungsbaugruppe bedeckt, wenn er um die erste Gelenkachse gedreht wird, die äußersten Abschnitte der Klappen (2530, 2532, 2534) an der untersten Fläche des unteren Verschlussabschnittes (2520) anliegen, wenn die Klappen um ihre jeweiligen Gelenkachsen gedreht werden, und die flexible Ummantelungsbaugruppe ein Mittel umfasst, das dazu dient, die äußersten Abschnitte des Klappenabschnittes (2530, 2532, 2534) an dem unteren Verschlussabschnitt (2520) zu befestigen, so dass die flexible Ummantelungsbaugruppe die elektronische Schaltungsbaugruppe (2510) umhüllt, um Komponenten der elektronischen Schaltungsbaugruppe vor elektrischen Anomalien abzuschirmen.

2. Flexible Ummantelungsbaugruppe nach Anspruch 1, wobei das Mittel, das dazu dient, das freie Ende jedes Seitenwandverschlussabschnittes (2530, 2532, 2534) an dem unteren Verschlussabschnitt (2520) zu befestigen, einen relativ starren Außenmontageaufbau (2558) umfasst, der dazu dient, die flexible Ummantelungsbaugruppe (2500) kontinuierlich kompressiv zu belasten.

3. Flexible Ummantelungsbaugruppe nach Anspruch 2, wobei der relativ starre äußere Montageaufbau (2558) eine Verkleidungstafel eines Audiosystems umfasst.

4. Flexible Ummantelungsbaugruppe nach Anspruch 2, wobei der relativ starre äußere Montageaufbau eine im Wesentlichen geschlossene Gehäusebaugruppe umfasst.

5. Flexible Ummantelungsbaugruppe nach Anspruch 1, wobei der Rahmen (2504) mit dem Vorformrohling (2502) zusammenwirkt, um entlang der Achse Biegegelenke zu bilden.

6. Flexible Ummantelungsbaugruppe nach Anspruch 1, wobei der Vorformrohling (2502) aus elektrisch leitendem Drahtgewebe gebildet ist.

7. Flexible Ummantelungsbaugruppe nach Anspruch 1, wobei das elastomere Material auf natürlichem Silikonkautschuk oder Neopren basierendes Material umfasst, das einen charakteristischen Bereich von 45 - 75 Durometer Shore A aufweist.

8. Flexible Ummantelungsbaugruppe nach Anspruch 1, wobei der Rahmen (2504) einen Umfangsrahmenabschnitt (2506) umfasst, der sich um den Umfang der freiliegenden Ränder der oberen (2518) und unteren (2520) Verschlussabschnitte und der Seitenwandverschlussabschnitte (2530, 2532, 2534) des Vorformrohlings (2502) erstreckt und diese umschließt.

9. Flexible Ummantelungsbaugruppe nach Anspruch 1, wobei der Rahmen (2504) zumindest einen Rippenabschnitt (2512) umfasst, der sich zwischen gegenüberliegenden Orten eines Umfangsrahmenabschnitts (2506) erstreckt.

10. Flexible Ummantelungsbaugruppe nach Anspruch 1, wobei der Rahmen (2504) längliche Führungsverlängerungen (2516) umfasst, die in dem oberen Verschlussabschnitt (2518) gebildet sind und sich davon abwärts erstrecken, um mit Ausrichtmerkmalen eines Substrates einer elektronischen Schaltungsbaugruppe oder aufrechtstehenden Komponenten in Eingriff zu treten.

11. Flexible Ummantelungsbaugruppe nach Anspruch 1, wobei der Rahmen (2504) einen Ansatz (2514) umfasst, der in dem oberen Verschlussabschnitt (2518) gebildet ist und sich davon abwärts erstreckt, um die Beibehaltung eines Abstands zwischen den oberen (2518) und unteren (2520) Verschlussabschnitten und jeglichen dazwischenliegenden Komponenten der elektronischen Schaltungsbaugruppe sicherzustellen.

12. Flexible Ummantelungsbaugruppe nach Anspruch 1, wobei der Rahmen (2504) zumindest eine Öffnung (2536, 2538, 2540) umfasst, die in dem oberen Verschlussabschnitt (2518) gebildet ist, wobei die Öffnung (2536, 2538, 2540) derart konfiguriert und dimensioniert ist, eine äußere elektrische Komponente aufzunehmen, die in der elektronischen Schaltungsbaugruppe (2510) montiert ist und sich durch die Öffnung (2536, 2538, 2540) nach außen erstreckt.

13. Flexible Ummantelungsbaugruppe nach Anspruch 1, wobei die äußere elektrische Komponente eine elektrische und/oder Antennenverbinderbuchse (2552) umfasst.

14. Flexible Ummantelungsbaugruppe nach Anspruch 1, wobei der Vorformrohling (2502) zur elektrischen Verbindung mit einer Masseschaltung innerhalb der elektronischen Schaltungsbaugruppe (2510) konfiguriert ist.

15. Flexible Ummantelungsbaugruppe nach Anspruch 1, wobei das elastomere Material transparent oder transluzent ist.

16. Flexible Ummantelungsbaugruppe nach Anspruch 1, wobei der Vorformrohling (2502) elektrisch von leitenden Elementen der elektronischen Schaltungsbaugruppe (2510) isoliert ist.

17. Flexible Ummantelungsbaugruppe nach Anspruch 1, wobei der Vorformrohling (2502) elektrisch von der elektronischen Schaltungsbaugruppe (2510) vorgespannt ist.

18. Flexible Ummantelungsbaugruppe nach Anspruch 1, wobei die elektronische Schaltungsbaugruppe (2510) eine Leiterplatte oder ein Substrat umfasst, das elektrische Komponenten und Leiterbahnen trägt, die eine elektrische Schaltung umfassen.

19. Flexible Ummantelungsbaugruppe nach Anspruch 1, wobei ein Abschnitt des Rahmens (2504) elastomeres Material mit einem ersten relativ hohen Wärmewiderstandswert verwendet und ein zweiter Abschnitt des Rahmens elastomeres Material mit einem zweiten relativ niedrigen charakteristischen Wärmewiderstandswert verwendet.

20. Flexible Ummantelungsbaugruppe nach Anspruch 19, wobei der zweite thermisch leitende Rahmenabschnitt nahe einem Kühlkörperabschnitt einer Leistungsvorrichtung in der elektronischen Schaltungsbaugruppe (2510) angeordnet ist.

21. Flexible Ummantelungsbaugruppe nach Anspruch 20, wobei der Abschnitt des thermisch leitenden Rahmens leitendes Material darin enthält.

## Revendications

1. Ensemble enceinte flexible configuré pour enfermer un ensemble circuit électronique (2510), l'ensemble enceinte flexible formant une partie de fermeture supérieure (2518) et une partie de fermeture inférieure (2520), et comprenant une ébauche de préforme (2502) formée d'un matériau en feuille électriquement conducteur pliable et un cadre (2504) formé d'un matériau élastomère élastique moulé par insertion sur des parties sélectionnées de ladite ébauche de préforme (2502), le cadre (2504) comprenant une partie de base (2508) conçue pour coopérer en montage avec ledit ensemble circuit électronique (2510) ; ledit ensemble enceinte flexible (2500) étant **caractérisé en ce que** l'ébauche de préforme (2502) est formée de manière à définir des parties de fermeture supérieure (2518) et inférieure (2520) reliées d'un seul tenant le long d'un premier axe d'articulation, la partie de fermeture supérieure (2518) formant un volet latéral s'étendant vers la gauche (2530), un volet latéral s'étendant vers la droite (2532) et un volet terminal s'étendant longitudinalement (2534) qui sont reliés d'un seul tenant à ladite partie de fermeture supérieure (2518) le long d'un axe d'articulation discret dédié associé ; et **en ce que** l'ensemble enceinte flexible est configuré de sorte que la partie de fermeture supérieure (2518) recouvre l'ensemble circuit électronique lorsqu'elle est tournée autour dudit premier axe d'articulation, les parties les plus extérieures des volets (2530, 2532, 2534) butent contre la surface la plus basse de la partie de fermeture inférieure (2520) lorsque les volets tournent autour de leurs axes d'articulation respectifs et l'ensemble enceinte flexible comprend des moyens conçus pour fixer lesdites parties les plus extérieures des volets (2530, 2532, 2534) à ladite partie de fermeture inférieure (2520) de sorte que l'ensemble enceinte flexible enveloppe l'ensemble circuit électronique (2510) pour protéger les composants de l'ensemble circuit électronique des anomalies électriques.

2. Ensemble enceinte flexible selon la revendication 1, dans lequel lesdits moyens conçus pour fixer l'extrémité libre de chaque partie de fermeture de paroi latérale (2530, 2532, 2534) à ladite partie de fermeture inférieure (2520) comprend une structure de montage externe relativement rigide (2558) conçue pour charger en compression de manière continue ledit ensemble enceinte flexible (2500).

3. Ensemble enceinte flexible selon la revendication 2, dans lequel ladite structure de montage externe relativement rigide (2558) comprend un panneau de garnissage de système audio.

4. Ensemble enceinte flexible selon la revendication 2, dans lequel ladite structure de montage externe relativement rigide comprend un ensemble boîtier sensiblement fermé.

5. Ensemble enceinte flexible selon la revendication 1, dans lequel ledit cadre (2504) coopère avec ladite ébauche de préforme (2502) pour former des charnières souples selon chacun desdits axes.

6. Ensemble enceinte flexible selon la revendication 1, dans lequel ladite ébauche de préforme (2502) est formée à partir d'un treillis métallique électriquement conducteur.

7. Ensemble enceinte flexible selon la revendication 1, dans lequel ledit matériau élastomère comprend un caoutchouc de silicone naturel ou un matériau à base de néoprène ayant une plage caractéristique de 45 à 75 au duromètre Shore A.

8. Ensemble enceinte flexible selon la revendication 1, dans lequel ledit cadre (2504) comprend une partie cadre périphérique (2506) s'étendant circonférentiellement autour et entourant les bords exposés des parties de fermeture supérieure (2518) et inférieure (2520) et les parties de fermeture de paroi latérale (2530, 2532, 2534) de ladite ébauche de préforme (2502).

9. Ensemble enceinte flexible selon la revendication 1, dans lequel ledit cadre (2504) comprend au moins une partie nervure (2512) s'étendant entre des emplacements opposés d'une partie cadre périphérique (2506).

10. Ensemble enceinte flexible selon la revendication 1, dans lequel ledit cadre (2504) comprend des extensions de guidage allongées (2516) formées dans ladite partie de fermeture supérieure (2518) et s'étendant vers le bas à partir de celle-ci pour coopérer avec des caractéristiques de repérage d'un substrat d'ensemble circuit électronique ou de composants dressés.

11. Ensemble enceinte flexible selon la revendication 1, dans lequel ledit cadre (2504) comprend une entretoise (2514) formée dans ladite partie de fermeture supérieure (2518) et s'étendant vers le bas à partir de celle-ci pour assurer le maintien de l'espacement entre lesdites parties de fermeture supérieure (2518) et inférieure (2520) et tout composant intermédiaire de l'ensemble circuit électronique.

12. Ensemble enceinte flexible selon la revendication 1, dans lequel ledit cadre (2504) comprend au moins une ouverture (2536, 2538, 2540) formée dans ladite partie de fermeture supérieure (2518), ladite ouverture (2536, 2538, 2540) étant configurée et dimensionnée pour recevoir un composant électrique hors gabarit monté sur ledit ensemble circuit électronique (2510) et s'étendant vers l'extérieur à travers ladite ouverture (2536, 2538, 2540).

13. Ensemble enceinte flexible selon la revendication 1, dans lequel ledit composant électrique hors gabarit comprend un réceptacle de connecteur électrique et/ou d'antenne (2552).

14. Ensemble enceinte flexible selon la revendication 1, dans lequel ladite ébauche de préforme (2502) est configurée pour une liaison électrique avec un circuit de masse dans ledit ensemble circuit électronique (2510).

15. Ensemble enceinte flexible selon la revendication 1, dans lequel ledit matériau élastomère est transparent ou translucide.

16. Ensemble enceinte flexible selon la revendication 1, dans lequel ladite ébauche de préforme (2502) est électriquement isolée des éléments conducteurs dudit ensemble circuit électronique (2510).

17. Ensemble enceinte flexible selon la revendication 1, dans lequel ladite ébauche de préforme (2502) est polarisée électriquement par ledit ensemble circuit électronique (2510).

18. Ensemble enceinte flexible selon la revendication 1, dans lequel ledit ensemble circuit électronique (2510) comprend une carte de circuit imprimé ou un substrat supportant des composants électriques et des tracés conducteurs comprenant un circuit électrique.

19. Ensemble enceinte flexible selon la revendication 1, dans lequel une partie dudit cadre (2504) emploie un matériau élastomère ayant une première valeur de résistance thermique relativement élevée et une seconde partie dudit cadre emploie un matériau élastomère ayant une seconde valeur de résistance thermique caractéristique relativement faible.

20. Ensemble enceinte flexible selon la revendication 19, dans lequel ladite seconde partie de cadre thermiquement conductrice est disposée à proximité d'une partie dissipateur thermique d'un dispositif de puissance dans ledit ensemble circuit électronique (2510).

21. Ensemble enceinte flexible selon la revendication 20, dans lequel ladite partie de cadre thermiquement conductrice contient un matériau conducteur.
